# EUROPEAN PATENT SPECIFICATION

(11) **EP 4 060 407 B1**
(45) Date of publication and mention of the grant of the patent: **29.04.2026**
(21) Application number: 22161785.5
(22) Date of filing: 14.03.2022
(51) Int. Cl.: G03F 7/004, G03F 7/039

(54) **CHEMICALLY AMPLIFIED POSITIVE RESIST COMPOSITION AND RESIST PATTERN FORMING PROCESS**
CHEMISCH ERWEITERTE POSITIVE RESISTZUSAMMENSETZUNG UND RESISTMUSTERFORMUNGSVERFAHREN
COMPOSITION DE RÉSERVE POSITIVE AMPLIFIÉE CHIMIQUEMENT ET PROCÉDÉ DE FORMATION DE MOTIFS RÉSISTANT

(30) Priority: 17.03.2021 JP 2021043151
(43) Date of publication of application: 21.09.2022
(73) Proprietor: Shin-Etsu Chemical Co., Ltd., Tokyo (JP)
(72) Inventor: MASUNAGA, Keiichi, Joetsu-shi (JP); WATANABE, Satoshi, Joetsu-shi (JP); FUNATSU, Kenji, Joetsu-shi (JP); KOTAKE, Masaaki, Joetsu-shi (JP); INOUE, Naoya, Joetsu-shi (JP)
(74) Representative: Ter Meer Steinmeister & Partner

(56) References cited:
- EP-A2- 2 264 525
- US-A1- 2009 202 947
- US-A1- 2011 294 070
- US-A1- 2013 288 180

## Description

### TECHNICAL FIELD

This invention relates to a chemically amplified positive resist composition and a resist pattern forming process using the same.

### BACKGROUND ART

To meet the recent demand for higher integration in integrated circuits, pattern formation to a smaller feature size is required. Acid-catalyzed chemically amplified resist compositions are most often used in forming resist patterns with a feature size of 0.2 µm or less. High-energy radiation such as UV, deep-UV, EUV or EB is used as the energy source for exposure of these resist compositions. In particular, the EB lithography, which is utilized as the ultra-fine microfabrication technique, is also indispensable in processing a photomask blank into a photomask for use in the fabrication of semiconductor devices.

In general, the EB lithography is by writing an image with EB, without using a mask. In the case of positive resist, those regions of a resist film other than the regions to be retained are successively irradiated with EB having a minute area. In the case of negative resist, those regions of a resist film to be retained are successively irradiated with EB.
The operation of successively scanning all finely divided regions on the work surface takes a long time as compared with full wafer exposure through a photomask. To prevent any throughput decline, a resist film having a high sensitivity is required. One of the important applications of chemically amplified resist material resides in processing of photomask blanks. Some photomask blanks have a surface material that can have an impact on the pattern profile of the overlying chemically amplified resist film, for example, a layer of a chromium compound, typically chromium oxide deposited on a photomask substrate. For high resolution and profile retention after etching, it is one important performance factor to maintain the profile of a resist film pattern rectangular independent of the type of substrate. A low line edge roughness (LER) is another important performance factor.

The control of resist sensitivity and pattern profile as mentioned above has been improved by a proper selection and combination of resist material-constituting components and processing conditions. One improvement is directed to the diffusion of acid that largely affects the resolution of a chemically amplified resist film. In the processing of photomasks, it is required that the profile of a resist pattern formed as above do not change with a lapse of time from the end of exposure to PEB. The major cause of such a change with time is diffusion of an acid generated upon exposure. The problem of acid diffusion has been widely studied not only in terms of photomask processing, but also in terms of general resist compositions because the acid diffusion has a significant impact on sensitivity and resolution.

Patent Documents 1 and 2 describe acid generators capable of generating bulky acids for controlling acid diffusion and reducing LER. Since these acid generators are still insufficient to control acid diffusion, it is desired to have an acid generator with more controlled diffusion.

Patent Document 3 discloses a resist composition comprising a base polymer having bound thereto an acid generator capable of generating a sulfonic acid upon light exposure whereby acid diffusion is controlled. This approach of controlling acid diffusion by binding repeat units capable of generating acid upon exposure to a base polymer is effective in forming a pattern with reduced LER. However, the base polymer having bound therein repeat units capable of generating acid upon exposure encounters a problem with respect to its solubility in organic solvent, depending on the structure and proportion of the repeat units.

Polymers comprising a major proportion of aromatic structure having an acidic side chain, for example, polyhydroxystyrene are useful in resist materials for the KrF excimer laser lithography. These polymers are not used in resist materials for the ArF excimer laser lithography since they exhibit strong absorption at a wavelength of around 200 nm. These polymers, however, are expected to form useful resist materials for the EB and EUV lithography for forming patterns of finer size than the processing limit of ArF excimer laser because they offer high etching resistance.

Often used as the base polymer in positive resist compositions for EB and EUV lithography is a polymer having an acidic functional group on phenol side chain masked with an acid labile group. Upon exposure to high-energy radiation, the acid labile group is deprotected by the catalysis of an acid generated from a photoacid generator so that the polymer may turn soluble in alkaline developer. Typical of the acid labile group are tertiary alkyl, tert-butoxycarbonyl, and acetal groups. The use of acid labile groups (e.g., acetal groups) requiring a relatively low level of activation energy for deprotection offers the advantage that a resist film having a high sensitivity is obtainable. However, if the diffusion of generated acid is not fully controlled, deprotection reaction can occur even in the unexposed region of the resist film, giving rise to problems like degradations of resolution and LER.

It is known that a develop loading phenomenon arises in the development step of the photomask fabrication process. That is, the finish size of pattern features differs between a grouped region and an isolated region on a photomask. Due to the develop loading, the distribution of pattern finish size becomes non-uniform depending on the surrounding pattern feature distribution. This is caused by a difference in elimination reaction during acid generation due to an energy difference of EB and a difference of dissolution rate in alkaline developer between grouped and isolated images. As one solution, Patent Document 4 discloses a beam dose computing method of an EB writing apparatus comprising the steps of adjusting an input dose in the EB writing apparatus so as to correct develop loading effects, and irradiating EB in the adjusted dose for thereby writing a pattern on a photomask. However, since the prior art correcting method has not fully taken into account the develop loading phenomenon for correction, the accuracy of correcting develop loading effects is not so high. To solve such problems, Patent Document 5 discloses an imaging method and Patent Document 6 discloses a method of improving a development mode after patterning. These methods are insufficient for establishing a uniform distribution of grouped and isolated features in the advanced generation of lithography. An improvement in resist compositions is desired. Patent Document 7 is directed to a polymer comprising a high proportion of aromatic ring structure-containing units and containing an aromatic sulfonic acid sulfonium salt on a side chain is used to form a chemically amplified positive photoresist composition.

### Citation List

Patent Document 1: JP-A 2009-053518
Patent Document 2: JP-A 2010-100604
Patent Document 3: JP-A 2011-022564
Patent Document 4: JP-A 2007-150243 (USP 7740991)
Patent Document 5: JP 5443548
Patent Document 6: JP 6281244
Patent Document 7: EP 2 264 525 A2

### SUMMARY OF INVENTION

An object of the invention is to provide a chemically amplified positive resist composition which is lithographically processed into a resist pattern with a very high resolution, reduced LER, improved rectangularity, and minimized influence of develop loading, and a pattern forming process using the same.

The inventors have found that when a base polymer of specific structure is blended in a resist composition, a resist pattern with a satisfactory resolution, profile and LER can be formed while controlling the influence of develop loading.

In one aspect, the invention provides a chemically amplified positive resist composition according to claim 1. Advantageous embodiments of the invention are defined in claims 2 to 7.

In another aspect, the invention provides a resist pattern forming process according to claim 8. Advantageous embodiments of the process are defined in claims 9 to 11.

In a further aspect, the invention provides a photomask blank according to claim 12.

### ADVANTAGEOUS EFFECTS OF INVENTION

The chemically amplified positive resist composition can be processed to form a resist pattern of good profile with a high resolution and reduced LER while controlling the influence of develop loading. It is thus suited as a resist composition for forming a resist film which is sensitive to high-energy radiation such as UV, deep UV, EB, EUV, X-ray, γ-ray or synchrotron radiation and useful in the processing of semiconductor substrates and photomask blanks. The pattern forming process using the positive resist composition can form a resist pattern with a high resolution, reduced LER and controlled influence of develop loading and is thus best suited in the micropatterning technology, typically EUV or EB lithography.

### DESCRIPTION OF EMBODIMENTS

As used herein, the singular forms "a," "an" and "the" include plural referents unless the context clearly dictates otherwise. "Optional" or "optionally" means that the subsequently described event or circumstances may or may not occur, and that description includes instances where the event or circumstance occurs and instances where it does not. The notation (Cn-Cm) means a group containing from n to m carbon atoms per group. The terms "group" and "moiety" are interchangeable. In chemical formulae, Me stands for methyl, Ac stands for acetyl, and the broken line designates a valence bond.

The abbreviations and acronyms have the following meaning.
EB: electron beam
EUV: extreme ultraviolet
Mw: weight average molecular weight
Mn: number average molecular weight
Mw/Mn: molecular weight distribution or dispersity
GPC: gel permeation chromatography
PEB: post-exposure bake
PAG: photoacid generator
LER: line edge roughness
CDU: critical dimension uniformity

It is understood that for some structures represented by chemical formulae, there can exist enantiomers and diastereomers because of the presence of asymmetric carbon atoms. In such a case, a single formula collectively represents all such isomers. The isomers may be used alone or in admixture.

The high-energy radiation encompasses UV, deep UV, EB, EUV, X-ray, γ-ray and synchrotron radiation.

### Positive resist composition

One embodiment of the invention is a chemically amplified positive resist composition comprising a base polymer which is protected with an acid labile group and adapted to turn alkali soluble under the action of acid.

The base polymer contains a polymer comprising an acid generating unit, a phenolic hydroxy group-containing unit, a unit containing a phenolic hydroxy group protected with an acid labile group, and a unit containing a carboxy group protected with an acid labile group.

The acid generating unit is a repeat unit having the following formula (A4), the phenolic hydroxy group-containing unit is a repeat unit having the following formula (B1-1), the unit containing a phenolic hydroxy group protected with an acid labile group is a repeat unit having the following formula (B2-1), and the unit containing a carboxy group protected with an acid labile group is a repeat unit having the following formula (B3-1): 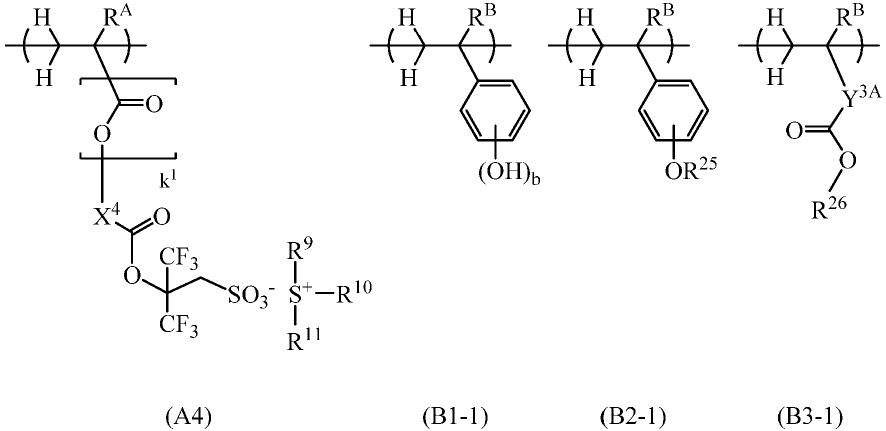
wherein R^{A} is each independently hydrogen or methyl,
wherein R^{B} is hydrogen, fluorine, methyl or trifluoromethyl,
X⁴ is a single bond or C₁-C₃₀ hydrocarbylene group which may contain a heteroatom, k¹ and k² are each independently 0 or 1, k¹ and k² are 0 when X⁴ is a single bond,
R⁹ to R¹¹ are each independently halogen or a C₁-C₂₀ hydrocarbyl group which may contain a heteroatom, R⁹ and R¹⁰ may bond together to form a ring with the sulfur atom to which they are attached,
b is an integer of 1 to 3,
k¹ is 0 or 1, k¹ is 0 when X⁴ is a single bond,
   Y^{3A} is a single bond, phenylene group or naphthylene group,
   R²⁵ and R²⁶ are each independently an acid labile group having a C₆-C₂₀ aromatic hydrocarbon moiety and/or C₅-C₂₀ alicyclic hydrocarbon moiety,
wherein said base polymer contains a polymer comprising repeat units having formula (A4), repeat units having formula (B1-1), repeat units having formula (B2-1), and repeat units having formula (B3-1).

The repeat unit having formula (A4) is a unit which generates an acid upon exposure to high-energy radiation, the acid having a sulfonyl group and being difluoromethylated at β-position thereof. The acid has an acid strength adequate for the deprotection of a polymer comprising units having a phenolic hydroxy group protected with an acetal, tertiary alkyl or tert-butoxycarbonyl group. When a polymer comprising the repeat unit is used as a base polymer in a resist composition, it is possible to properly control the movement and diffusion of the generated acid.

A photoacid generator capable of generating an arene sulfonic acid upon exposure to high-energy radiation is also commonly used for the deprotection of a polymer comprising units having a phenolic hydroxy group protected with an acetal, tertiary alkyl or tert-butoxycarbonyl group. However, when an arene sulfonic acid-generating unit is introduced as the repeat unit in a base polymer with the intention of attaining the same effect as in the present invention, the resulting base polymer is not always dissolvable in a solvent because of low solvent solubility. In contrast, the polymer comprising repeat units having formula (A4) is fully lipophilic and easy to prepare and handle, and a resist composition is readily prepared therefrom. For more details regarding repeat units having formula (A4), we refer to the explanations further below.

The acid strength of repeat unit A4 is most appropriate in designing the acid-labile eliminating group on a polymer.

The repeat unit is A4 capable of generating an acid upon exposure to high-energy radiation. The acid-generating units bound to a polymer enable to appropriately control acid diffusion and hence, to form a pattern with reduced LER. Since the acid-generating unit is bound to a polymer, the phenomenon that acid volatilizes from the exposed region and re-deposits on the unexposed region during bake in vacuum is suppressed. This is effective for reducing LER and for mitigating any geometric degradation due to unwanted film thickness reduction in the unexposed region.

The repeat unit A4 is preferably incorporated in a range of 0.1 to 30 mol%, more preferably 0.5 to 20 mol% based on the overall repeat units of the polymer in the base polymer
The phenolic hydroxy group-containing unit is a repeat unit having the formula (B1-1). 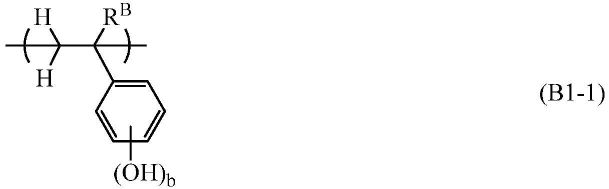 Herein R^{B} is hydrogen, fluorine, methyl or trifluoromethyl and b b is an integer of 1 to 3.

The unit containing a phenolic hydroxy group protected with an acid labile group is a repeat unit having the formula (B2-1). The unit containing a carboxy group protected with an acid labile group is a repeat unit having the formula (B3-1).

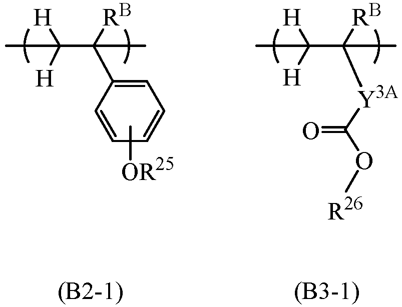

Herein R^{B} is as defined above. Y^{3A} is a single bond, phenylene group or naphthylene group. R²⁵ and R²⁶ are each independently an acid labile group having a C₆-C₂₀ aromatic hydrocarbon moiety and/or C₅-C₂₀ alicyclic hydrocarbon moiety.

The repeat units B2-1 are preferably incorporated in a range of 2 to 40 mol% based on the overall repeat units of the polymer in the base polymer. The repeat units B3-1 are preferably incorporated in a range of 2 to 40 mol% based on the overall repeat units of the polymer in the base polymer. The sum of repeat units B2-1 and B3-1 is preferably incorporated in a range of 5 to 60 mol% based on the overall repeat units of the polymer in the base polymer.

Where the base polymer is of the design that it is a mixture of repeat units of two types in which a phenolic hydroxy group and a carboxy group are protected with acid labile groups, the influence of develop loading is suppressed because the dissolution rate of exposed region is improved due to the carboxylate framework while maintaining pattern robustness due to the phenol framework, and the dissolution contrast between exposed and unexposed regions is optimized while maintaining a satisfactory resolution in the exposed region. As a consequence, a pattern with a minimal size difference is obtained independent of pattern density. In the fabrication of photomasks wherein the development conditions employed therein are stronger than in the processing of wafer substrates, it is required to form a pattern with a minimal size difference while maintaining a satisfactory resolution and suppressing the influence of develop loading. Then the chemically amplified positive resist composition of the invention is best suited for the processing of photomask substrates.

In a preferred embodiment, the polymer in the base polymer further comprises repeat units of at least one type selected from repeat units having the formula (C1), repeat units having the formula (C2), and repeat units having the formula (C3), which are also referred to as repeat units C1, C2 and C3, respectively.

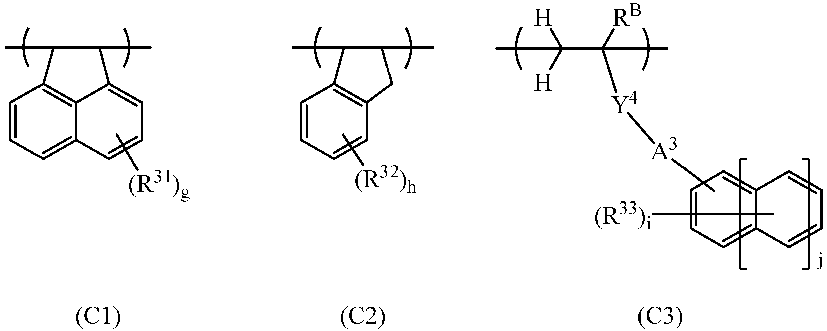

**In** formulae (C1) and (C2), g and h are each independently an integer of 0 to 4.

**In** formulae (C1) and (C2), R³¹ and R³² are each independently a hydroxy group, halogen, an optionally halogenated C₂-C₈ saturated hydrocarbylcarbonyloxy group, optionally halogenated C₁-C₈ saturated hydrocarbyl group, or optionally halogenated C₁-C₈ saturated hydrocarbyloxy group. The saturated hydrocarbyl group, saturated hydrocarbyloxy group and saturated hydrocarbylcarbonyloxy group may be straight, branched or cyclic. Groups R³¹ may be identical or different when g is 2 or more. Groups R³² may be identical or different when h is 2 or more.

In formula (C3), R^{B} is as defined above, i is an integer of 0 to 5, and j is an integer of 0 to 2.

In formula (C3), R³³ is an acetyl group, C₁-C₂₀ saturated hydrocarbyl group, C₁-C₂₀ saturated hydrocarbyloxy group, C₂-C₂₀ saturated hydrocarbylcarbonyloxy group, C₂-C₂₀ saturated hydrocarbyloxyhydrocarbyl group, C₂-C₂₀ saturated hydrocarbylthiohydrocarbyl group, halogen, nitro group, or cyano group. R³³ may also be hydroxy when j is 1 or 2. The saturated hydrocarbyl group, saturated hydrocarbyloxy group, saturated hydrocarbylcarbonyloxy group, saturated hydrocarbyloxyhydrocarbyl group and saturated hydrocarbylthiohydrocarbyl group may be straight, branched or cyclic. Groups R³³ may be identical or different when i is 2 or more.

In formula (C3), Y⁴ is a single bond, *-C(=O)-O- or *-C(=O)-NH-. The asterisk (*) designates a point of attachment to the carbon atom in the backbone.

In formula (C3), A³ is a single bond or a C₁-C₁₀ saturated hydrocarbylene group in which some constituent -CH₂- may be replaced by -O-. The saturated hydrocarbylene group may be straight, branched or cyclic and examples thereof are as exemplified for A¹ in formula (B1).

When repeat units of at least one type selected from repeat units C1 to C3 are incorporated, better performance is obtained because not only the aromatic ring possesses etch resistance, but the cyclic structure incorporated into the main chain also exerts the effect of improving resistance to etching and EB irradiation during pattern inspection step.

The repeat units C1 to C3 are preferably incorporated in a range of at least 5 mol% based on the overall repeat units of the polymer in the base polymer for obtaining the effect of improving etch resistance. Also, the repeat units C1 to C3 are preferably incorporated in a range of up to 35 mol%, more preferably up to 30 mol% based on the overall repeat units of the polymer in the base polymer. When the repeat units C1 to C3 are incorporated, their content of up to 35 mol% is preferred because the risk of forming development defects is eliminated. Each of the repeat units C1 to C3 may be of one type or a combination of plural types.

The total content of repeat units B 1, repeat units B2, repeat units B3, and repeat units of at least one type selected from repeat units C1 to C3 is preferably at least 60 mol%, more preferably at least 70 mol% based on the overall repeat units of the polymer in the base polymer.

The polymer may further comprise (meth)acrylate units protected with an acid labile group and/or (meth)acrylate units having an adhesive group such as a lactone structure or a hydroxy group other than phenolic hydroxy, as commonly used in the art. These repeat units are effective for fine adjustment of properties of a resist film, but not essential.

Examples of the (meth)acrylate unit having an adhesive group include repeat units having the following formula (C4), repeat units having the following formula (C5), and repeat units having the following formula (C6), which are also referred to as repeat units C4, C5, and C6, respectively. While these units do not exhibit acidity, they may be used as auxiliary units for providing adhesion to substrates or adjusting solubility.

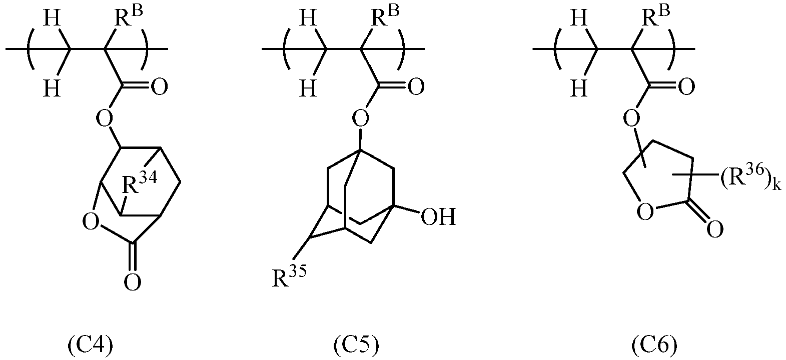

In formulae (C4) to (C6), R^{B} is as defined above. R³⁴ is -O- or methylene. R³⁵ is hydrogen or hydroxy. R³⁶ is a C₁-C₄ saturated hydrocarbyl group, and k is an integer of 0 to 3.

When the repeat units C4 to C6 are included, their content is preferably 0 to 30 mol%, more preferably 0 to 20 mol% based on the overall repeat units of the polymer. Each of the repeat units C4 to C6 may be of one type or a combination of plural types.

In another embodiment, the base polymer is a mixture of a polymer containing repeat units A1 to A8 and a polymer not containing repeat units A1 to A8, specifically a polymer containing repeat units of at least one type selected from repeat units having formula (B1), repeat units having formula (B2), and repeat units having formula (B3), but not repeat units A1 to A8,
wherein R^{B} is hydrogen, fluorine, methyl or trifluoromethyl,
R²¹ is halogen, an optionally halogenated C₂-C₈ saturated hydrocarbylcarbonyloxy group, optionally halogenated C₁-C₆ saturated hydrocarbyl group, or optionally halogenated C₁-C₆ saturated hydrocarbyloxy group,
Y¹ is a single bond, *-C(=O)-O- or *-C(=O)-NH-, * designates a point of attachment to the carbon atom in the backbone,
A¹ is a single bond or a C₁-C₁₀ saturated hydrocarbylene group in which any constituent -CH₂- may be replaced by -O-,
a is an integer satisfying 0 ≤ a ≤ 5+2c-b, b is an integer of 1 to 3, and c is an integer of 0 to 2, 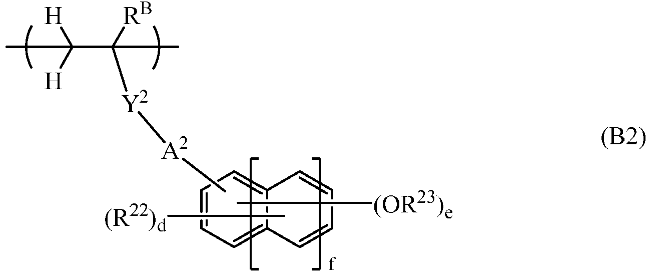 wherein R^{B} is as defined above,
R²² is halogen, an optionally halogenated C₂-C₈ saturated hydrocarbylcarbonyloxy group, optionally halogenated C₁-C₆ saturated hydrocarbyl group, or optionally halogenated C₁-C₆ saturated hydrocarbyloxy group,
Y² is a single bond, *-C(=O)-O- or *-C(=O)-NH-, * designates a point of attachment to the carbon atom in the backbone,
A² is a single bond or a C₁-C₁₀ saturated hydrocarbylene group in which any constituent -CH₂- may be replaced by -O-,
R²³ is an acid labile group when e is 1, and R²³ is hydrogen or an acid labile group, at least one being an acid labile group, when e is 2 or 3,
d is an integer satisfying 0 ≤ d ≤ 5+2f-e, e is an integer of 1 to 3, and f is an integer of 0 to 2, 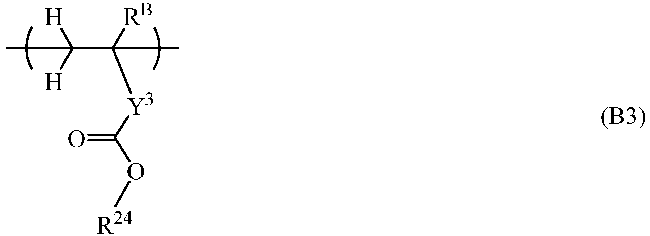 wherein R^{B} is as defined above,
Y³ is a single bond, phenylene group, naphthylene group or a C₁-C₁₂ linking group having an ester bond, ether bond or lactone ring, and
R²⁴ is an acid labile group, 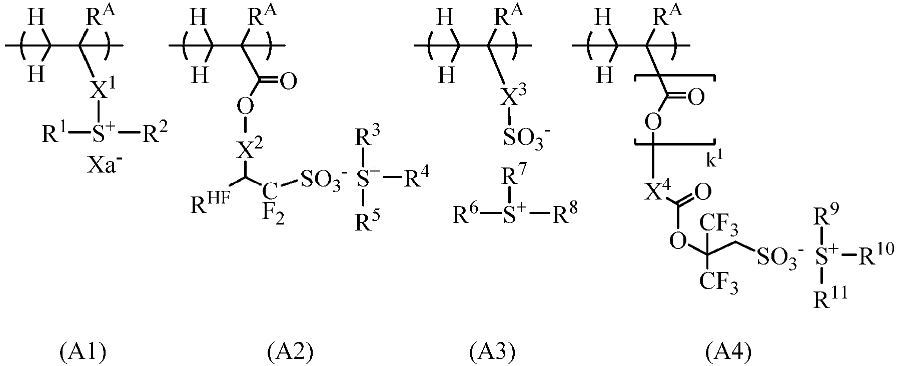 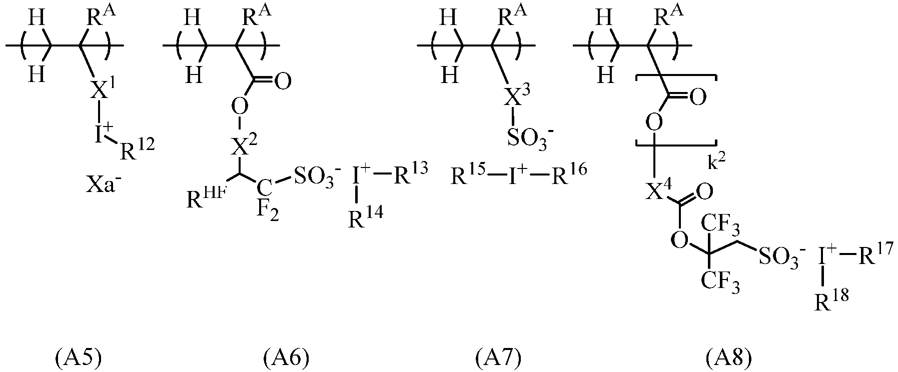 wherein R^{A} is each independently hydrogen or methyl,
X¹ is a single bond, a C₁-C₆ aliphatic hydrocarbylene group, phenylene group, naphthylene group or C₇-C₁₈ group obtained by combining the foregoing, *-O-X¹¹-, *-C(=O)-O-X¹¹-, or *-C(=O)-NH-X¹¹-, X¹¹ is a C₁-C₆ aliphatic hydrocarbylene group, phenylene group, naphthylene group or C₇-C₁₈ group obtained by combining the foregoing, which may contain a carbonyl moiety, ester bond, ether bond or hydroxy moiety,
X² is a single bond or **-X²¹-C(=O)-O-, X²¹ is a C₁-C₂₀ hydrocarbylene group which may contain a heteroatom,
X³ is a single bond, methylene, ethylene, phenylene, fluorinated phenylene, trifluoromethyl-substituted phenylene, *-O-X³¹-, *-C(=O)-O-X³¹-, or *-C(=O)-NH-X³¹-, X³¹ is a C₁-C₆ aliphatic hydrocarbylene group, phenylene group, fluorinated phenylene group, trifluoromethyl-substituted phenylene group, or C₇-C₂₀ group obtained by combining the foregoing, which may contain a carbonyl moiety, ester bond, ether bond or hydroxy moiety,
* designates a point of attachment to the carbon atom in the backbone, ** designates a point of attachment to the oxygen atom in the formula,
X⁴ is a single bond or C₁-C₃₀ hydrocarbylene group which may contain a heteroatom, k¹ and k² are each independently 0 or 1, k¹ and k² are 0 when X⁴ is a single bond,
R¹ to R¹⁸ are each independently halogen or a C₁-C₂₀ hydrocarbyl group which may contain a heteroatom, R¹ and R² may bond together to form a ring with the sulfur atom to which they are attached, R³ and R⁴, R⁶ and R⁷, or R⁹ and R¹⁰ may bond together to form a ring with the sulfur atom to which they are attached,
R^{HF} is hydrogen or trifluoromethyl, and
Xa⁻ is a non-nucleophilic counter ion.
The mixture preferably consists of 100 parts by weight of the polymer containing repeat units A1 to A8 and 2 to 5,000 parts by weight, more preferably 10 to 1,000 parts by weight of the polymer not containing repeat units A1 to A8.

In formulae (A2) and (A6), X² is a single bond or **-X²¹-C(=O)-O- wherein X²¹ is a C₁-C₂₀ hydrocarbylene group which may contain a heteroatom. Examples of the hydrocarbylene group X²¹ are given below, but not limited thereto.

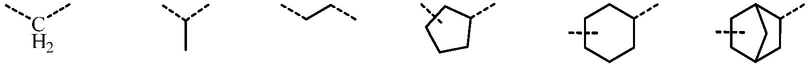

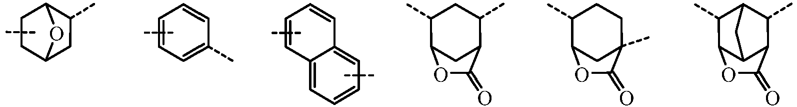

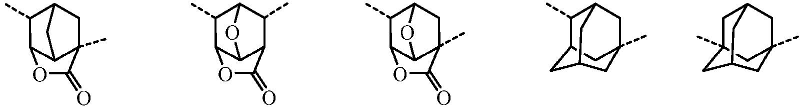

In formulae (A2) and (A6), R^{HF} is hydrogen or trifluoromethyl. Examples of the repeat units A2 and A6 wherein R^{HF} is hydrogen are as exemplified in USP 8,105,748 (JP-A 2010-116550). Examples of the repeat units A2 and A6 wherein R^{HF} is trifluoromethyl are as exemplified in USP 8,057,985 (JP-A 2010-077404). Examples of the repeat units A3 and A7 are as exemplified in USP 8,835,097 (JP-A 2012-246265) and USP 8,900,793 (JP-A 2012-246426).

In formulae (A1) and (A5), Xa⁻ is a non-nucleophilic counter ion. Examples of the non-nucleophilic counter ion Xa⁻ are as exemplified in USP 8,349,533 (JP-A 2010-113209) and USP 7,511,169 (JP-A 2007-145797).

In formulae (A4) and (A8), X⁴ is a single bond or C₁-C₃₀ hydrocarbylene group which may contain a heteroatom. The hydrocarbylene group may be saturated or unsaturated and straight, branched or cyclic. Examples thereof include alkanediyl groups such as methanediyl, ethane-1,2-diyl, propane-1,3-diyl, butane-1,4-diyl, pentane-1,5-diyl, hexane-1,6-diyl, heptane-1,7-diyl, octane-1,8-diyl, nonane-1,9-diyl, decane-1,10-diyl, undecane-1,11 -diyl, dodecane-1,12-diyl, tridecane-1,13-diyl, tetradecane-1,14-diyl, pentadecane-1,15-diyl, hexadecane-1,16-diyl, and heptadecane-1,17-diyl; cyclic saturated hydrocarbylene groups such as cyclopentanediyl, cyclohexanediyl, norbornanediyl, and adamantanediyl; arylene groups such as phenylene, methylphenylene, ethylphenylene, n-propylphenylene, isopropylphenylene, n-butylphenylene, isobutylphenylene, sec-butylphenylene, tert-butylphenylene, naphthylene, methylnaphthylene, ethylnaphthylene, n-propylnaphthylene, isopropylnaphthylene, n-butylnaphthylene, isobutylnaphthylene, sec-butylnaphthylene, and tert-butylnaphthylene; and combinations thereof.

In the hydrocarbylene group, some or all of the hydrogen atoms may be substituted by a moiety containing a heteroatom such as oxygen, sulfur, nitrogen or halogen and some constituent -CH₂- may be replaced by a moiety containing a heteroatom such as oxygen, sulfur or nitrogen, so that the group may contain a hydroxy moiety, cyano moiety, fluorine, chlorine, bromine, iodine, carbonyl moiety, ether bond, ester bond, sulfonic ester bond, carbonate bond, lactone ring, sultone ring, carboxylic anhydride, or haloalkyl moiety.

Preferred examples of the anion in the monomer from which repeat units A4 and A8 are derived are shown below, but not limited thereto.

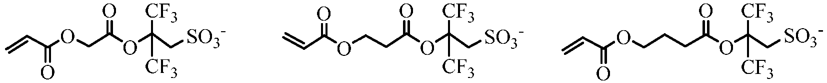

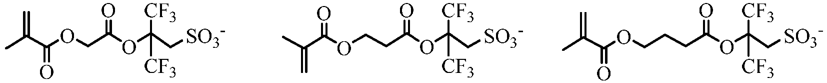

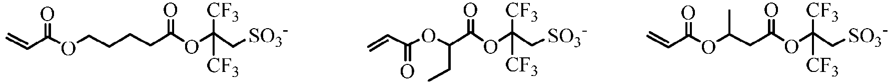

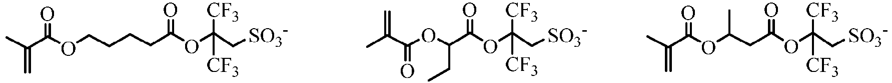

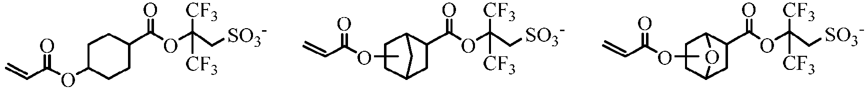

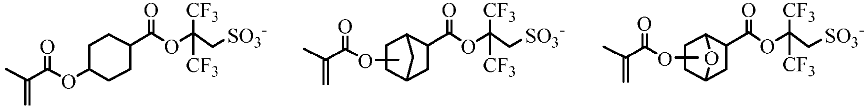

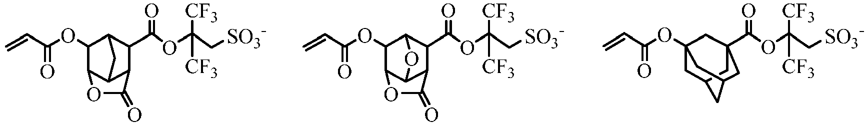

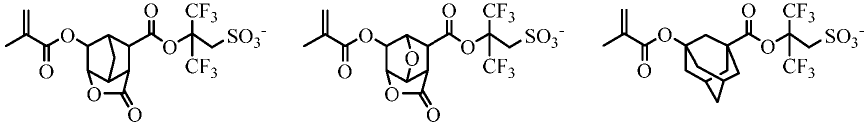

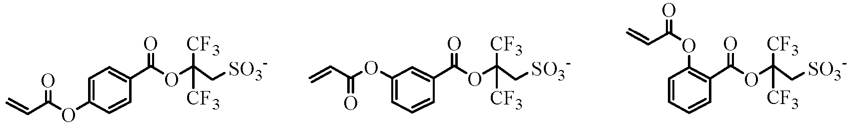

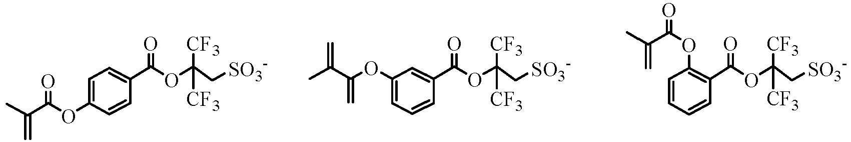

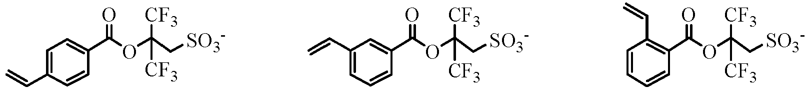

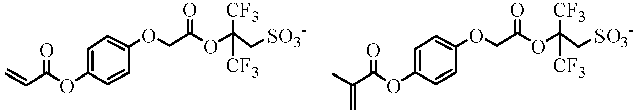

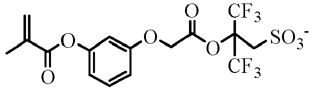

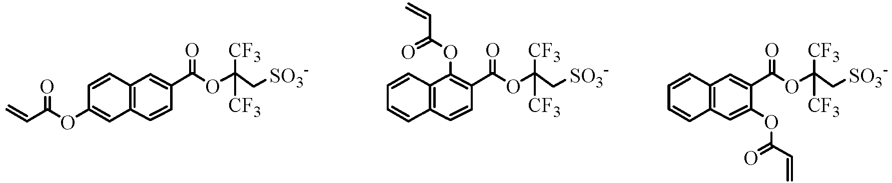

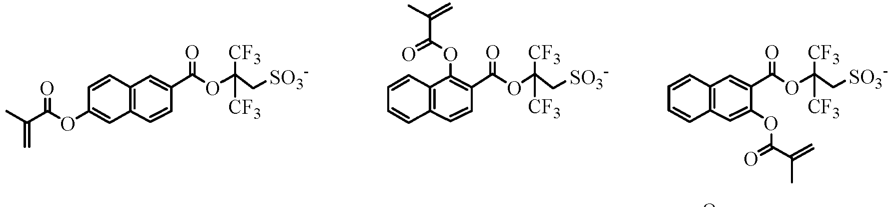

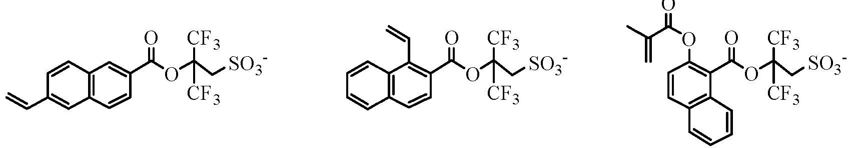

In formulae (A1) to (A8), R¹ to R¹⁸ are each independently halogen or a C₁-C₂₀ hydrocarbyl group which may contain a heteroatom.

Suitable halogen atoms include fluorine, chlorine, bromine and iodine.

The C₁-C₂₀ hydrocarbyl group may be saturated or unsaturated and straight, branched or cyclic. Examples thereof include C₁-C₂₀ alkyl groups such as methyl, ethyl, propyl, isopropyl, n-butyl, sec-butyl, tert-butyl, tert-pentyl, n-pentyl, n-hexyl, n-octyl, 2-ethylhexyl, n-nonyl and n-decyl; C₃-C₂₀ cyclic saturated hydrocarbyl groups such as cyclopentyl, cyclohexyl, cyclopentylmethyl, cyclopentylethyl, cyclopentylbutyl, cyclohexylmethyl, cyclohexylethyl, cyclohexylbutyl, norbornyl, tricyclo[5.2.1.0^{2,6}]decanyl, adamantyl, and adamantylmethyl; and C₆-C₂₀ aryl groups such as phenyl, naphthyl and anthracenyl. In the hydrocarbyl groups, some or all of the hydrogen atoms may be substituted by a moiety containing a heteroatom such as oxygen, sulfur, nitrogen or halogen, and a moiety containing a heteroatom such as oxygen, sulfur or nitrogen may intervene in a carbon-carbon bond, so that the group may contain a hydroxy, fluorine, chlorine, bromine, iodine, cyano, carbonyl, ether bond, ester bond, sulfonic ester bond, carbonate bond, lactone ring, sultone ring, carboxylic anhydride or haloalkyl.

Also, R¹ and R² may bond together to form a ring with the sulfur atom to which they are attached, R³ and R⁴, R⁶ and R⁷, or R⁹ and R¹⁰ may bond together to form a ring with the sulfur atom to which they are attached. Examples of the ring are shown below.

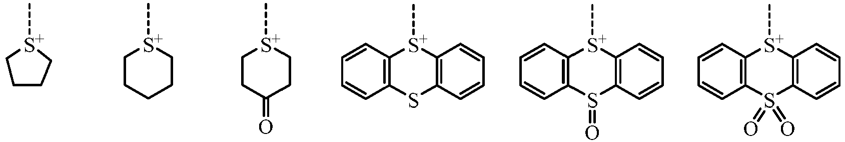

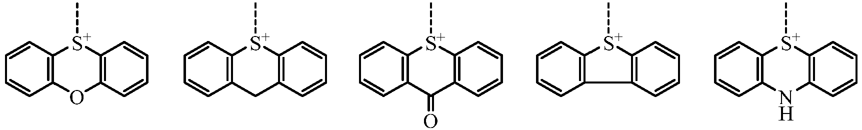

Exemplary structures of the sulfonium cation in formulae (A2) to (A4) are shown below, but not limited thereto.

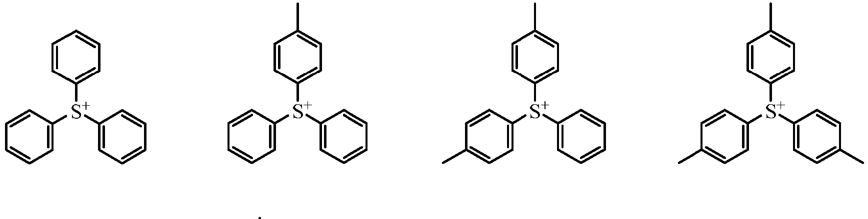

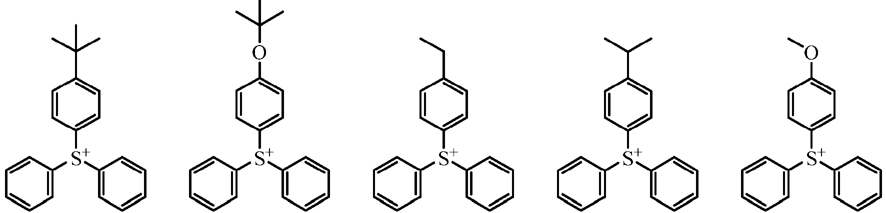

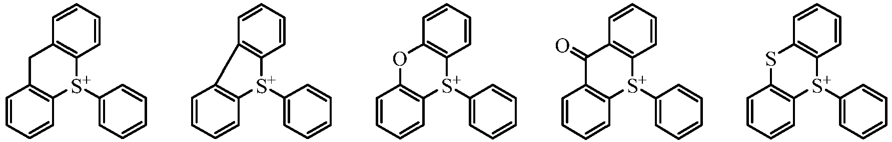

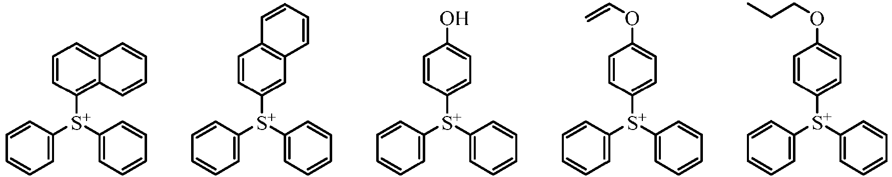

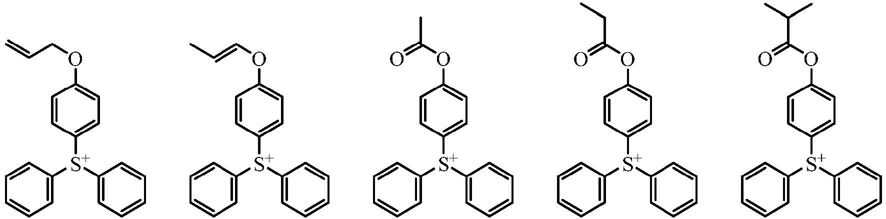

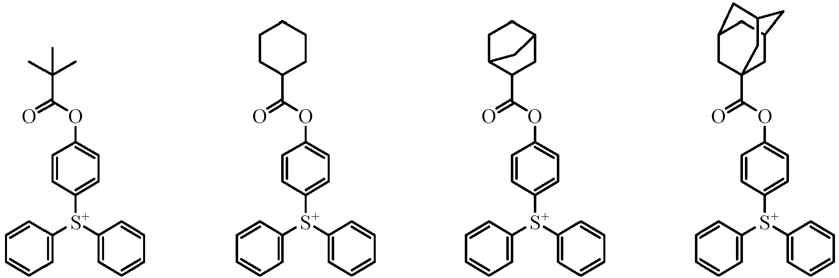

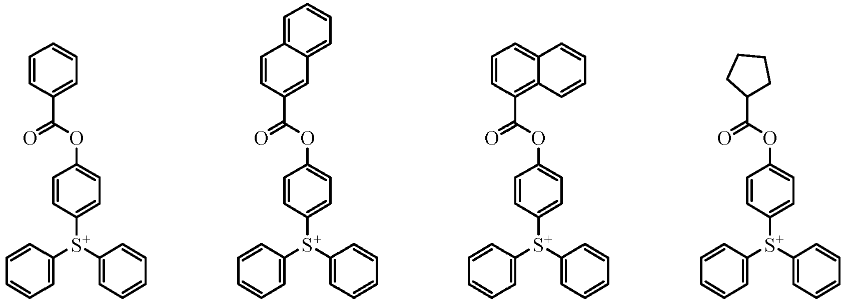

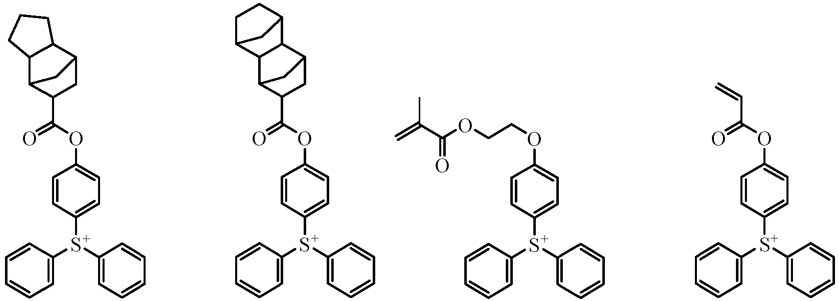

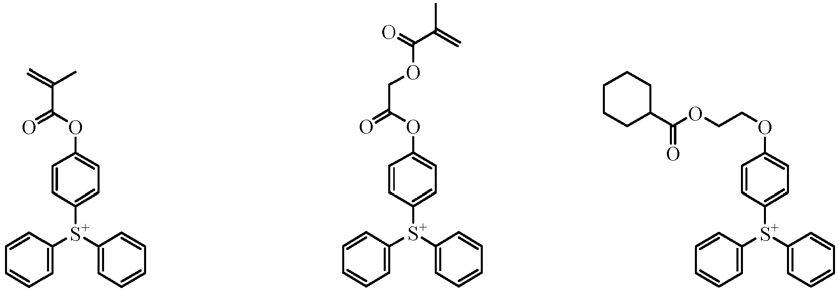

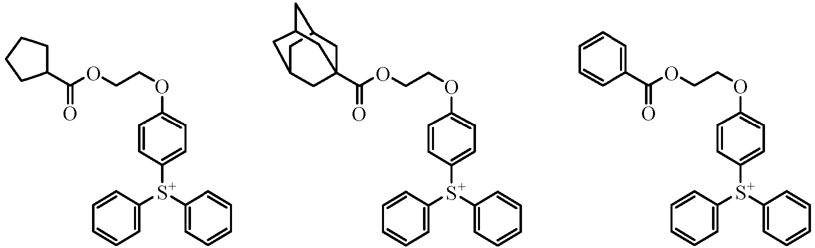

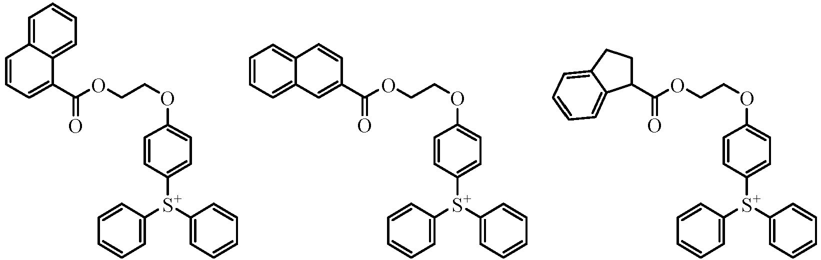

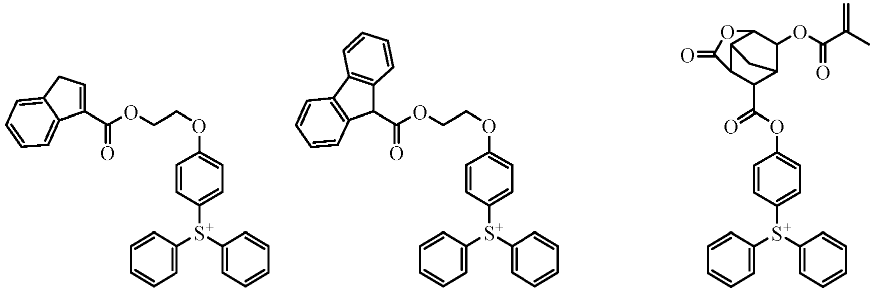

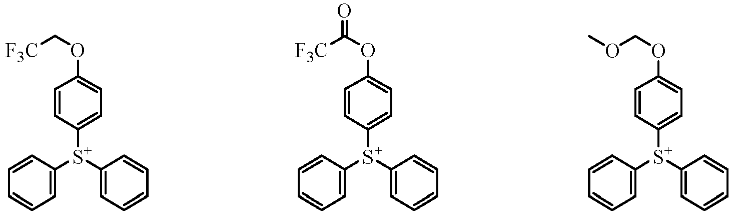

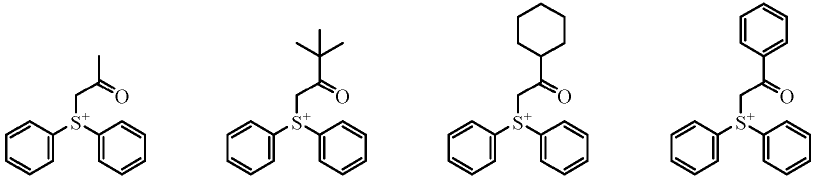

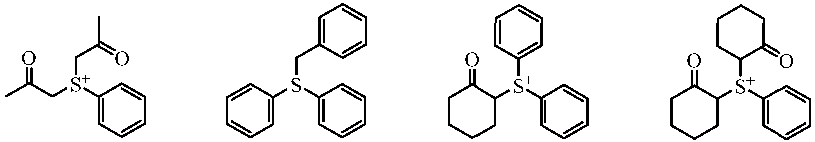

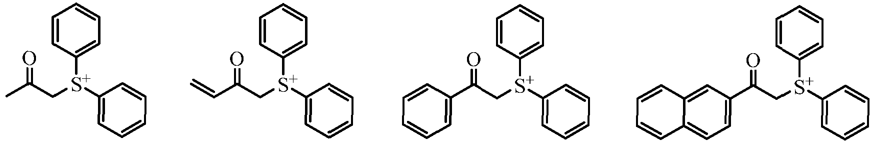

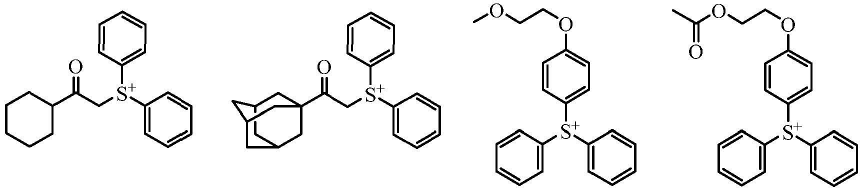

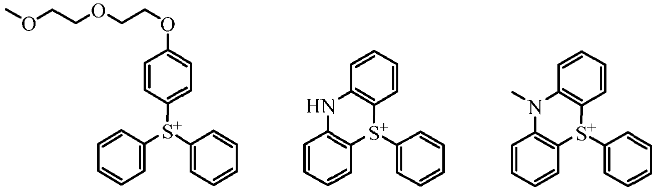

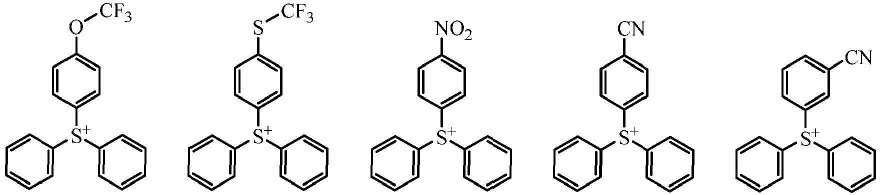

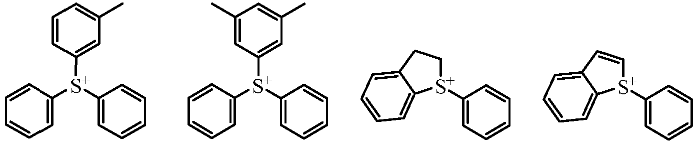

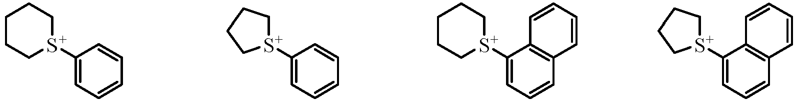

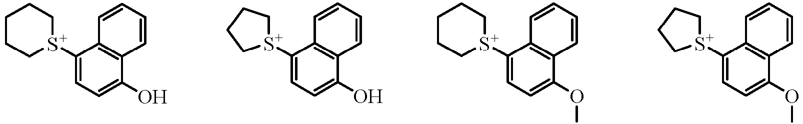

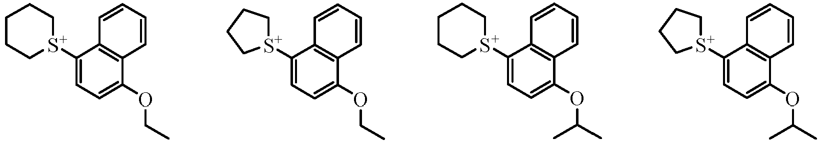

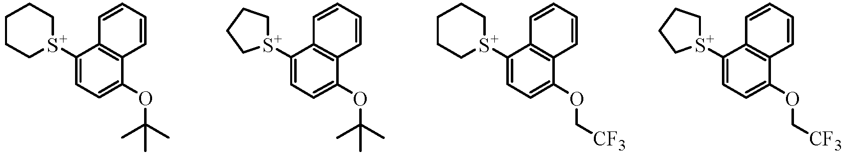

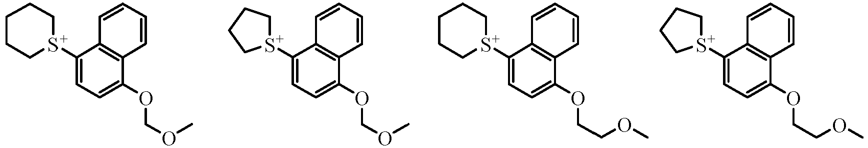

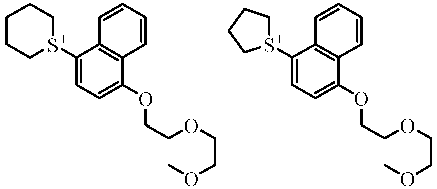

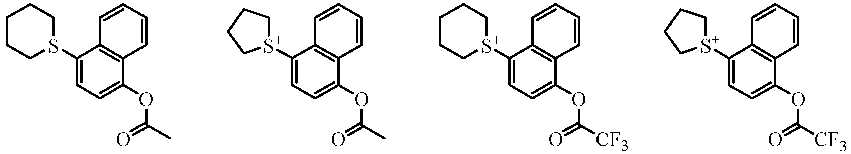

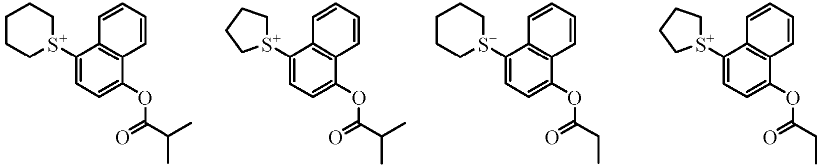

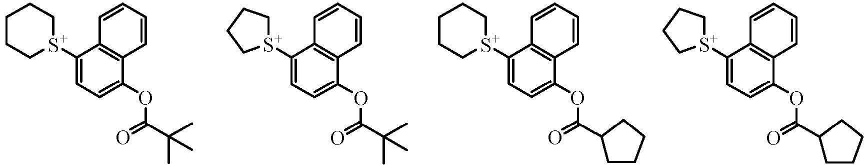

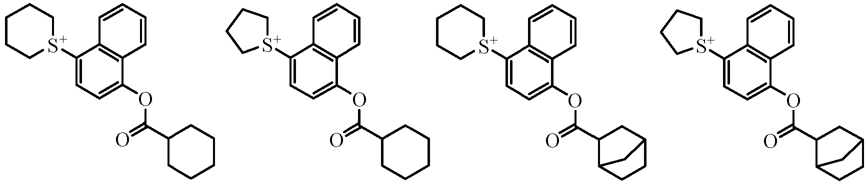

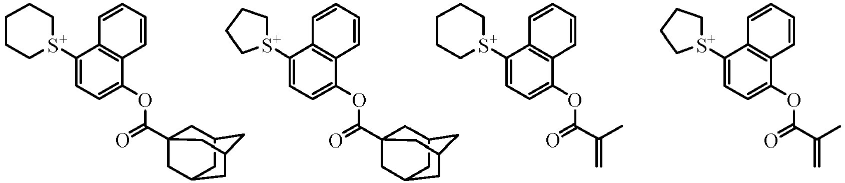

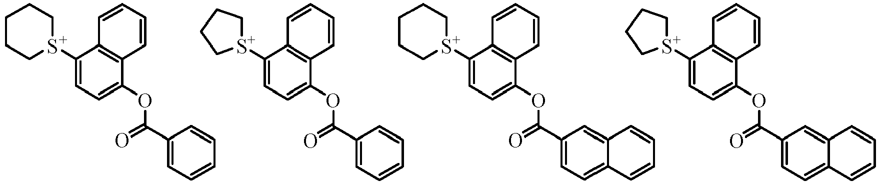

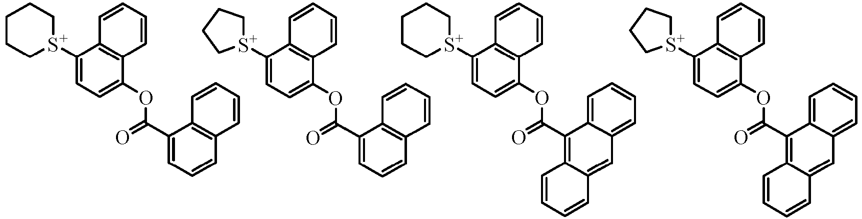

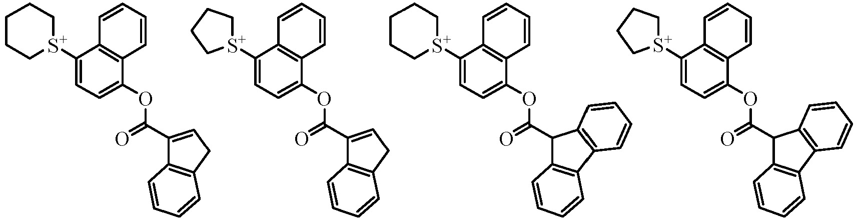

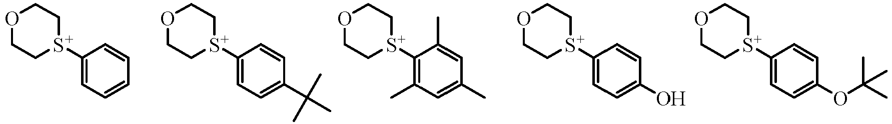

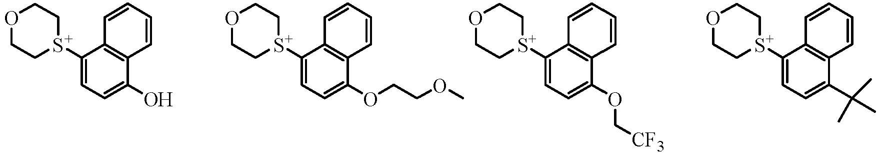

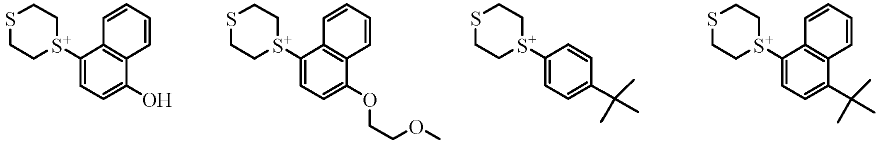

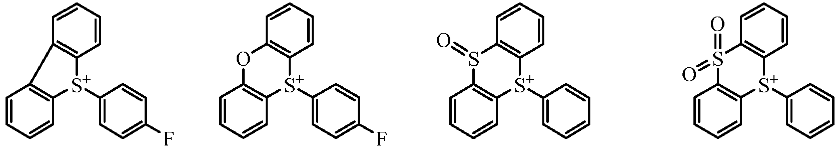

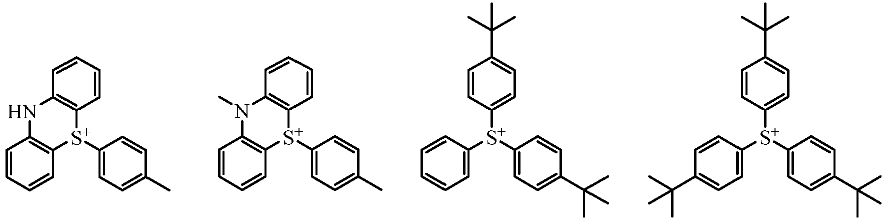

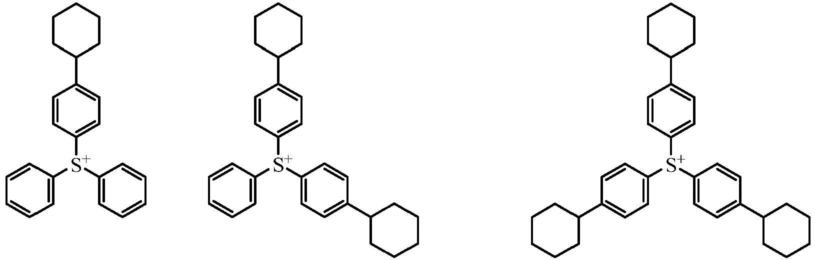

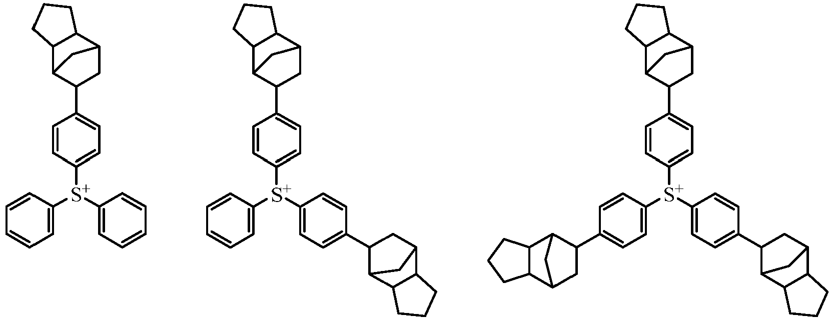

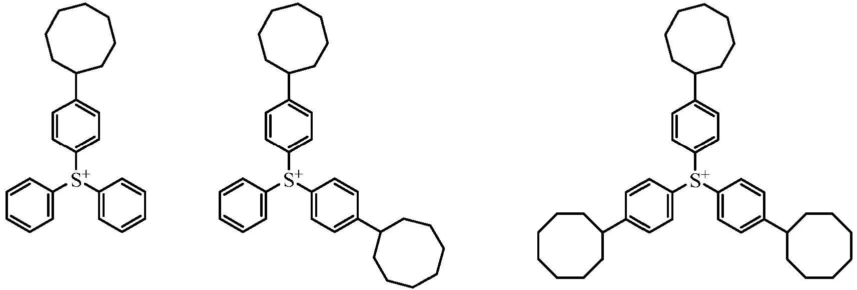

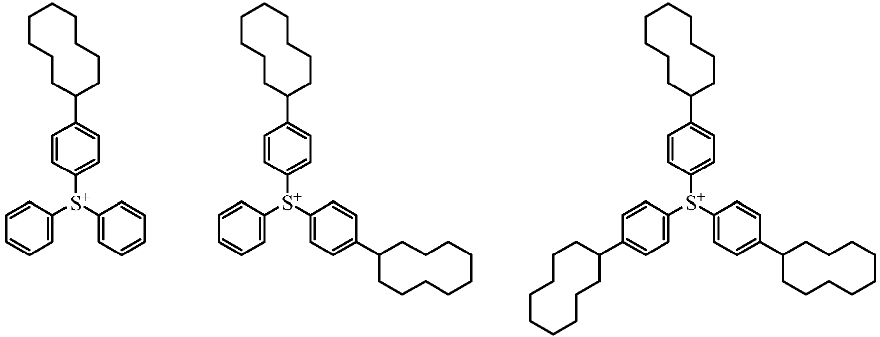

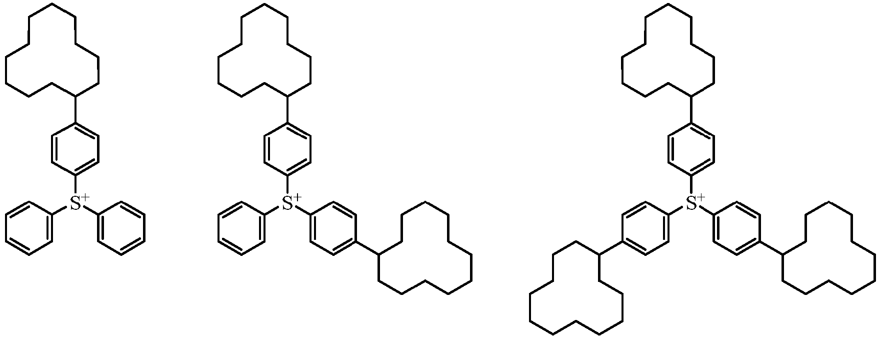

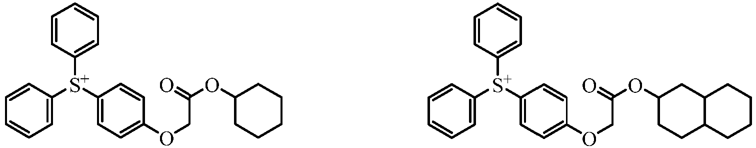

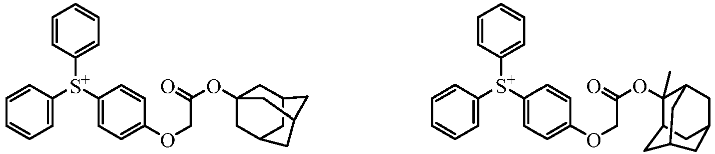

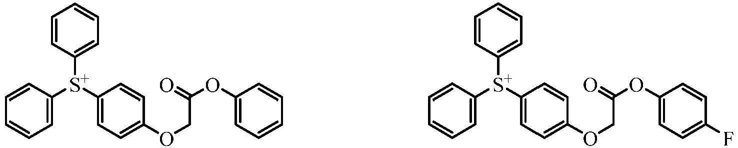

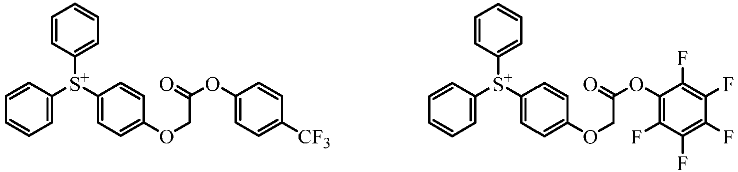

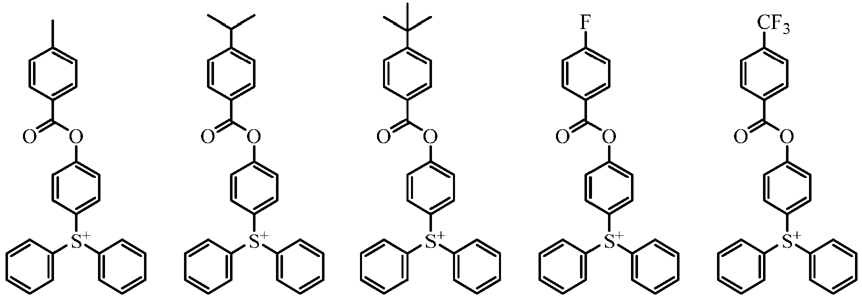

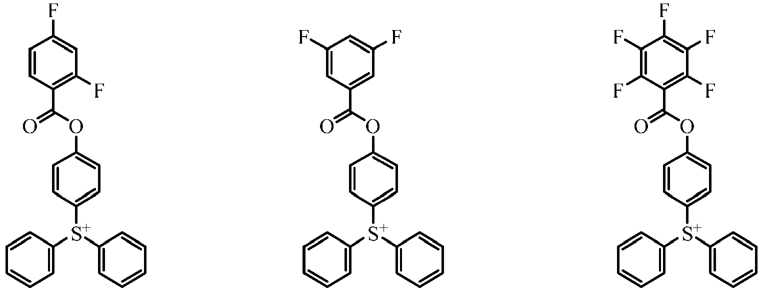

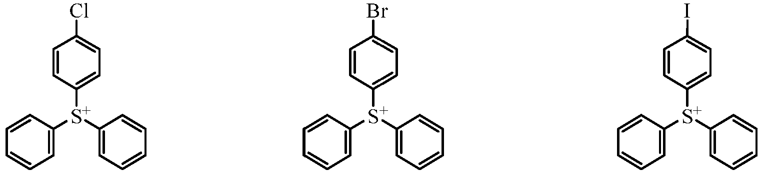

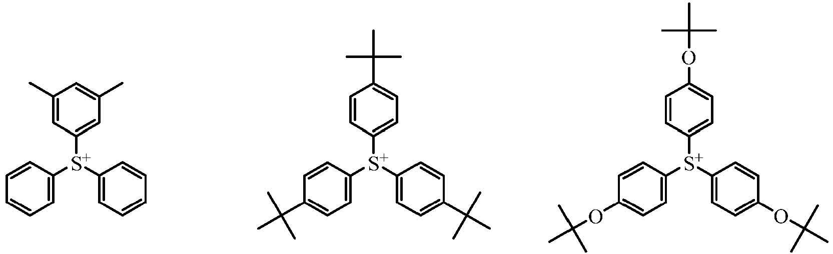

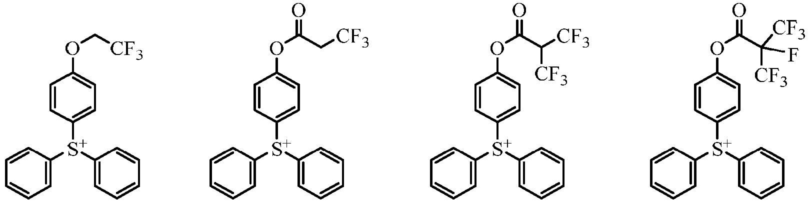

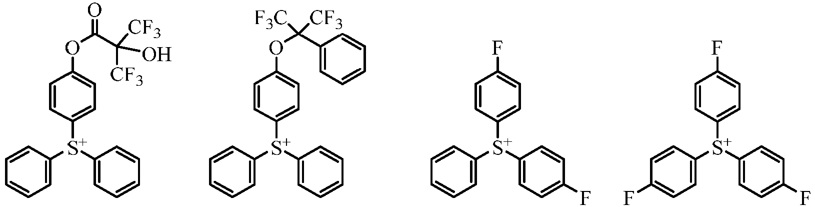

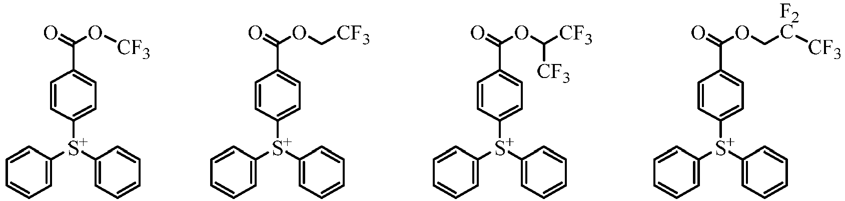

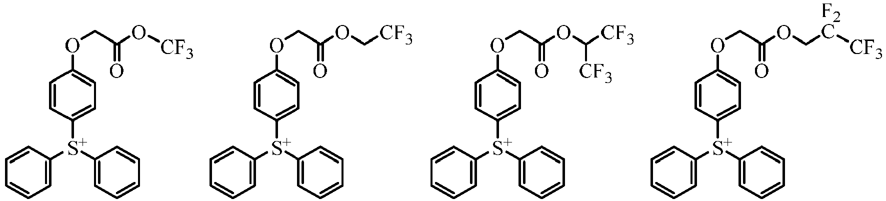

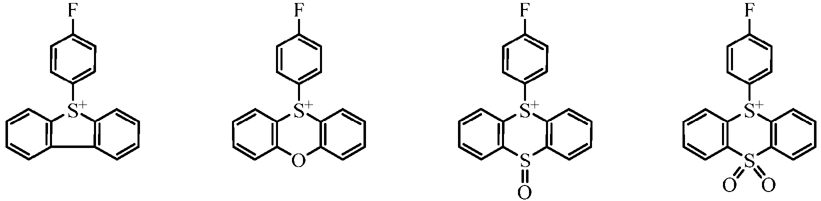

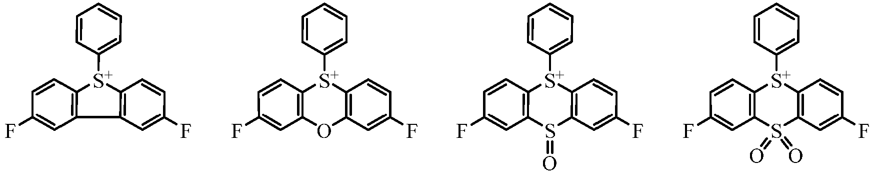

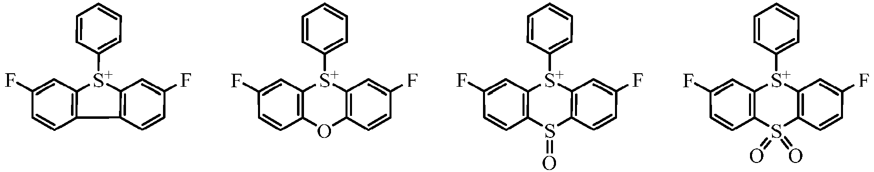

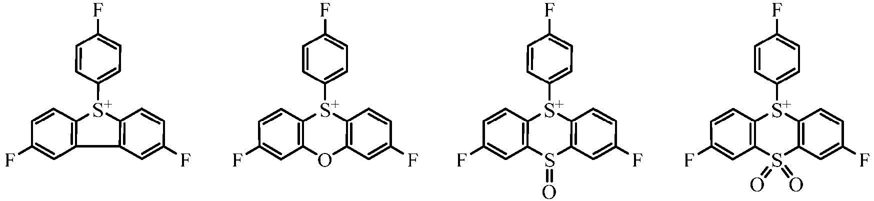

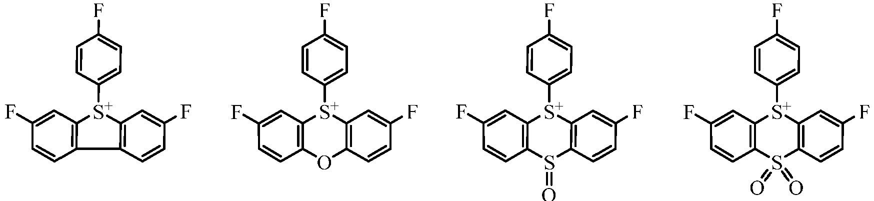

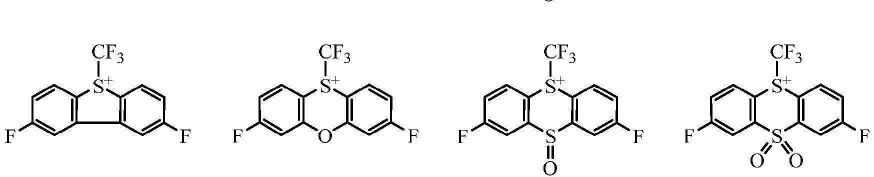

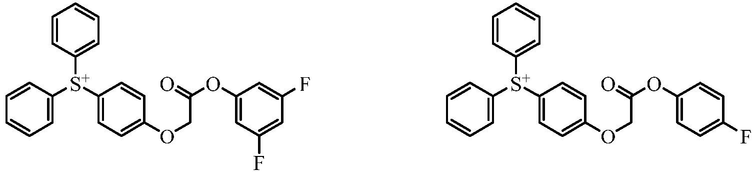

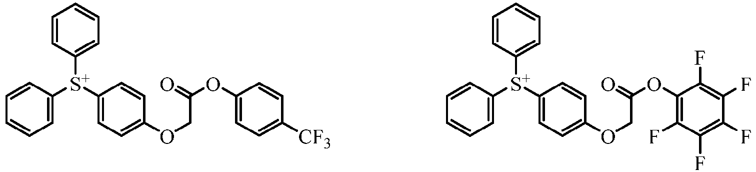

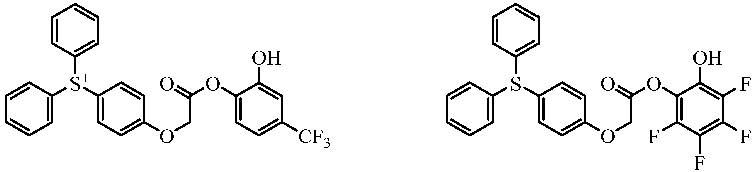

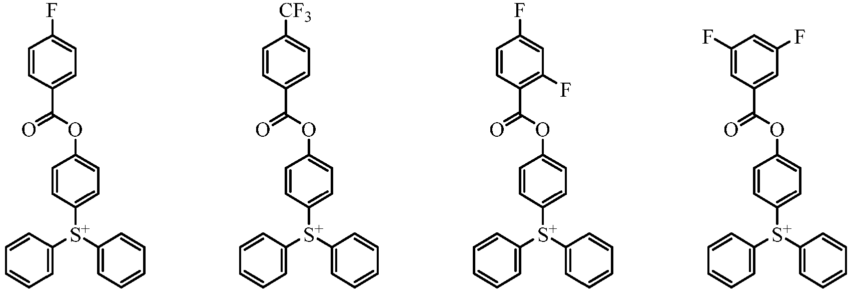

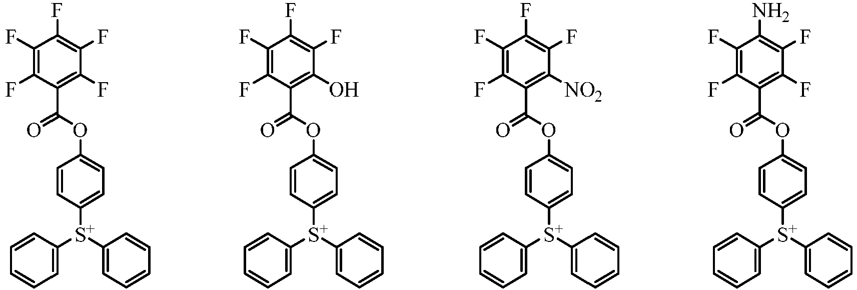

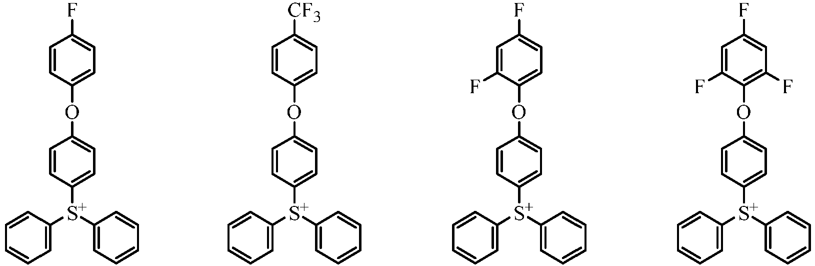

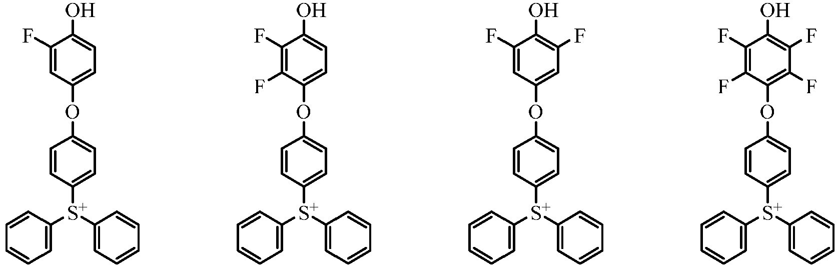

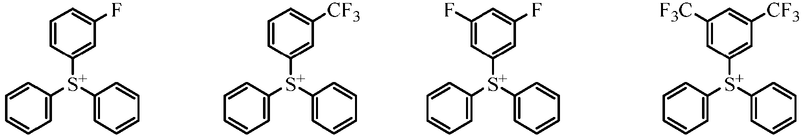

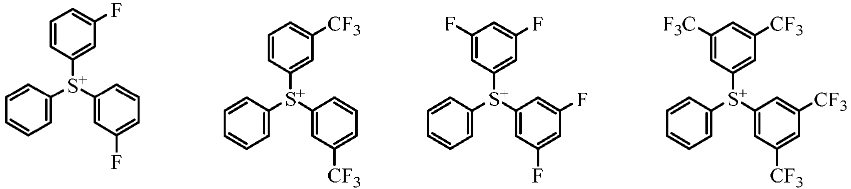

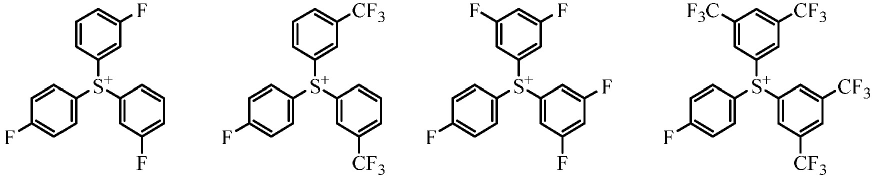

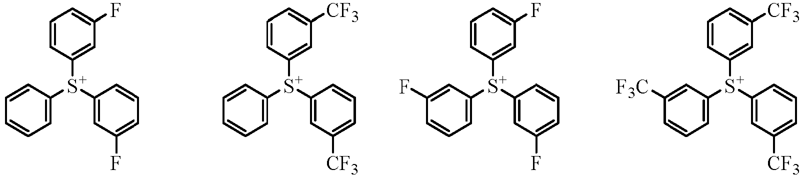

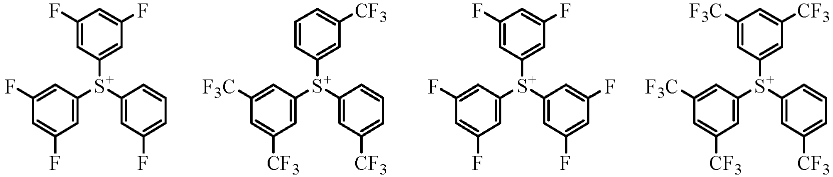

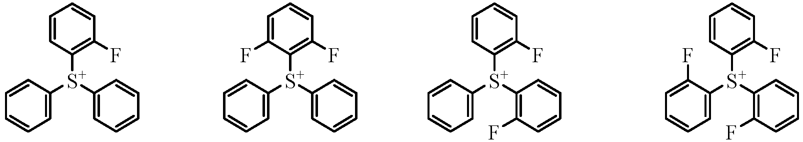

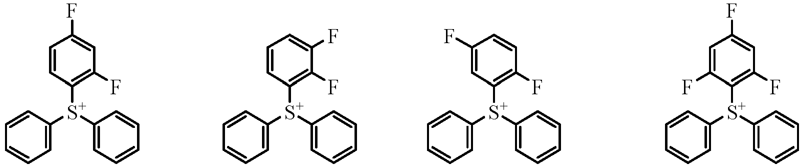

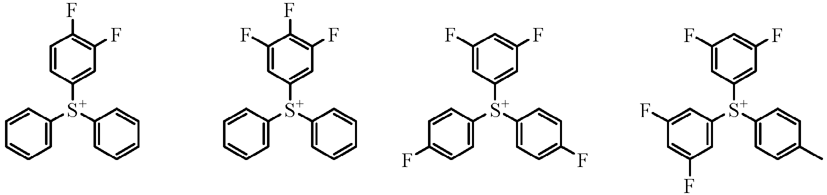

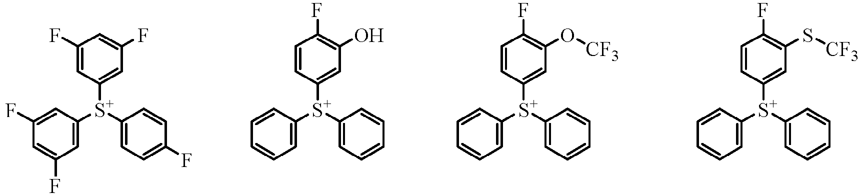

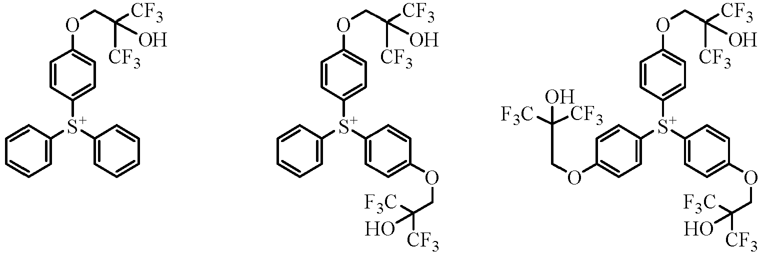

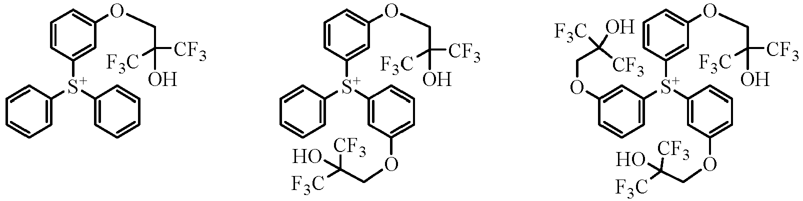

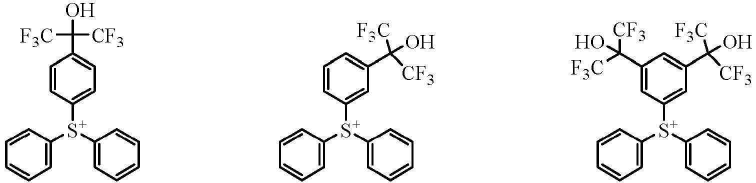

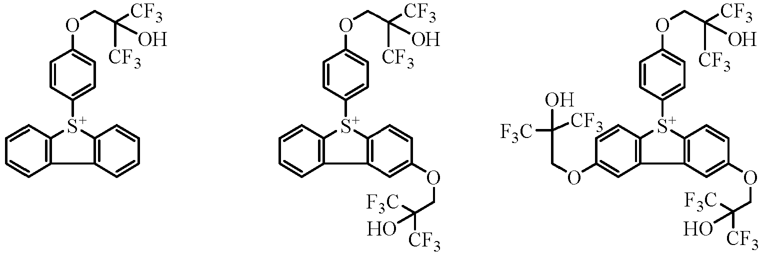

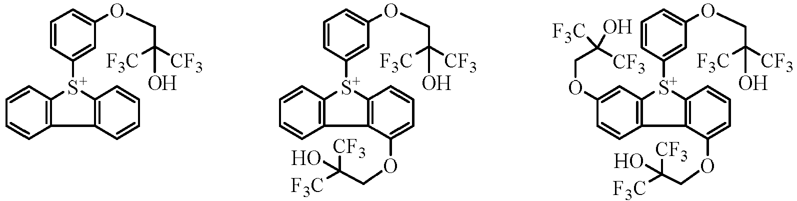

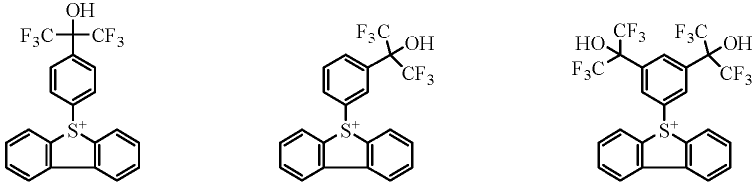

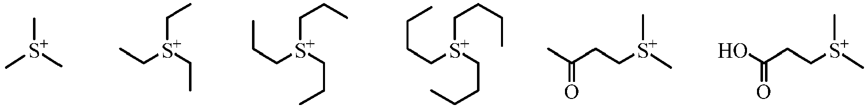

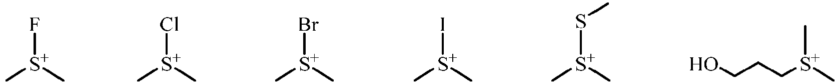

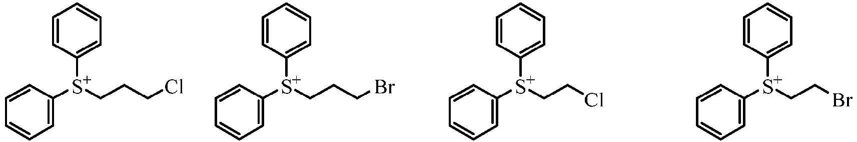

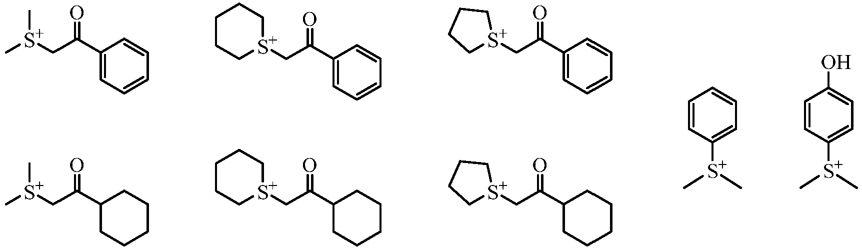

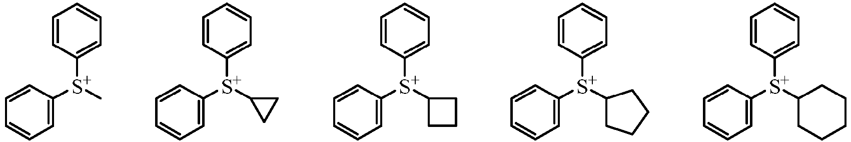

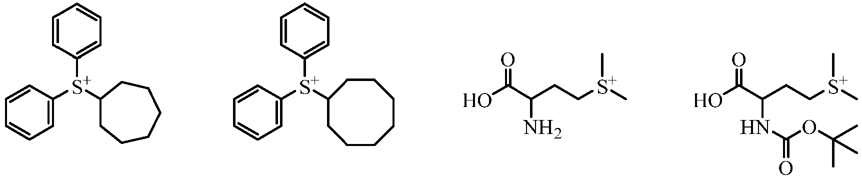

Exemplary structures of the iodonium cation in formulae (A5) to (A8) are shown below, but not limited thereto.

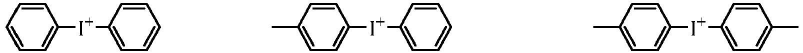

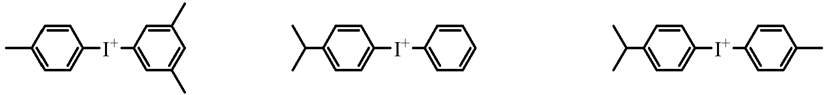

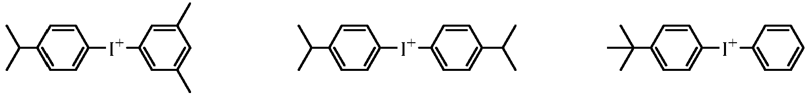

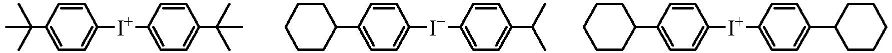

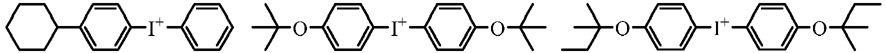

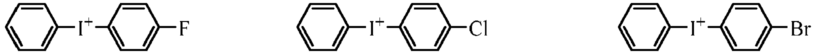

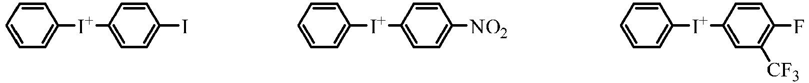

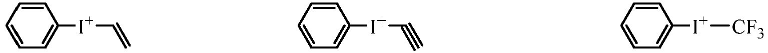

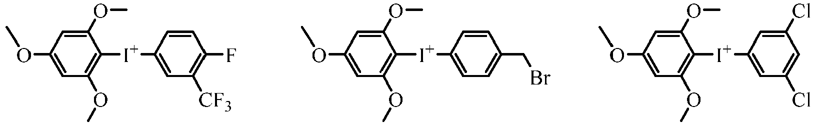

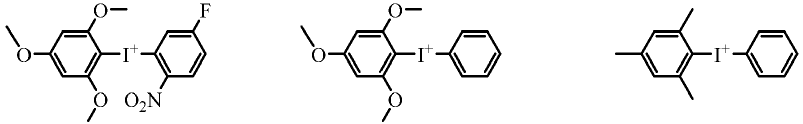

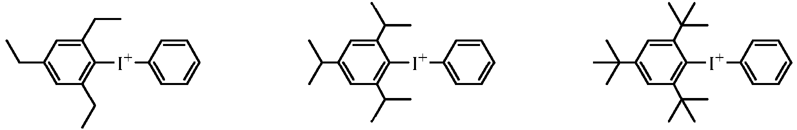

The phenolic hydroxy group-containing unit is a repeat unit having the following formula (B1), which is also referred to as repeat unit B1, hereinafter.

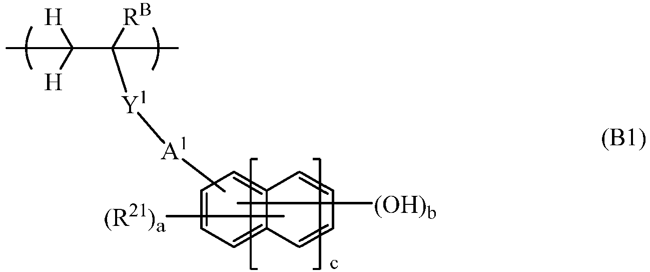

In formula (B 1), R^{B} is hydrogen, fluorine, methyl or trifluoromethyl.

In formula (B1), R²¹ is halogen, an optionally halogenated C₂-C₈ saturated hydrocarbylcarbonyloxy group, optionally halogenated C₁-C₆ saturated hydrocarbyl group, or optionally halogenated C₁-C₆ saturated hydrocarbyloxy group. The saturated hydrocarbyl group and saturated hydrocarbyl moiety in the saturated hydrocarbylcarbonyloxy group and saturated hydrocarbyloxy group may be straight, branched or cyclic, and examples thereof include alkyl groups such as methyl, ethyl, propyl, isopropyl, butyl, pentyl, and hexyl, cycloalkyl groups such as cyclopropyl, cyclobutyl, cyclopentyl and cyclohexyl, and combinations thereof. A carbon count within the upper limit ensures good solubility in alkaline developer. Groups R²¹ may be identical or different when "a" is 2 or more.

In formula (B1), Y¹ is a single bond, *-C(=O)-O- or *-C(=O)-NH-. The asterisk (*) designates a point of attachment to the carbon atom in the backbone.

In formula (B 1), A¹ is a single bond or a C₁-C₁₀ saturated hydrocarbylene group in which any constituent -CH₂- may be replaced by -O-. The saturated hydrocarbylene group may be straight, branched or cyclic and examples thereof include C₁-C₁₀ alkanediyl groups such as methylene, ethane-1,2-diyl, propane-1,3-diyl, butane-1,4-diyl, pentane-1,5-diyl, hexane-1,6-diyl, and structural isomers thereof; C₃-C₁₀ cyclic saturated hydrocarbylene groups such as cyclopropanediyl, cyclobutanediyl, cyclopentanediyl, and cyclohexanediyl; and combinations thereof.

In formula (B1), "a" is an integer satisfying 0 ≤ a ≤ 5+2c-b, b is an integer of 1 to 3, and c is an integer of 0 to 2.

Preferred examples of the repeat unit B1 wherein both Y¹ and A¹ are a single bond include units derived from 3-hydroxystyrene, 4-hydroxystyrene, 5-hydroxy-2-vinylnaphthalene, and 6-hydroxy-2-vinylnaphthalene.
Preferred examples of the repeat unit B1 wherein Y¹ is other than a single bond are shown below, but not limited thereto. Herein R^{B} is as defined above.

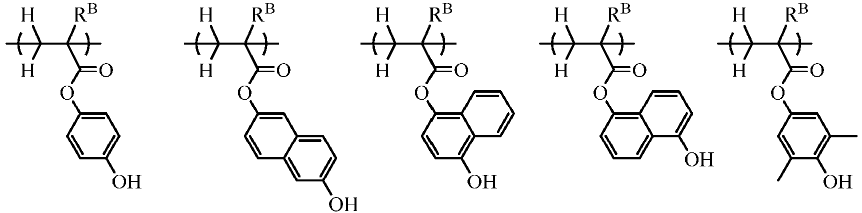

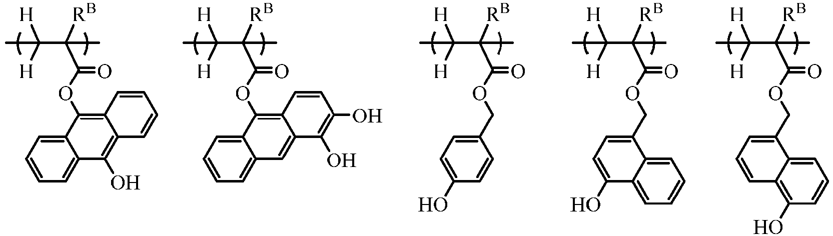

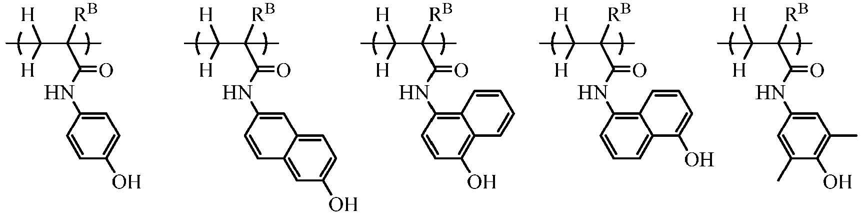

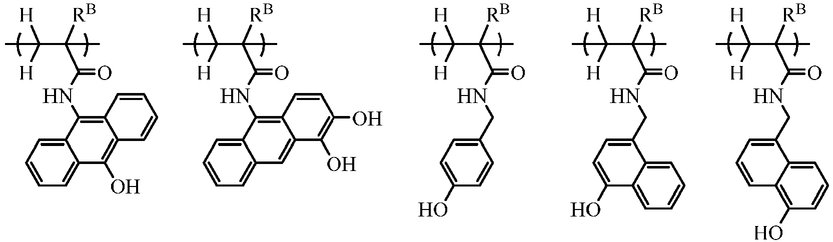

The repeat units B1 are preferably incorporated in a range of 10 to 95 mol%, more preferably 30 to 85 mol% based on the overall repeat units of the polymer in the base polymer. It is noted that when the polymer contains additional repeat units of at least one type selected from repeat units having formulae (B3) and (B4) contributing to high etching resistance, the additional repeat units having a phenolic hydroxy group as a substituent group, the sum of repeat units B1 and additional repeat units preferably falls in the above range. The repeat units B1 used herein may be of one type or a mixture of two or more types.

The unit containing a phenolic hydroxy group protected with an acid labile group is a repeat unit having the following formula (B2), also referred to as repeat unit B2, hereinafter.

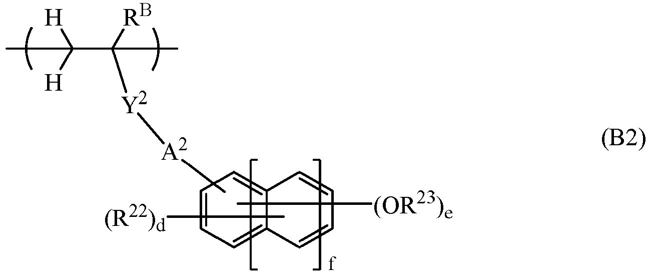

In formula (B2), R^{B} is as defined above. R²² is halogen, an optionally halogenated C₂-C₈ saturated hydrocarbylcarbonyloxy group, optionally halogenated C₁-C₆ saturated hydrocarbyl group, or optionally halogenated C₁-C₆ saturated hydrocarbyloxy group. The saturated hydrocarbyl group and saturated hydrocarbyl moiety in the saturated hydrocarbylcarbonyloxy group and saturated hydrocarbyloxy group may be straight, branched or cyclic, and examples thereof are as exemplified above for R²¹ in formula (B1). A carbon count within the upper limit ensures good solubility in alkaline developer. Groups R²² may be identical or different when d is 2 or more.

In formula (B2), Y² is a single bond, *-C(=O)-O- or *-C(=O)-NH-. The asterisk (*) designates a point of attachment to the carbon atom in the backbone.

In formula (B2), A² is a single bond or a C₁-C₁₀ saturated hydrocarbylene group in which any constituent -CH₂- may be replaced by -O-. The saturated hydrocarbylene group may be straight, branched or cyclic, and examples thereof are as exemplified above for A¹ in formula (B1).

In formula (B2), R²³ is an acid labile group when e = 1. R²³ is hydrogen or an acid labile group, at least one being an acid labile group, when e = 2 or 3.

In formula (B2), d is an integer satisfying 0 ≤ d ≤ 5+2f-e, e is an integer of 1 to 3, and f is an integer of 0 to 2.

The unit containing a carboxy group protected with an acid labile group is a repeat unit having the following formula (B3), also referred to as repeat unit B3, hereinafter.

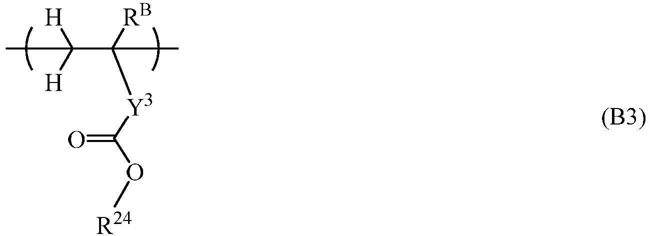

In formula (B3), R^{B} is as defined above. Y³ is a single bond, phenylene group, naphthylene group or a C₁-C₁₂ linking group having an ester bond, ether bond or lactone ring. R²⁴ is an acid labile group.

The acid labile group represented by R²³ and R²⁴ is not particularly limited as long as it is eliminated under the action of acid, leaving an acidic group. It may be any of acid labile groups which are commonly used in many well-known chemically amplified resist compositions.

The repeat unit B2 is a unit having a phenolic hydroxy group whose hydrogen is substituted by an acid labile group, preferably a unit derived from hydroxystyrene or hydroxyphenyl (meth)acrylate in which the hydrogen atom of the hydroxy group is substituted by an acid labile group. Examples of the monomer from which repeat unit B2 is derived are shown below, but not limited thereto. Herein R^{B} and R²³ are as defined above.

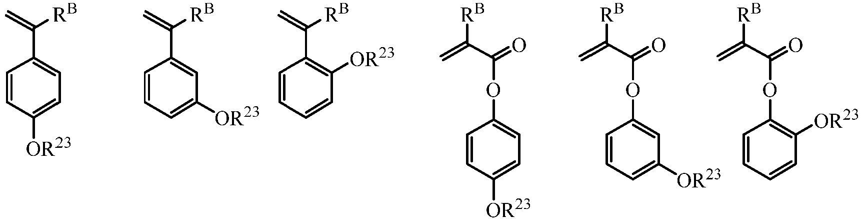

The repeat unit B3 is a unit having a carboxy group whose hydrogen is substituted by an acid labile group, preferably a unit derived from a hydroxy-containing (meth)acrylate in which the hydrogen atom of the hydroxy group is substituted by an acid labile group. Examples of the monomer from which repeat unit B3 is derived are shown below, but not limited thereto. Herein R^{B} and R²⁴ are as defined above.

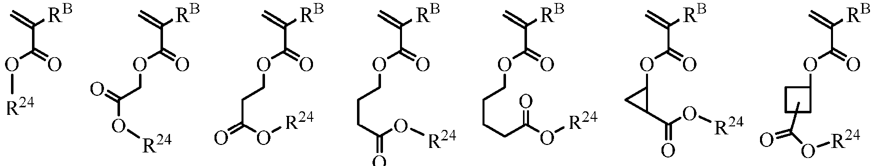

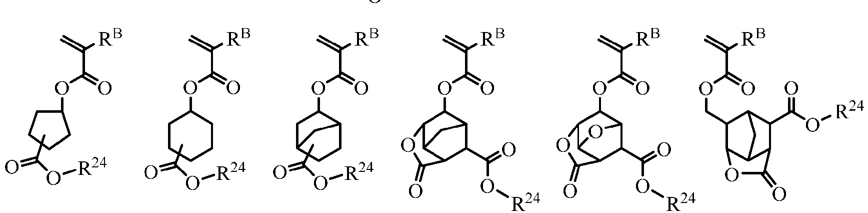

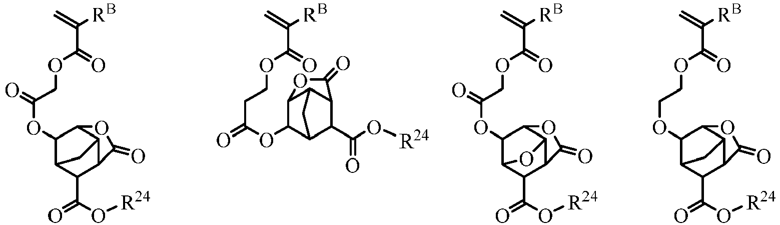

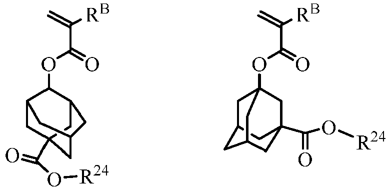

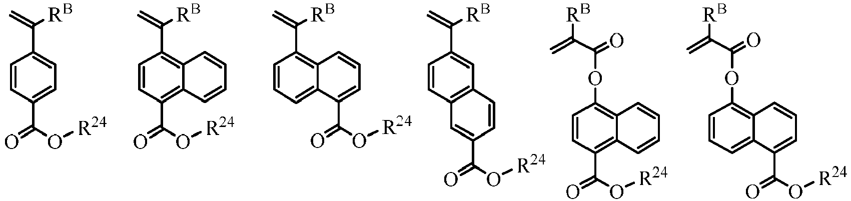

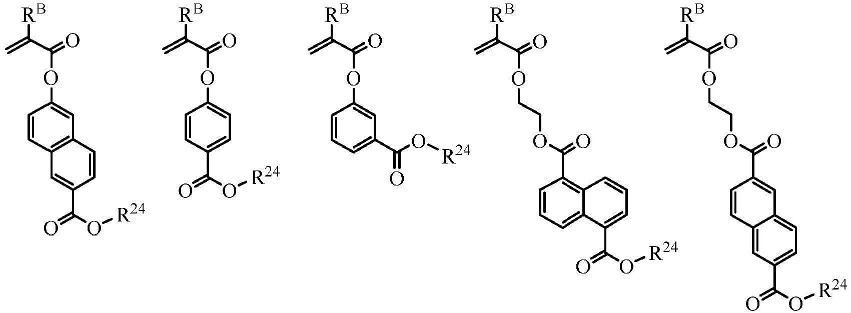

Examples of the acid labile groups R²³ and R²⁴ include those described in USP 9,164,392 (JP-A 2014-219657, paragraphs [0030]-[0082]).

Of the acid labile groups, groups having the following formulae (AL-1) to (AL-19) are preferred.

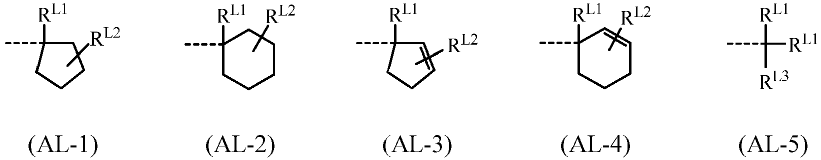

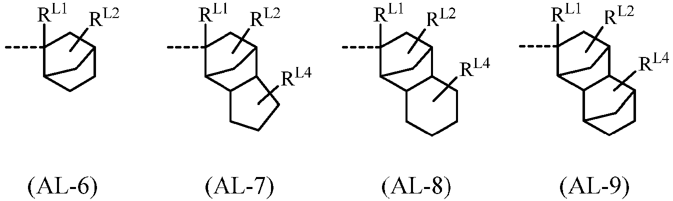

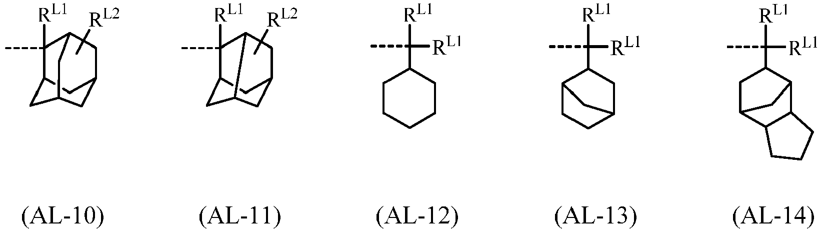

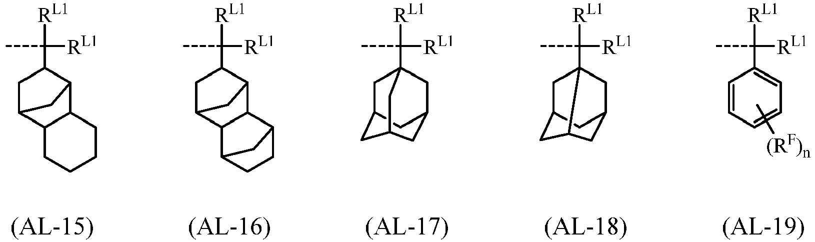

In formulae (AL-1) to (AL-19), R^{L1} is each independently a saturated hydrocarbyl group or C₆-C₂₀ aryl group. R^{L2} and R^{L4} are each independently hydrogen or a C₁-C₂₀ saturated hydrocarbyl group. R^{L3} is a C₆-C₂₀ aryl group. The saturated hydrocarbyl group may be straight, branched or cyclic. Typical of the aryl group is phenyl. R^{F} is fluorine or trifluoromethyl. The subscript n is an integer of 1 to 5.

It is preferred to select a tertiary hydrocarbyl group as the acid labile group because a pattern with reduced LER is obtained even when a resist film is formed to a thickness of 10 to 100 nm and exposed to a small size pattern of light so as to provide a line width of 45 nm or less. The tertiary hydrocarbyl group is preferably of 4 to 18 carbon atoms because a monomer for polymerization is collectable through distillation. The group attached to the tertiary carbon atom in the tertiary hydrocarbyl group is typically a C₁-C₂₀ saturated hydrocarbyl group which may contain an oxygen-containing functional group such as an ether bond or carbonyl group while the groups attached to the tertiary carbon atom may bond together to form a ring.

Examples of the group attached to the tertiary carbon atom include methyl, ethyl, propyl, adamantyl, norbornyl, tetrahydrofuran-2-yl, 7-oxanorbornan-2-yl, cyclopentyl, 2-tetrahydrofuryl, tricyclo[5.2.1.0^{2,6}]decyl, tetracyclo[4.4.0.1^{2,5}.1^{7,10}]dodecyl, and 3-oxo-1-cyclohexyl.

Examples of the tertiary hydrocarbyl group include tert-butyl, tert-pentyl, 1-ethyl-1-methylpropyl, 1,1-diethylpropyl, 1,1,2-trimethylpropyl, 1-adamantyl-1-methylethyl, 1-methyl-1-(2-norbornyl)ethyl, 1-methyl-1-(tetrahydrofuran-2-yl)ethyl, 1-methyl-1-(7-oxanorbornan-2-yl)ethyl, 1-methylcyclopentyl, 1-ethylcyclopentyl, 1-propylcyclopentyl, 1-isopropylcyclopentyl, 1-cyclopentylcyclopentyl, 1-cyclohexylcyclopentyl, 1-(2-tetrahydrofuryl)cyclopentyl, 1-(7-oxanorbornan-2-yl)cyclopentyl, 1-methylcyclohexyl, 1-ethylcyclohexyl, 1-isopropylcyclohexyl, 1-cyclopentylcyclohexyl, 1-cyclohexylcyclohexyl, 2-methyl-2-norbornyl, 2-ethyl-2-norbornyl, 8-methyl-8-tricyclo[5.2.1.0^{2,6}]decyl, 8-ethyl-8-tricyclo[5.2.1.0^{2,6}]decyl, 3-methyl-3-tetracyclo[4.4.0.1^{2,5}.1^{7,10}]dodecyl, 3-ethyl-3-tetracyclo[4.4.0.1^{2,5}.1^{7,10}]dodecyl, 3-isopropyl-3-tetracyclo[4.4.0.1^{2,5}.1^{7,10}]dodecyl, 2-methyl-2-adamantyl, 2-ethyl-2-adamantyl, 2-isopropyl-2-adamantyl, 1-methyl-3-oxo-1-cyclohexyl, 1-methyl-1-(tetrahydrofuran-2-yl)ethyl, 5-hydroxy-2-methyl-2-adamantyl, 5-hydroxy-2-ethyl-2-adamantyl, and 2-(4-fluorophenyl)-2-propyl.

Also, an acetal group having the formula (AL-20) is often used as the acid labile group. It is a good choice of acid labile group that ensures to form a pattern having a relatively rectangular interface between pattern features and the substrate.

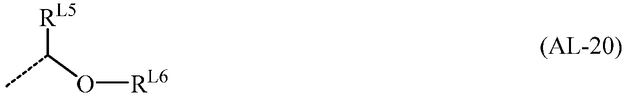

In formula (AL-20), R^{L5} is hydrogen or a C₁-C₁₀ saturated hydrocarbyl group. R^{L6} is a C₁-C₃₀ saturated hydrocarbyl group.

R^{L5} is selected in accordance with how to design the sensitivity of the labile group to acid. For example, hydrogen is selected for the design that the group having a relatively high stability is decomposed with a strong acid. A straight alkyl group is selected for the design that utilizes a relatively high reactivity to provide a high sensitivity relative to pH changes. Depending on a combination with an acid generator and a basic compound blended in a resist composition, a hydrocarbyl group in which the carbon attached to the acetal carbon is a secondary carbon atom is preferably selected as R^{L5} for the design that is substituted at an end with a relatively higher alkyl group as R^{L6} and experiences a large solubility change upon decomposition. Examples of the group R^{L5} attached to the acetal carbon via a secondary carbon atom include isopropyl, sec-butyl, cyclopentyl and cyclohexyl.

Of the acetal groups, those groups wherein R^{L6} is a C₇-C₃₀ polycyclic alkyl group are preferred in order to gain a higher resolution. When R^{L6} is a polycyclic alkyl group, it is preferred that the secondary carbon in the polycyclic structure form a bond with the acetal oxygen. A polymer relying on an attachment on the secondary carbon atom in the cyclic structure is stable as compared with an attachment on the tertiary carbon atom, ensuring that the resist composition is improved in shelf stability and not degraded in resolution. The polymer has a high glass transition temperature (Tg) as compared with the case wherein R^{L6} is attached on the primary carbon atom via a straight alkyl group of at least one carbon atom, so that the resist pattern after development may not undergo geometrical failure during bake.

Preferred examples of the group having formula (AL-20) are shown below, but not limited thereto. Herein R^{L5} is as defined above. 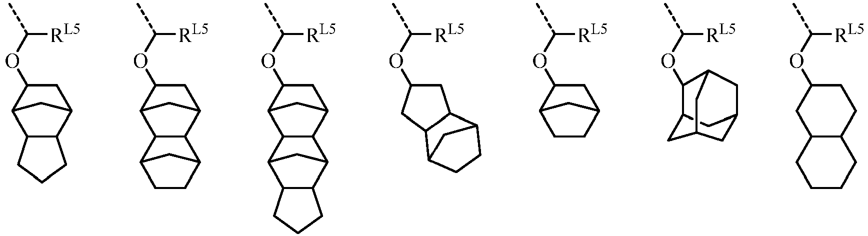 The polymer may be synthesized by combining suitable monomers optionally protected with a protective group, copolymerizing them in the standard way, and effecting deprotection reaction if necessary. The copolymerization reaction is preferably radical or anionic polymerization though not limited thereto. For the polymerization reaction, reference may be made to JP-A 2004-115630, for example.

The polymer should preferably have a Mw of 1,000 to 50,000, and more preferably 2,000 to 20,000. A Mw of at least 1,000 eliminates the risk that pattern features are rounded at their top, inviting degradations of resolution and LER. A Mw of up to 50,000 eliminates the risk that LER is degraded when a pattern with a line width of up to 100 nm is formed. As used herein, Mw is measured by GPC versus polystyrene standards using tetrahydrofuran (THF) or dimethylformamide (DMF) solvent.

The polymer preferably has a narrow molecular weight distribution or dispersity (Mw/Mn) of 1.0 to 2.0, more preferably 1.0 to 1.9, even more preferably 1.0 to 1.8. A polymer with such a narrow dispersity eliminates the risk that foreign particles are left on the pattern after development and the pattern profile is aggravated.

The base polymer is designed such that the dissolution rate in alkaline developer is preferably up to 8 nm/min, more preferably up to 6 nm/min, even more preferably up to 5 nm/min. In the advanced generation of lithography wherein the coating film on the substrate is in a thin film range of up to 100 nm, the influence of pattern film thickness loss during alkaline development becomes strong. When the polymer has an alkaline dissolution rate of greater than 8 nm/min, pattern collapse occurs, i.e., a small size pattern cannot be formed. The problem becomes outstanding in the fabrication of photomasks requiring to be defectless and having a tendency of strong development process. It is noted that the dissolution rate of a base polymer in alkaline developer is computed by spin coating a 16.7 wt% solution of a polymer in propylene glycol monomethyl ether (PGME) solvent onto a 8-inch silicon wafer, baking at 100°C for 90 seconds to form a film of 1,000 nm thick, developing the film in a 2.38 wt% aqueous solution of tetramethylammonium hydroxide (TMAH) at 23°C for 100 seconds, and measuring a loss of film thickness.

### Fluorinated polymer

The positive resist composition may further comprise a fluorinated polymer which contains repeat units of at least one type selected from repeat units having the formula (D3), repeat units having the formula (D4), repeat units having the formula (D5), and repeat units having the formula (D6), and which may contain repeat units of at least one type selected from repeat units having the formula (D1) and repeat units having the formula (D2), for the purposes of enhancing contrast, preventing chemical flare of acid upon exposure to high-energy radiation, preventing mixing of acid from an anti-charging film in the step of coating an anti-charging film-forming material on a resist film, and suppressing unexpected unnecessary pattern degradation. It is noted that repeat units having formulae (D1), (D2), (D3), (D4), (D5), and (D6) are also referred to as repeat units D1, D2, D3, D4, D5, and D6, respectively, hereinafter. Since the fluorinated polymer also has a surface active function, it can prevent insoluble residues from re-depositing onto the substrate during the development step and is thus effective for preventing development defects.

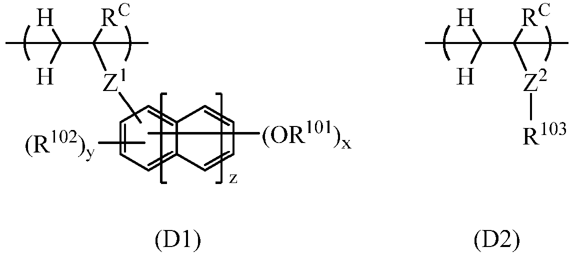

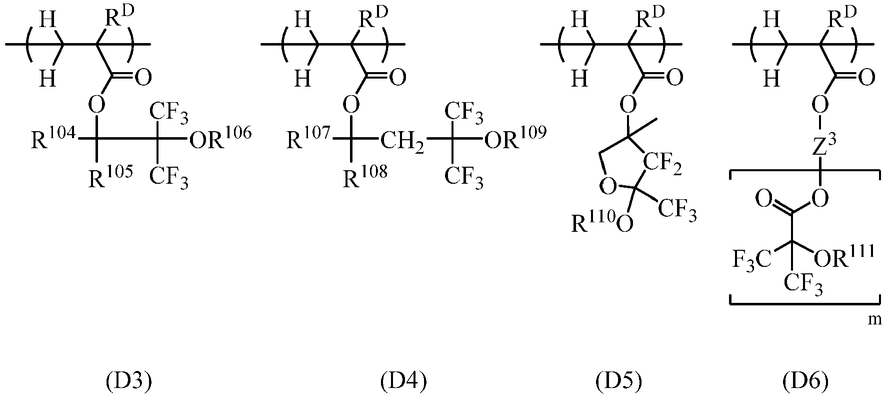

In formulae (D1) to (D6), R^{C} is each independently hydrogen or methyl. R^{D} is each independently hydrogen, fluorine, methyl or trifluoromethyl. R¹⁰¹ is hydrogen or a C₁-C₅ straight or branched hydrocarbyl group in which a heteroatom-containing moiety may intervene in a carbon-carbon bond. R¹⁰² is a C₁-C₅ straight or branched hydrocarbyl group in which a heteroatom-containing moiety may intervene in a carbon-carbon bond. R¹⁰³ is a C₁-C₂₀ saturated hydrocarbyl group in which at least one hydrogen is substituted by fluorine and some constituent -CH₂- may be replaced by an ester bond or ether bond. R¹⁰⁴, R¹⁰⁵, R¹⁰⁷ and R¹⁰⁸ are each independently hydrogen or a C₁-C₁₀ saturated hydrocarbyl group. R¹⁰⁶, R¹⁰⁹, R¹¹⁰ and R¹¹¹ are each independently hydrogen, a C₁-C₁₅ hydrocarbyl group or fluorinated hydrocarbyl group, or an acid labile group, with the proviso that an ether bond or carbonyl moiety may intervene in a carbon-carbon bond in the hydrocarbyl groups or fluorinated hydrocarbyl groups represented by R¹⁰⁶, R¹⁰⁹, R¹¹⁰ and R¹¹¹. The subscript x is an integer of 1 to 3, y is an integer satisfying: 0 ≤ y ≤ 5+2z-x, z is 0 or 1, and m is an integer of 1 to 3. Z¹ is a single bond, *-C(=O)-O- or *-C(=O)-NH- wherein the asterisk (*) designates a point of attachment to the carbon atom in the backbone. Z² is a single bond, -O-, *-C(=O)-O-Z²¹-Z²²- or *-C(=O)-NH-Z²¹-Z²²-, wherein Z²¹ is a single bond or a C₁-C₁₀ saturated hydrocarbylene group, Z²² is a single bond, ester bond, ether bond or sulfonamide bond, and the asterisk (*) designates a point of attachment to the carbon atom in the backbone. Z³ is a C₁-C₂₀ (m+1)-valent hydrocarbon group or C₁-C₂₀ (m+1)-valent fluorinated hydrocarbon group.

Examples of the C₁-C₅ hydrocarbyl groups R¹⁰¹ and R¹⁰² include alkyl, alkenyl and alkynyl groups, with the alkyl groups being preferred. Suitable alkyl groups include methyl, ethyl, n-propyl, isopropyl, n-butyl, isobutyl, sec-butyl, and n-pentyl. In these groups, a moiety containing a heteroatom such as oxygen, sulfur or nitrogen may intervene in a carbon-carbon bond.

In formula (D1), -OR¹⁰¹ is preferably a hydrophilic group. In this case, R¹⁰¹ is preferably hydrogen or a C₁-C₅ alkyl group in which oxygen intervenes in a carbon-carbon bond.

Examples of the repeat unit D1 are given below, but not limited thereto. Herein R^{C} is as defined above.

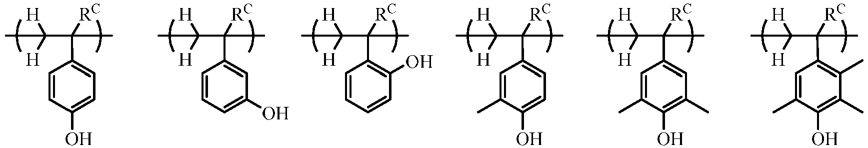

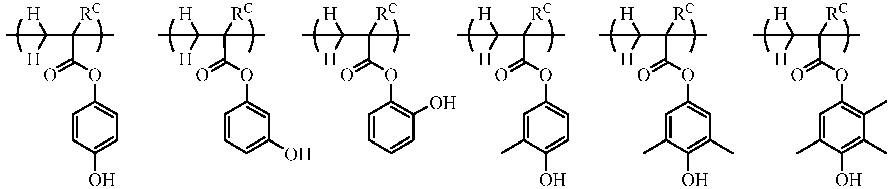

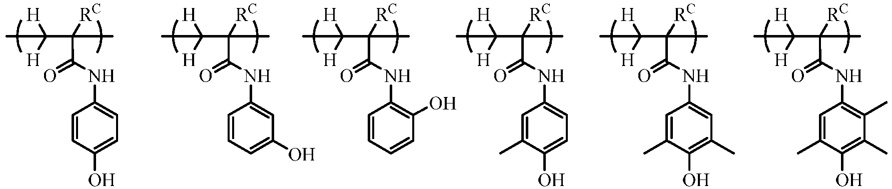

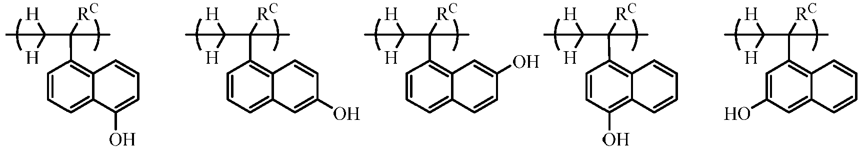

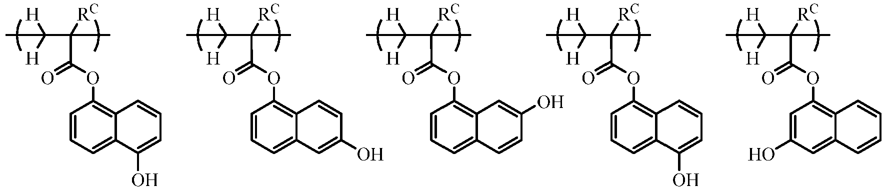

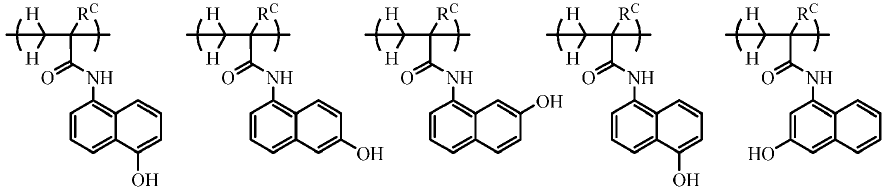

Z¹ is preferably *-C(=O)-O- or *-C(=O)-NH-. Also preferably R^{C} is methyl. The inclusion of carbonyl in Z¹ enhances the ability to trap the acid originating from the anti-charging film. A polymer wherein R^{C} is methyl is a robust polymer having a high Tg which is effective for suppressing acid diffusion. As a result, the resist film is improved in stability with time, and neither resolution nor pattern profile is degraded.

The C₁-C₁₀ saturated hydrocarbylene group Z²¹ may be straight, branched or cyclic and examples thereof include methanediyl, ethane-1,1-diyl, ethane-1,2-diyl, propane-1,1-diyl, propane-1,2-diyl, propane-1,3-diyl, propane-2,2-diyl, butane-1,1-diyl, butane-1,2-diyl, butane-1,3-diyl, butane-2,3-diyl, butane-1,4-diyl, and 1,1-dimethylethane-1,2-diyl.

The C₁-C₂₀ saturated hydrocarbyl group having at least one hydrogen substituted by fluorine, represented by R¹⁰³, may be straight, branched or cyclic and examples thereof include the alkyl and cyclic saturated hydrocarbyl groups exemplified above for the hydrocarbyl groups R¹ to R¹⁸ in formulae (A1) to (A8), with at least one hydrogen being substituted by fluorine.

Examples of the repeat unit D2 are given below, but not limited thereto. Herein R^{C} is as defined above.

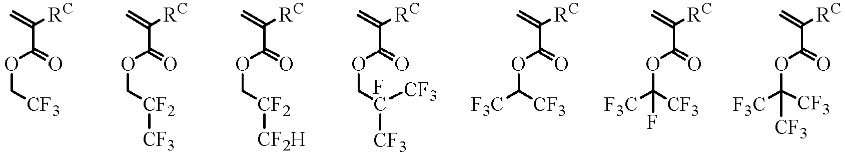

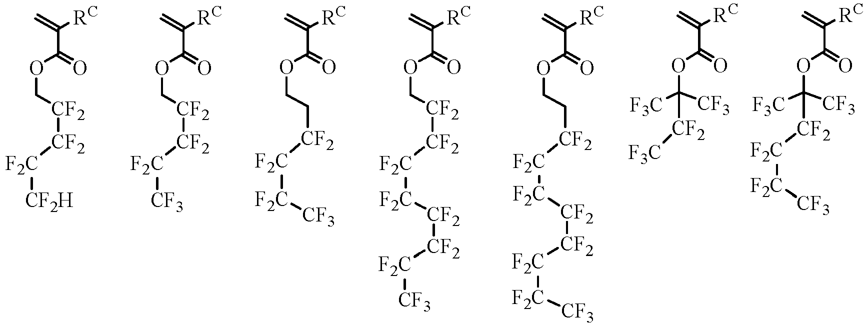

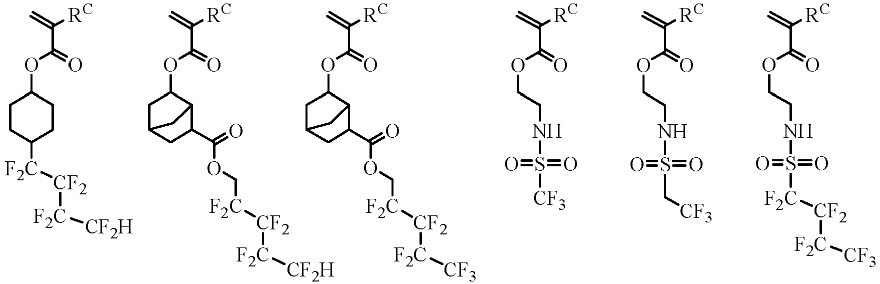

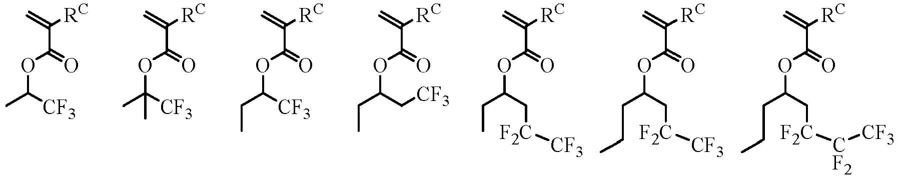

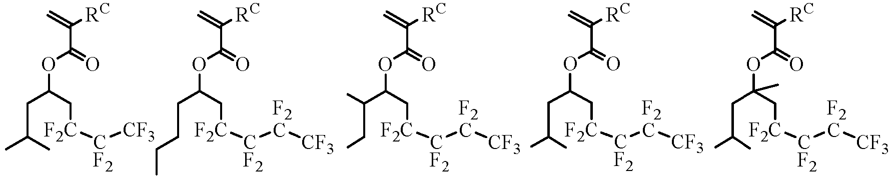

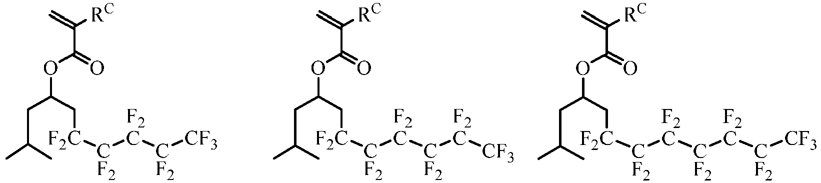

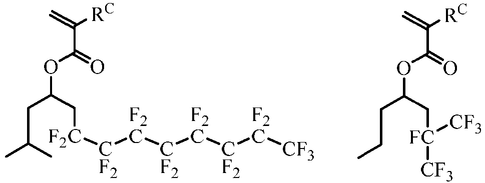

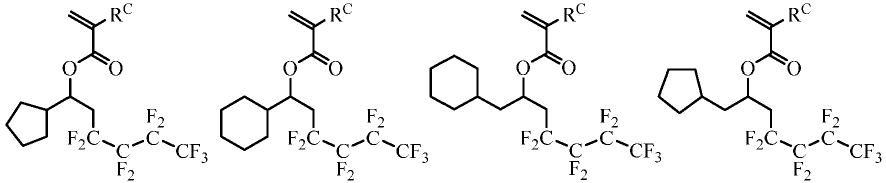

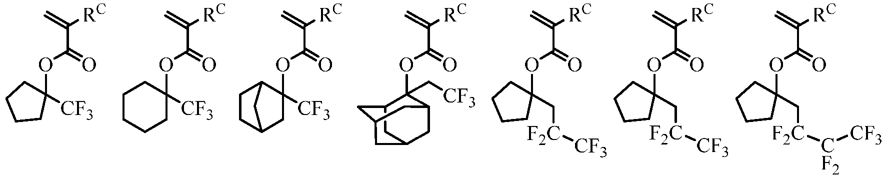

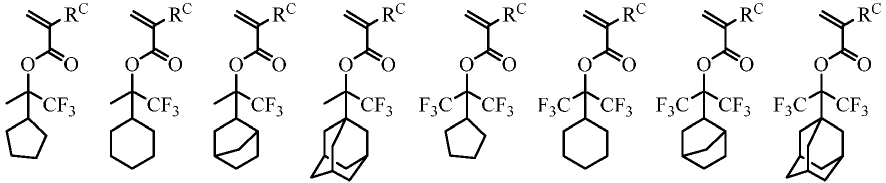

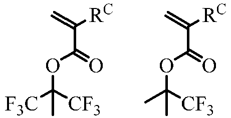

Examples of the C₁-C₁₀ saturated hydrocarbyl group represented by R¹⁰⁴, R¹⁰⁵, R¹⁰⁷ and R¹⁰⁸ include alkyl groups such as methyl, ethyl, n-propyl, isopropyl, n-butyl, isobutyl, sec-butyl, tert-butyl, n-pentyl, n-hexyl, n-heptyl, n-octyl, n-nonyl, and n-decyl, and cyclic saturated hydrocarbyl groups such as cyclopropyl, cyclobutyl, cyclopentyl, cyclohexyl, adamantyl, and norbornyl. Inter alia, C₁-C₆ saturated hydrocarbyl groups are preferred.

Examples of the C₁-C₁₅ hydrocarbyl group represented by R¹⁰⁶, R¹⁰⁹, R¹¹⁰ and R¹¹¹ include alkyl, alkenyl and alkynyl groups, with the alkyl groups being preferred. Suitable alkyl groups include n-undecyl, n-dodecyl, tridecyl, tetradecyl and pentadecyl as well as those exemplified above. The fluorinated hydrocarbyl groups correspond to the foregoing hydrocarbyl groups in which some or all carbon-bonded hydrogen atoms are substituted by fluorine atoms.

Examples of the C₁-C₂₀ (m+1)-valent hydrocarbon group or fluorinated hydrocarbon group Z³ include the foregoing hydrocarbyl groups and fluorinated hydrocarbyl groups, with m number of hydrogen atoms being eliminated.

Examples of the repeat units D3 to D6 are given below, but not limited thereto. Herein R^{D} is as defined above.

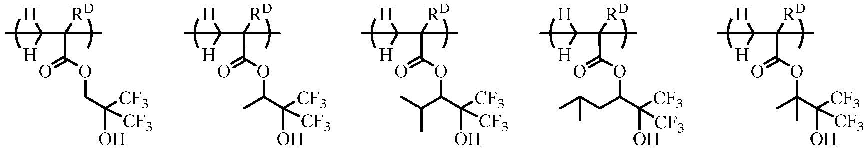

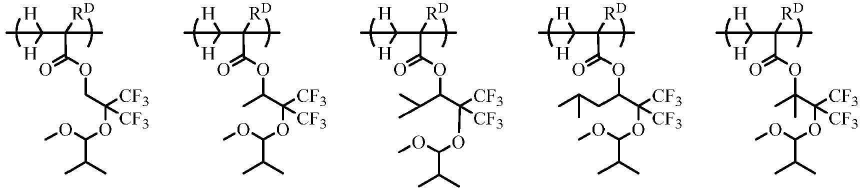

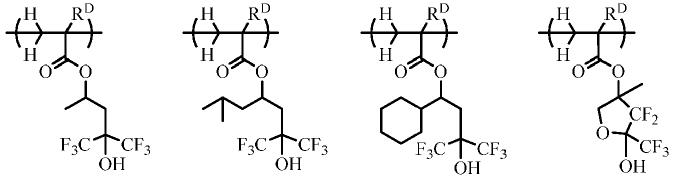

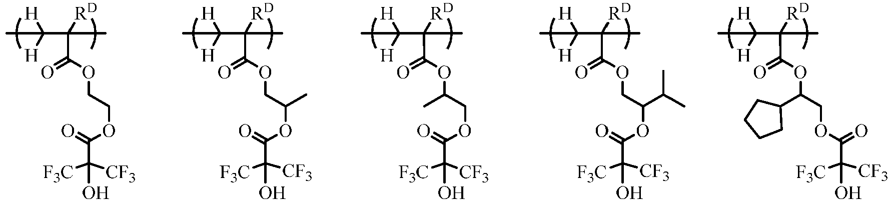

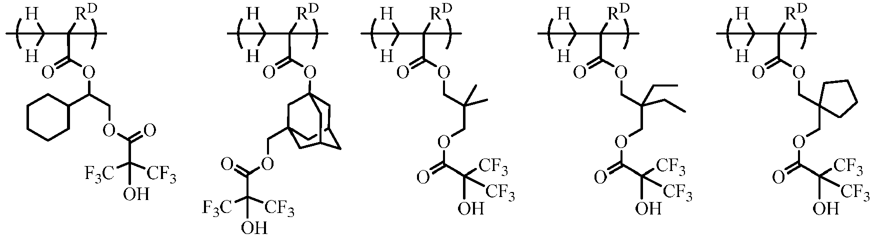

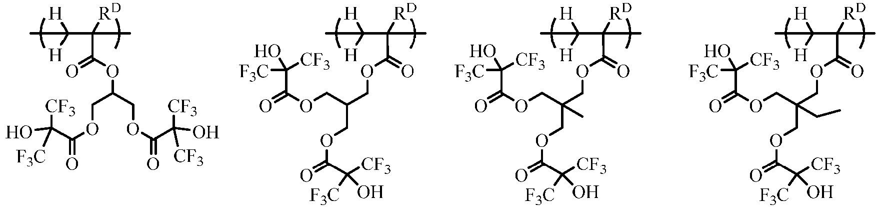

The repeat unit D1 and/or D2 is preferably incorporated in an amount of 5 to 85 mol%, more preferably 15 to 80 mol% based on the overall repeat units of the fluorinated polymer. The repeat units D3 to D6 are preferably incorporated in an amount of 15 to 95 mol%, more preferably 20 to 85 mol% based on the overall repeat units of the fluorinated polymer. Each of repeat units D1 to D6 may be used alone or in admixture.

The fluorinated polymer may comprise additional repeat units as well as the repeat units D1 to D6. Suitable additional repeat units include those described in USP 9,091,918 (JP-A 2014-177407, paragraphs [0046]-[0078]). When the fluorinated polymer comprises additional repeat units, their content is preferably up to 50 mol% based on the overall repeat units.

The fluorinated polymer may be synthesized by combining suitable monomers optionally protected with a protective group, copolymerizing them in the standard way, and effecting deprotection reaction if necessary. The copolymerization reaction is preferably radical or anionic polymerization though not limited thereto. For the polymerization reaction, reference may be made to JP-A 2004-115630.

The fluorinated polymer should preferably have a Mw of 2,000 to 50,000, and more preferably 3,000 to 20,000. A fluorinated polymer with a Mw of less than 2,000 helps acid diffusion, degrading resolution and detracting from age stability. A polymer with too high Mw has a reduced solubility in solvent, with a risk of leaving coating defects. The fluorinated polymer preferably has a dispersity (Mw/Mn) of 1.0 to 2.2, more preferably 1.0 to 1.7.

In the positive resist composition, the fluorinated polymer is preferably used in an amount of 0.01 to 30 parts, more preferably 0.1 to 20 parts, even more preferably 0.5 to 10 parts by weight per 80 parts by weight of the base polymer.

### Organic solvent

The chemically amplified positive resist composition may further comprise an organic solvent. The organic solvent used herein is not particularly limited as long as the components are soluble therein. Examples of the organic solvent are described in JP-A 2008-111103, paragraphs [0144] to [0145] (USP 7,537,880). Specifically, exemplary solvents include ketones such as cyclohexanone and methyl-2-n-pentyl ketone; alcohols such as 3-methoxybutanol, 3-methyl-3-methoxybutanol, 1-methoxy-2-propanol, 1-ethoxy-2-propanol, and diacetone alcohol; ethers such as propylene glycol monomethyl ether (PGME), ethylene glycol monomethyl ether, propylene glycol monoethyl ether, ethylene glycol monoethyl ether, propylene glycol dimethyl ether, and diethylene glycol dimethyl ether; esters such as propylene glycol monomethyl ether acetate (PGMEA), propylene glycol monoethyl ether acetate, ethyl lactate (EL), ethyl pyruvate, butyl acetate, methyl 3-methoxypropionate, ethyl 3-ethoxypropionate, t-butyl acetate, t-butyl propionate, and propylene glycol mono-t-butyl ether acetate; and lactones such as γ-butyrolactone (GBL), and mixtures thereof. Where an acid labile group of acetal form is used, a high boiling alcohol solvent such as diethylene glycol, propylene glycol, glycerol, 1,4-butanediol or 1,3-butanediol may be added to accelerate deprotection reaction of acetal.

Of the above organic solvents, it is recommended to use 1-ethoxy-2-propanol, PGMEA, PGME, cyclohexanone, EL, GBL, and mixtures thereof.

In the positive resist composition, the organic solvent is preferably used in an amount of 200 to 10,000 parts, more preferably 400 to 5,000 parts by weight per 80 parts by weight of the base polymer. The organic solvent may be used alone or in admixture.

### Photoacid generator

The positive resist composition may further comprise a photoacid generator (PAG), also referred to as acid generator of addition type. The PAG used herein may be any compound capable of generating an acid upon exposure to high-energy radiation.
Suitable PAGs include sulfonium salts, iodonium salts, sulfonyldiazomethane, N-sulfonyloxyimide, and oxime-O-sulfonate acid generators.

Suitable PAGs include nonafluorobutane sulfonate, partially fluorinated sulfonates described in JP-A 2012-189977, paragraphs [0247]-[0251], partially fluorinated sulfonates described in JP-A 2013-101271, paragraphs [0261]-[0265], and those described in JP-A 2008-111103, paragraphs [0122]-[0142] and JP-A 2010-215608, paragraphs [0080]-[0081]. Among others, arylsulfonate and alkanesulfonate type PAGs are preferred because they generate acids having an appropriate strength to deprotect the acid labile group in the repeat units having formula (B2) or (B3).

The preferred PAGs are compounds having a sulfonium anion of the structure shown below. Notably the cation that pairs with the anion is as exemplified for the sulfonium cation in formulae (A2) to (A4).

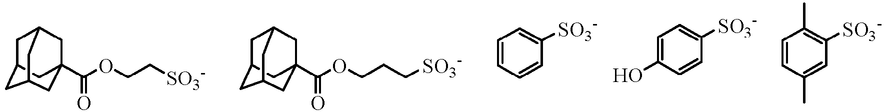

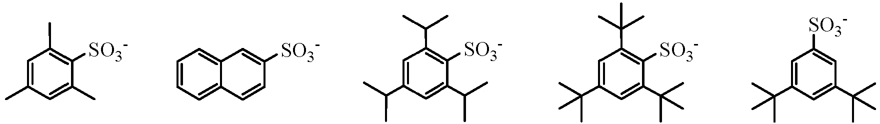

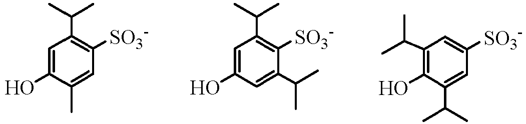

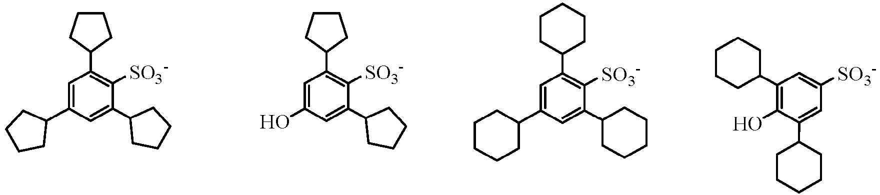

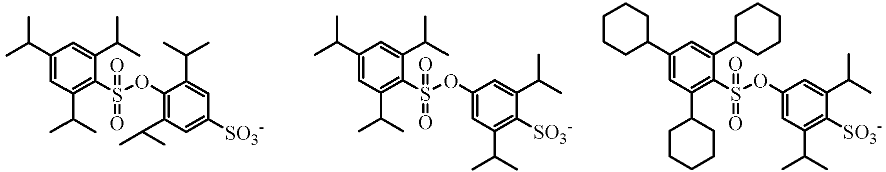

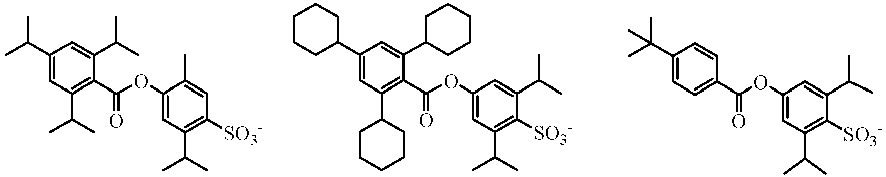

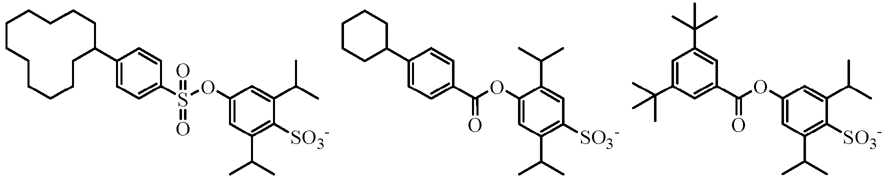

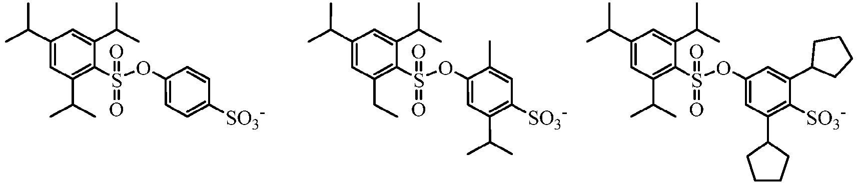

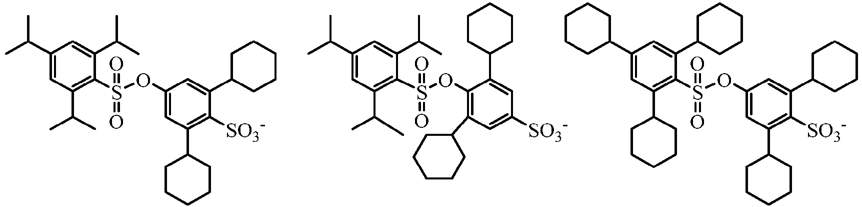

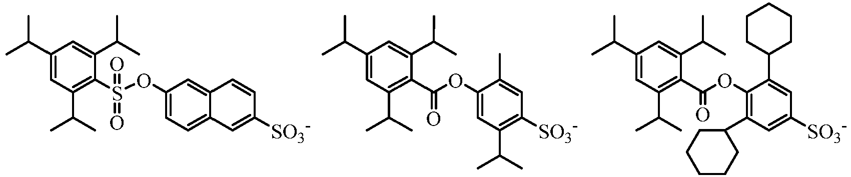

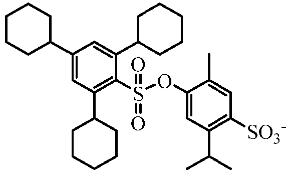

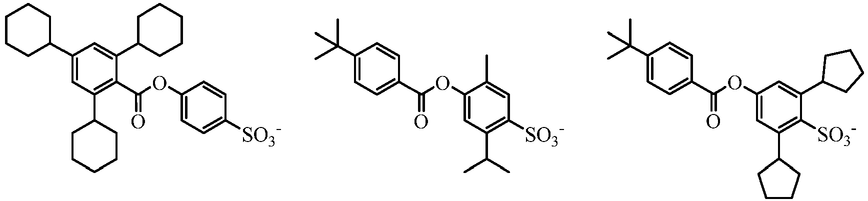

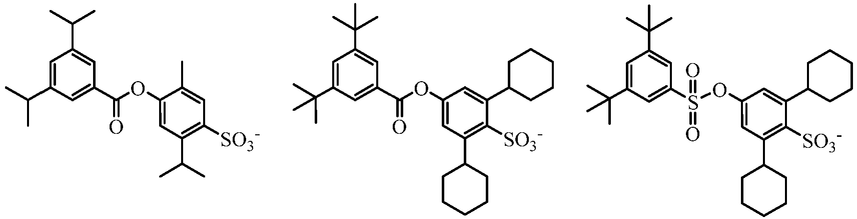

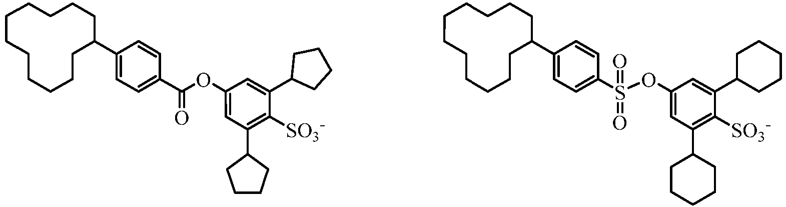

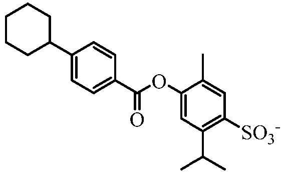

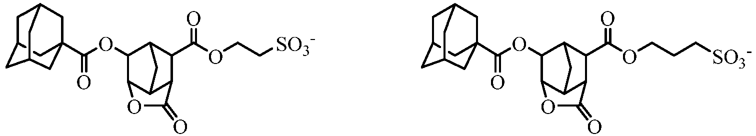

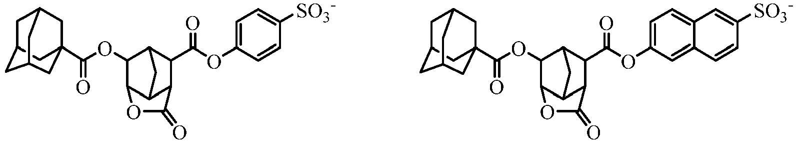

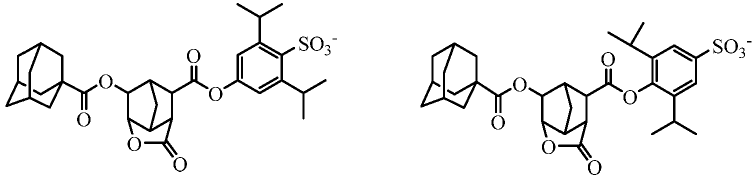

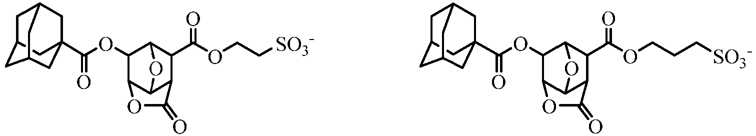

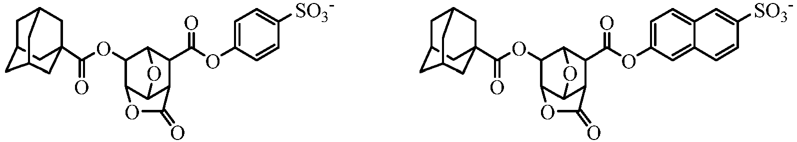

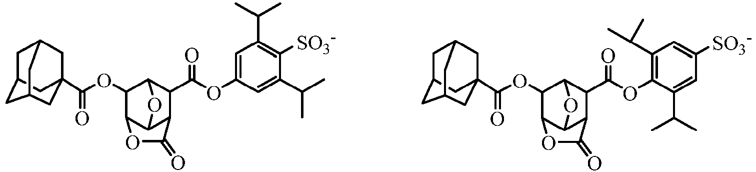

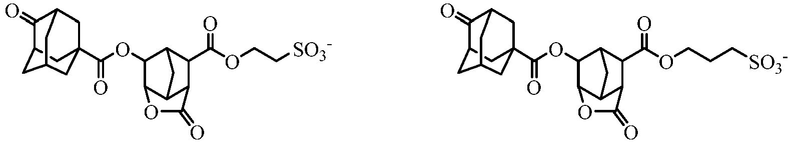

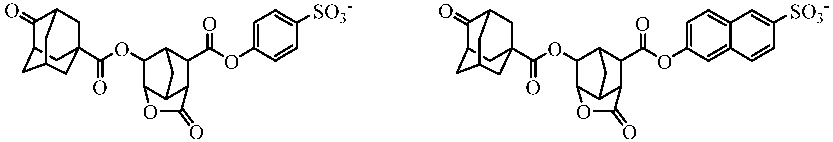

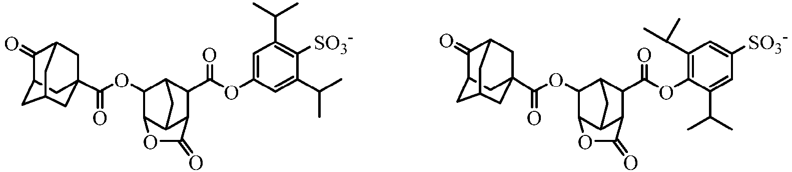

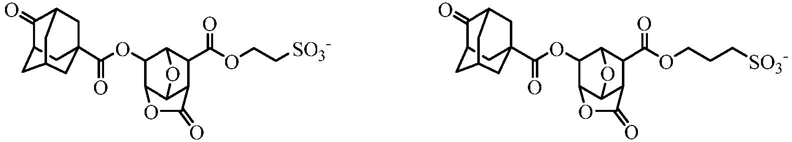

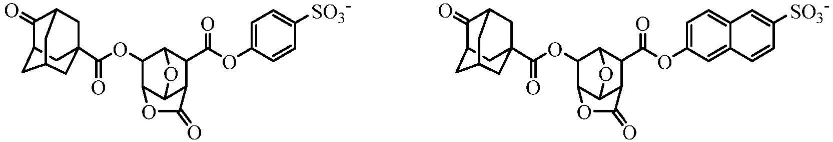

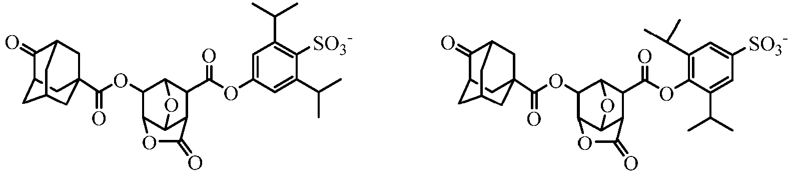

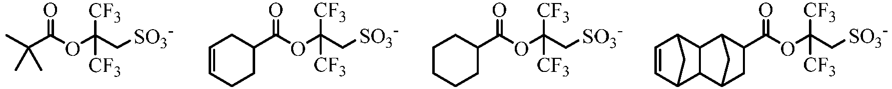

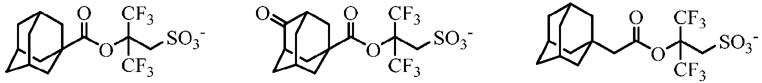

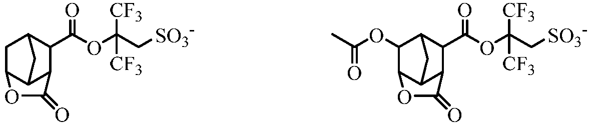

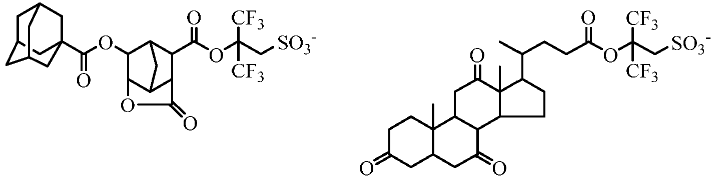

Preferably, the photoacid generator generates an acid having a pKa value of equal to or more than -2.0. The upper limit of pKa is preferably 2.0. Notably, the pKa value is computed using pKa DB in software ACD/Chemsketch ver: 9.04 of Advanced Chemistry Development Inc.

An appropriate amount of the photoacid generator of addition type used is 1 to 30 parts, more preferably 2 to 20 parts by weight per 80 parts by weight of the base polymer. The photoacid generator may be used alone or in admixture.

### Quencher

The positive resist composition preferably contains a quencher. The quencher is typically selected from conventional basic compounds. Conventional basic compounds include primary, secondary, and tertiary aliphatic amines, mixed amines, aromatic amines, heterocyclic amines, nitrogen-containing compounds with carboxy group, nitrogen-containing compounds with sulfonyl group, nitrogen-containing compounds with hydroxy group, nitrogen-containing compounds with hydroxyphenyl group, alcoholic nitrogen-containing compounds, amide derivatives, imide derivatives, and carbamate derivatives. Also included are primary, secondary, and tertiary amine compounds, specifically amine compounds having a hydroxy group, ether bond, ester bond, lactone ring, cyano group, or sulfonic ester bond as described in JP-A 2008-111103, paragraphs [0146]-[0164], and compounds having a carbamate group as described in JP 3790649. Inter alia, tris[2-(methoxymethoxy)ethyl]amine, tris[2-(methoxymethoxy)ethyl]amine-N-oxide, dibutylaminobenzoic acid, morpholine derivatives, and imidazole derivatives are preferred. Addition of a basic compound is effective for further suppressing the diffusion rate of acid in the resist film or correcting the pattern profile.

Onium salts such as sulfonium salts, iodonium salts and ammonium salts of carboxylic acids which are not fluorinated at α-position as described in USP 8,795,942 (JP-A 2008-158339) may also be used as the quencher. While an α-fluorinated sulfonic acid, imide acid, and methide acid are necessary to deprotect the acid labile group, an α-non-fluorinated carboxylic acid is released by salt exchange with an α-non-fluorinated onium salt. An α-non-fluorinated carboxylic acid functions as a quencher because it does not induce substantial deprotection reaction.

Examples of the onium salt of α-non-fluorinated carboxylic acid include compounds having the formula (F1).

R²⁰¹-CO₂- Mq⁺ (F1)

In formula (F1), R²⁰¹ is hydrogen or a C₁-C₄₀ hydrocarbyl group which may contain a heteroatom, exclusive of the hydrocarbyl group in which the hydrogen bonded to the carbon atom at α-position of the carboxy group is substituted by fluorine or fluoroalkyl.

The hydrocarbyl group may be saturated or unsaturated and straight, branched or cyclic. Examples thereof include C₁-C₄₀ alkyl groups such as methyl, ethyl, propyl, isopropyl, n-butyl, sec-butyl, tert-butyl, n-pentyl, tert-pentyl, n-hexyl, n-octyl, 2-ethylhexyl, n-nonyl, n-decyl; C₃-C₄₀ cyclic saturated hydrocarbyl groups such as cyclopentyl, cyclohexyl, cyclopentylmethyl, cyclopentylethyl, cyclopentylbutyl, cyclohexylmethyl, cyclohexylethyl, cyclohexylbutyl, norbornyl, tricyclo[5.2.1.0^{2,6}]decanyl, adamantyl, and adamantylmethyl; C₂-C₄₀ alkenyl groups such as vinyl, allyl, propenyl, butenyl and hexenyl; C₃-C₄₀ cyclic unsaturated aliphatic hydrocarbyl groups such as cyclohexenyl; C₆-C₄₀ aryl groups such as phenyl, naphthyl, alkylphenyl groups (e.g., 2-methylphenyl, 3-methylphenyl, 4-methylphenyl, 4-ethylphenyl, 4-tert-butylphenyl, 4-n-butylphenyl), dialkylphenyl groups (e.g., 2,4-dimethylphenyl and 2,4,6-triisopropylphenyl), alkylnaphthyl groups (e.g., methylnaphthyl and ethylnaphthyl), dialkylnaphthyl groups (e.g., dimethylnaphthyl and diethylnaphthyl); and C₇-C₄₀ aralkyl groups such as benzyl, 1-phenylethyl and 2-phenylethyl.

In these groups, some hydrogen may be substituted by a moiety containing a heteroatom such as oxygen, sulfur, nitrogen or halogen, and some carbon may be replaced by a moiety containing a heteroatom such as oxygen, sulfur or nitrogen, so that the group may contain a hydroxy moiety, cyano moiety, carbonyl moiety, ether bond, thioether bond, ester bond, sulfonic ester bond, carbonate bond, lactone ring, sultone ring, carboxylic anhydride, or haloalkyl moiety. Suitable heteroatom-containing hydrocarbyl groups include heteroaryl groups such as thienyl; alkoxyphenyl groups such as 4-hydroxyphenyl, 4-methoxyphenyl, 3-methoxyphenyl, 2-methoxyphenyl, 4-ethoxyphenyl, 4-tert-butoxyphenyl, 3-tert-butoxyphenyl; alkoxynaphthyl groups such as methoxynaphthyl, ethoxynaphthyl, n-propoxynaphthyl and n-butoxynaphthyl; dialkoxynaphthyl groups such as dimethoxynaphthyl and diethoxynaphthyl; and aryloxoalkyl groups, typically 2-aryl-2-oxoethyl groups such as 2-phenyl-2-oxoethyl, 2-(1-naphthyl)-2-oxoethyl and 2-(2-naphthyl)-2-oxoethyl.

In formula (F1), Mq⁺ is an onium cation. The onium cation is preferably selected from sulfonium, iodonium and ammonium cations, more preferably sulfonium and iodonium cations. Exemplary sulfonium cations are as exemplified above for the sulfonium cation in formulae (A2) to (A4). Exemplary iodonium cations are as exemplified above for the iodonium cation in formulae (A5) to (A8).

Examples of the anion of the salt having formula (F1) are shown below, but not limited thereto.

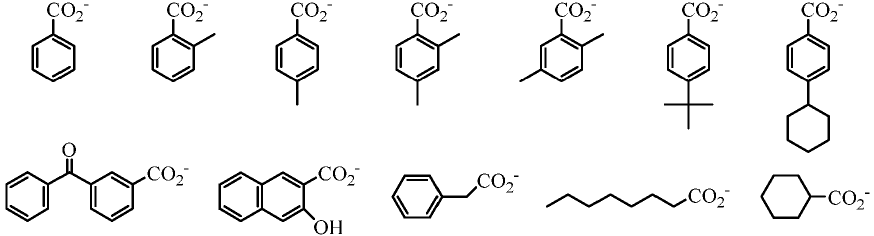

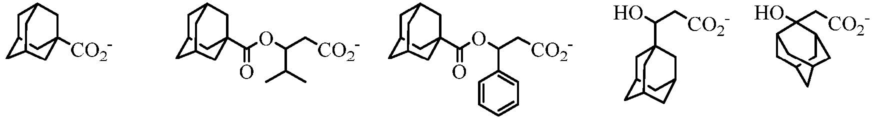

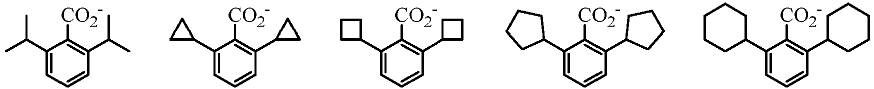

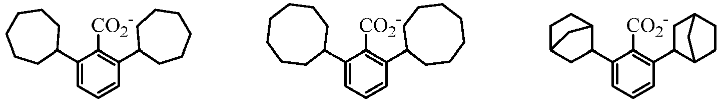

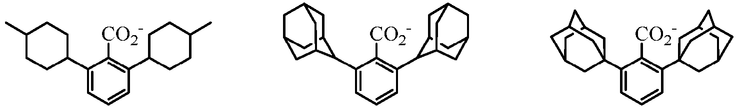

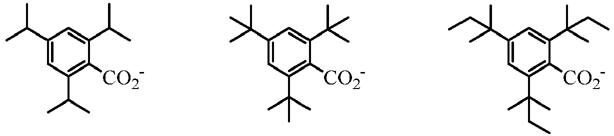

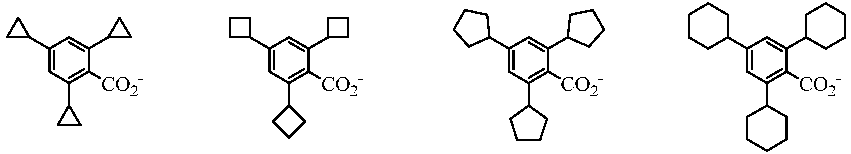

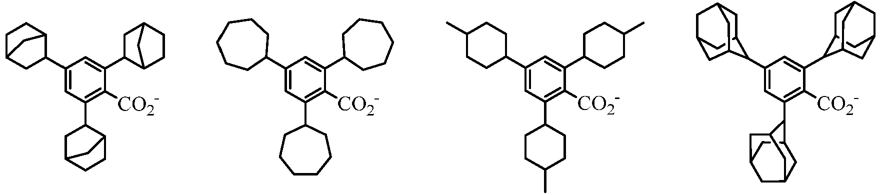

A sulfonium salt of iodized benzene ring-containing carboxylic acid having the formula (F2) is also useful as the quencher.

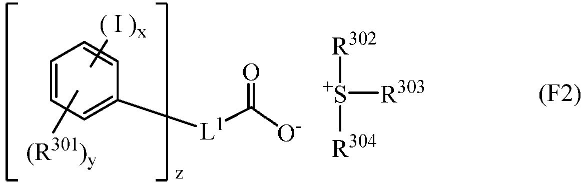

**In** formula (F2), R³⁰¹ is hydroxy, fluorine, chlorine, bromine, amino, nitro, cyano, or a C₁-C₆ saturated hydrocarbyl, C₁-C₆ saturated hydrocarbyloxy, C₂-C₆ saturated hydrocarbylcarbonyloxy or C₁-C₄ saturated hydrocarbylsulfonyloxy group, in which some or all hydrogen may be substituted by halogen, or -N(R^{301A})-C(=O)-R^{301B}, or -N(R^{301A})-C(=O)-O-R^{301B}. R^{301A} is hydrogen or a C₁-C₆ saturated hydrocarbyl group. R^{301B} is a C₁-C₆ saturated hydrocarbyl or C₂-C₈ unsaturated aliphatic hydrocarbyl group.

**In** formula (F2), x is an integer of 1 to 5, y is an integer of 0 to 3, and z is an integer of 1 to 3. L¹ is a single bond, or a C₁-C₂₀ (z+1)-valent linking group which may contain at least one moiety selected from ether bond, carbonyl moiety, ester bond, amide bond, sultone ring, lactam ring, carbonate moiety, halogen, hydroxy moiety, and carboxy moiety. The saturated hydrocarbyl, saturated hydrocarbyloxy, saturated hydrocarbylcarbonyloxy, and saturated hydrocarbylsulfonyloxy groups may be straight, branched or cyclic. Groups R³⁰¹ may be the same or different when y and/or z is 2 or 3.

In formula (F2), R³⁰², R³⁰³ and R³⁰⁴ are each independently halogen, or a C₁-C₂₀ hydrocarbyl group which may contain a heteroatom. The hydrocarbyl group may be saturated or unsaturated and straight, branched or cyclic. Examples thereof include C₁-C₂₀ alkyl, C₂-C₂₀ alkenyl, C₆-C₂₀ aryl, and C₇-C₂₀ aralkyl groups. In these groups, some or all hydrogen may be substituted by hydroxy, carboxy, halogen, oxo, cyano, nitro, sultone, sulfone, or sulfonium salt-containing moiety, or some carbon may be replaced by an ether bond, ester bond, carbonyl moiety, amide bond, carbonate moiety or sulfonic ester bond. Also R³⁰² and R³⁰³ may bond together to form a ring with the sulfur atom to which they are attached.

Examples of the compound having formula (F2) include those described in USP 10,295,904 (JP-A 2017-219836). These compounds exert a sensitizing effect due to remarkable absorption and an acid diffusion controlling effect.

A nitrogen-containing carboxylic acid salt compound having the formula (F3) is also useful as the quencher.

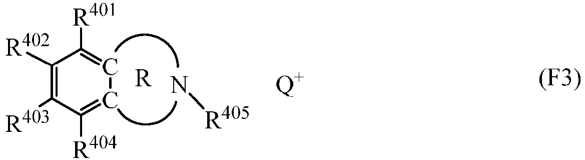

In formula (F3), R⁴⁰¹ to R⁴⁰⁴ are each independently hydrogen, -L²-CO₂⁻, or a C₁-C₂₀ hydrocarbyl group which may contain a heteroatom. R⁴⁰¹ and R⁴⁰², R⁴⁰² and R⁴⁰³, or R⁴⁰³ and R⁴⁰⁴ may bond together to form a ring with the carbon atom to which they are attached. L² is a single bond or a C₁-C₂₀ hydrocarbylene group which may contain a heteroatom. R⁴⁰⁵ is hydrogen or a C₁-C₂₀ hydrocarbyl group which may contain a heteroatom.

In formula (F3), the ring R is a C₂-C₆ ring containing the carbon and nitrogen atoms in the formula, in which some or all of the carbon-bonded hydrogen atoms may be substituted by a C₁-C₂₀ hydrocarbyl group or -L²-CO₂⁻ and in which some carbon may be replaced by sulfur, oxygen or nitrogen. The ring may be alicyclic or aromatic and is preferably a 5- or 6-membered ring. Suitable rings include pyridine, pyrrole, pyrrolidine, piperidine, pyrazole, imidazoline, pyridazine, pyrimidine, pyrazine, imidazoline, oxazole, thiazole, morpholine, thiazine, and triazole rings.

The carboxylic onium salt having formula (F3) has at least one -L²-CO₂⁻. That is, at least one of R⁴⁰¹ to R⁴⁰⁴ is -L²-CO₂⁻, and/or at least one of hydrogen atoms bonded to carbon atoms in the ring R is substituted by -L²-CO₂⁻.

In formula (F3), Q⁺ is a sulfonium, iodonium or ammonium cation, with the sulfonium cation being preferred. Examples of the sulfonium cation are as exemplified above for the cation in formulae (A2) to (A4).

Examples of the anion in the compound having formula (F3) are shown below, but not limited thereto.

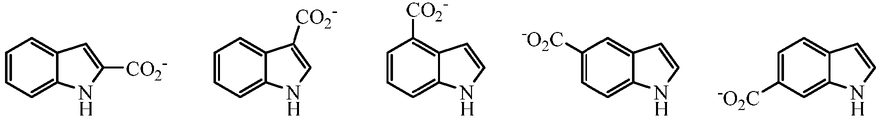

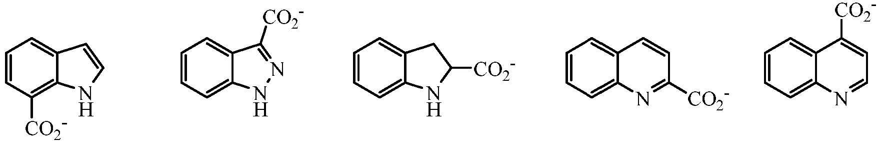

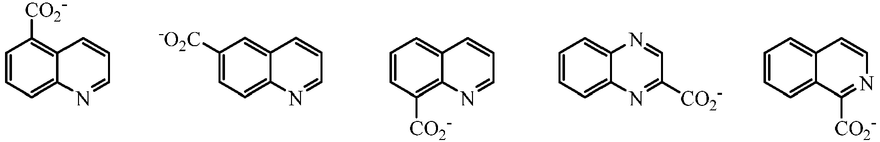

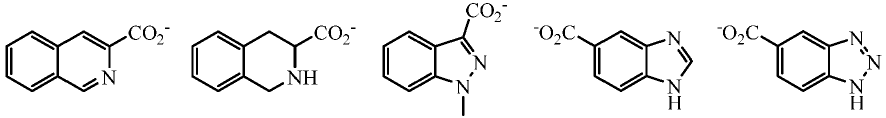

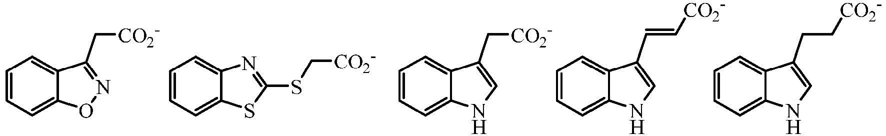

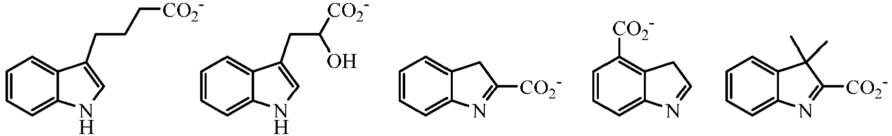

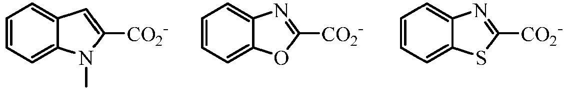

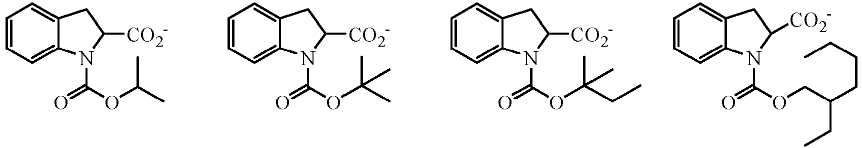

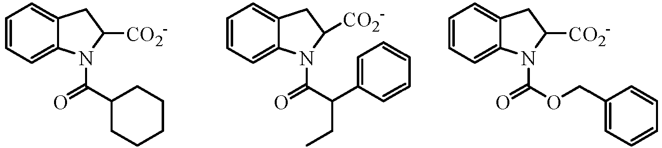

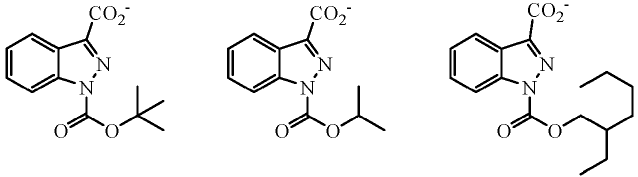

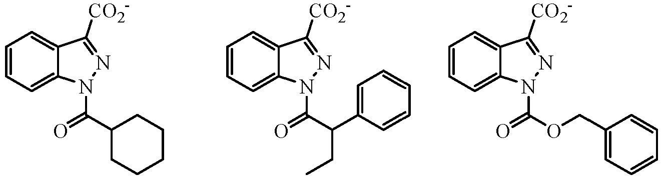

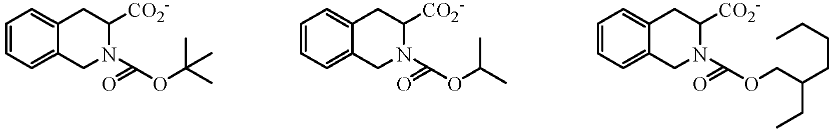

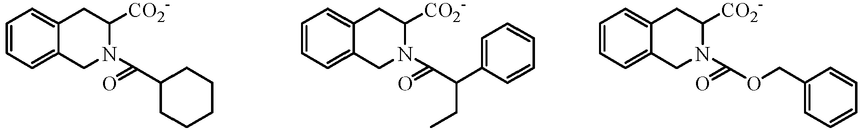

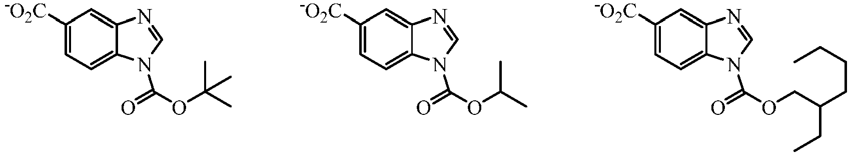

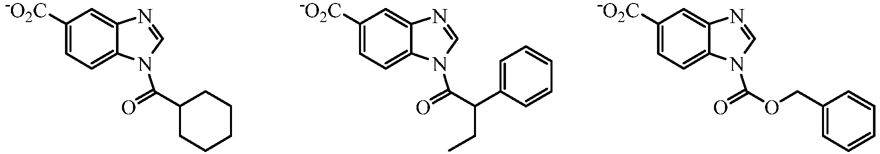

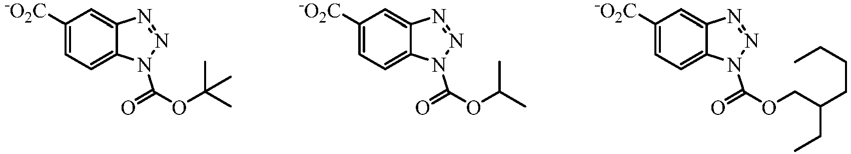

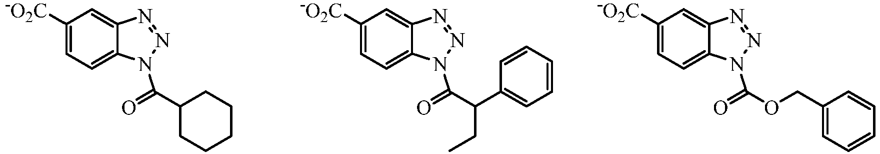

Weak acid betaine compounds are also useful as the quencher. Non-limiting examples thereof are shown below.

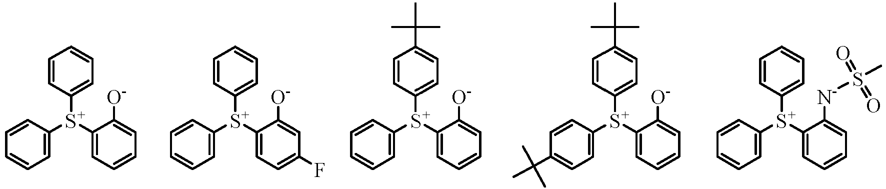

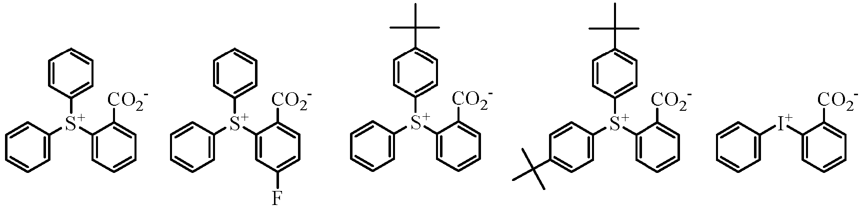

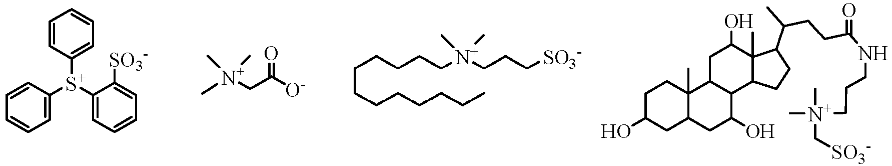

Also useful are quenchers of polymer type as described in USP 7,598,016 (JP-A 2008-239918). The polymeric quencher segregates at the resist surface after coating and thus enhances the rectangularity of resist pattern. When a protective film is applied as is often the case in the immersion lithography, the polymeric quencher is also effective for preventing a film thickness loss of resist pattern or rounding of pattern top.

When used, the quencher is preferably added in an amount of 0 to 50 parts, more preferably 0.1 to 40 parts by weight per 80 parts by weight of the base polymer. The quencher may be used alone or in admixture.

### Surfactant

The positive resist composition may contain any conventional surfactants for facilitating to coat the composition to the substrate. A number of surfactants are known in the art as described in JP-A 2004-115630, and any suitable one may be chosen therefrom. The amount of surfactant added is preferably 0 to 5 parts by weight per 80 parts by weight of the base polymer. It is noted that the surfactant need not be added when the positive resist composition contains a fluorinated polymer as mentioned above, which also plays the role of a surfactant.

From the standpoint of improving the develop loading effect, the chemically amplified positive resist composition is preferably designed such that a resist film formed therefrom in an over-exposed region may have a dissolution rate in alkaline developer of at least 50 nm/sec, more preferably at least 70 nm/sec. As long as the dissolution rate is at least 50 nm/sec, the resist film is uniformly dissolved in alkaline developer independent of a pattern layout difference in the case of a grouped/isolated pattern, and the variation of line width can be minimized. It is noted that the dissolution rate of an over-exposed region is computed by spin coating the positive resist composition onto a 8-inch silicon wafer, baking at 110°C for 60 seconds to form a resist film of 90 nm thick, exposing the resist film to KrF excimer laser radiation in a sufficient energy dose to complete deprotection reaction on the polymer, baking at 110°C for 60 seconds, developing the film in a 2.38 wt% TMAH aqueous solution at 23°C, and measuring a loss of film thickness by means of a resist development analyzer.

Also preferably, the resist film formed from the positive resist composition in an unexposed region has a dissolution rate in alkaline developer of up to 10 nm/min, more preferably up to 8 nm/min, even more preferably up to 6 nm/min. Where the resist film is in the thin film range of up to 100 nm, the influence of pattern film thickness loss in alkaline developer becomes greater. If the dissolution rate in unexposed region is more than 10 nm/min, pattern collapse will occur, failing to form a small size pattern. The problem becomes outstanding in the fabrication of photomasks requiring to be defectless and having a tendency of strong development process. It is noted that the dissolution rate of an unexposed region is computed by spin coating the positive resist composition onto a 6-inch silicon wafer, baking at 110°C for 240 seconds to form a resist film of 80 nm thick, developing the film in a 2.38 wt% TMAH aqueous solution at 23°C for 80 seconds, and measuring a loss of film thickness.

### Pattern forming process

A further embodiment of the invention is a process for forming a resist pattern comprising the steps of applying the chemically amplified positive resist composition onto a substrate to form a resist film thereon, exposing patternwise the resist film to high-energy radiation, and developing the exposed resist film in an alkaline developer.

The resist composition is first applied onto a substrate on which an integrated circuit is to be formed (e.g., Si, SiO, SiO₂, SiN, SiON, TiN, WSi, BPSG, SOG, or organic antireflective coating) or a substrate on which a mask circuit is to be formed (e.g., Cr, CrO, CrON, MoSi₂, Si, SiO, SiO₂, SiON, SiONC, CoTa, NiTa, TaBN, or SnO₂) by a suitable coating technique such as spin coating. The coating is prebaked on a hot plate at a temperature of preferably 60 to 150°C for 1 to 20 minutes, more preferably at 80 to 140°C for 1 to 10 minutes. The resulting resist film is generally 0.03 to 2 µm thick.

The resist film is then exposed to a desired pattern of high-energy radiation such as UV, deep-UV, excimer laser radiation (KrF, ArF, etc.), EUV, x-ray, γ-ray, synchrotron radiation or EB. Exposure using EUV or EB is preferred.

When UV, deep-UV, excimer laser, EUV, x-ray, γ-ray or synchrotron radiation is used as the high-energy radiation, the resist film is exposed thereto through a mask having a desired pattern in a dose of preferably 1 to 500 mJ/cm², more preferably 10 to 400 mJ/cm². When EB is used as the high-energy radiation, the resist film is exposed thereto directly in a dose of preferably 1 to 500 µC/cm², more preferably 10 to 400 µC/cm².

The exposure may be performed by conventional lithography whereas the immersion lithography of holding a liquid between the resist film and the mask may be employed if desired. In the case of immersion lithography, a protective film which is insoluble in water may be formed on the resist film.

After the exposure, the resist film may be baked (PEB) on a hotplate preferably at 60 to 150°C for 1 to 20 minutes, more preferably at 80 to 140°C for 1 to 10 minutes.

After the exposure or PEB, the resist film is developed in a developer in the form of an aqueous alkaline solution for preferably 0.1 to 3 minutes, more preferably 0.5 to 2 minutes by conventional techniques such as dip, puddle and spray techniques. A typical developer is a 0.1 to 5 wt%, preferably 2 to 3 wt% aqueous solution of tetramethylammonium hydroxide (TMAH) or another alkali. In this way, the desired pattern is formed on the substrate.

The positive resist composition of the invention is useful in forming a resist pattern having a satisfactory resolution and reduced LER. The positive resist composition is also useful in forming a resist pattern on a substrate having a surface layer of a material which is less adhesive to a resist film with a likelihood of later pattern stripping or pattern collapse. Examples of such substrate include substrates having sputter deposited on their outermost surface a layer of metallic chromium or a chromium compound containing one or more light elements such as oxygen, nitrogen and carbon, and substrates having an outermost layer of SiO, SiOₓ, or a tantalum, molybdenum, cobalt, nickel, tungsten or tin compound. The substrate to which the positive resist composition is applied is most typically a photomask blank which may be of transmission or reflection type.

The resist pattern forming process is successful in forming patterns having a high resolution, minimized influence of develop loading, and a reduced size difference independent of a pattern density (grouped or isolated) even on a substrate (typically photomask blank) whose outermost surface is made of a material tending to affect resist pattern profile such as a chromium, silicon or tantalum-containing material.

### EXAMPLES

Examples of the invention are given below by way of illustration and not by way of limitation. The abbreviation "pbw" is parts by weight. For copolymers, the compositional ratio is a molar ratio and Mw is determined by GPC versus polystyrene standards.

### Synthesis of sulfonium salt

### Synthesis Example 1

### Synthesis of sulfonium salt PM-1

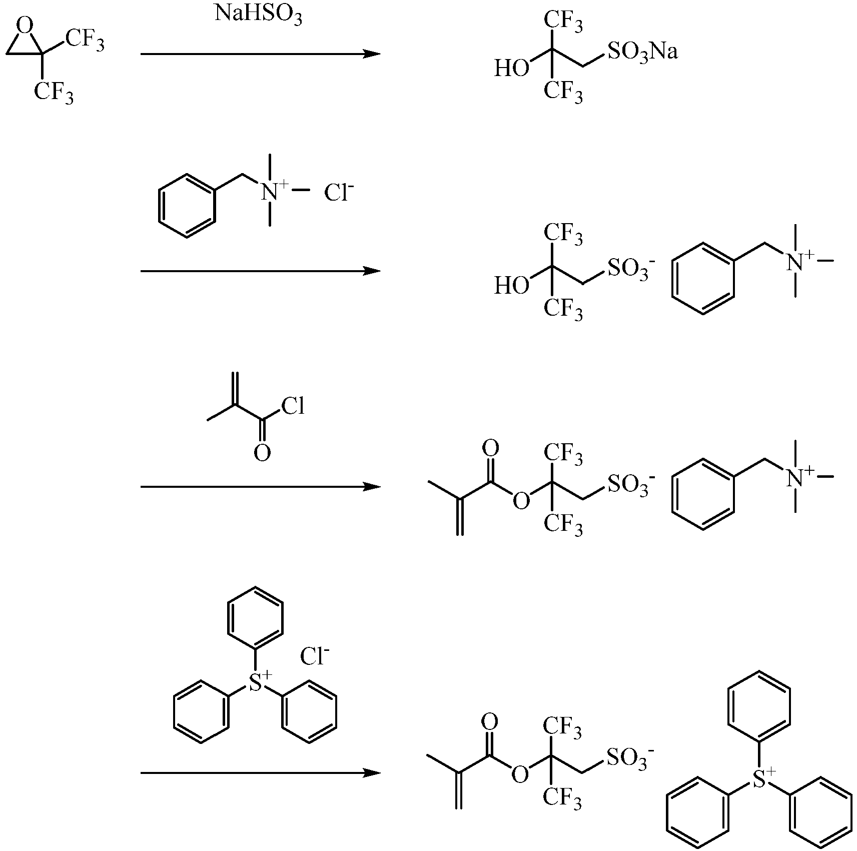

Sodium 3,3,3-trifluoro-2-hydroxy-2-trifluoromethylpropane-1-sulfonate was synthesized according to the method of USP 8,283,104 (JP-A 2010-215608). To 132 g of an aqueous solution containing sodium 3,3,3-trifluoro-2-hydroxy-2-trifluoromethylpropane-1-sulfonate (corresponding to 0.1 mol of sodium 3,3,3-trifluoro-2-hydroxy-2-trifluoromethylpropane-1-sulfonate), 200 g of methylene chloride and 20.4 g of benzyltrimethylammonium chloride were added, followed by 30 minutes of stirring. After stirring, the aqueous solution was subjected to separatory operation, extraction and water washing. The organic layer was concentrated. Methyl isobutyl ketone was added to the concentrate, followed by concentration again. Diisopropyl ether was added to the concentrate for recrystallization. The solid precipitate was collected and dried in vacuum, yielding a benzyltrimethylammonium salt.

To the benzyltrimethylammonium salt, 15.0 g of triethylamine and 200 g of methylene chloride were added. Under ice cooling, 11.5 g of methacryloyl chloride was added to the mixture. The solution was stirred at room temperature overnight, after which 100 g of water was added to quench the reaction. The reaction solution as quenched was subjected to separatory operation and extraction. An aqueous solution of triphenylsulfonium chloride was added to the extracted organic layer, followed by 30 minutes of stirring, separatory operation, and water washing. The organic layer was concentrated. Methyl isobutyl ketone was added to the concentrate, followed by concentration again. Diisopropyl ether was added to the concentrate for recrystallization. The solid precipitate was collected and dried in vacuum, obtaining the target compound, triphenylsulfonium 2-(methacryloyloxy)-3,3,3-trifluoro-2-trifluoromethylpropane-1-sulfonate (PM-1) as white solid (yield 85%).

### Synthesis of polymer

### Synthesis Example 2-1

### Synthesis of Polymer P-1

In nitrogen atmosphere, a 200-mL dropping cylinder was charged with 25.5 g of a 50.0 wt% PGMEA solution of 4-hydroxystyrene, 9.3 g of ethylcyclopentyl methacrylate, 12.7 g of 1-(1-methylcyclopentyloxy)-4-vinylbenzene, 17.5 g of PM-1, 4.1 g of dimethyl-2,2'-azobis(2-methylpropionate) (tradename V-601 by Fujifilm Wako Pure Chemical), and 24 g of γ-butyrolactone and 30 g of PGMEA as solvent to form a monomer solution.

In nitrogen atmosphere, a 300-mL flask was charged with 40 g of γ-butyrolactone and heated at 80°C. The monomer solution was added dropwise to the flask over 4 hours. After the completion of dropwise addition, the polymerization solution was continuously stirred for 18 hours while maintaining its temperature at 80°C. The polymerization solution was cooled to room temperature and added dropwise to 400 g of diisopropyl ether. The solution was statically held whereupon a solid precipitated. Diisopropyl ether was decanted off and the solid precipitate was dissolved in 100 g of acetone. The acetone solution was added dropwise to 400 g of diisopropyl ether whereupon a solid precipitated. The solid precipitate was collected by filtration and dissolved in 100 g of acetone again. The acetone solution was added dropwise to 400 g of water whereupon a solid precipitated. The solid was collected by filtration and dried at 40°C for 40 hours, obtaining 35 g of a polymer as white solid. The polymer designated Polymer P-1 was analyzed by ¹H-NMR, ¹³C-NMR and GPC, with the results shown below.

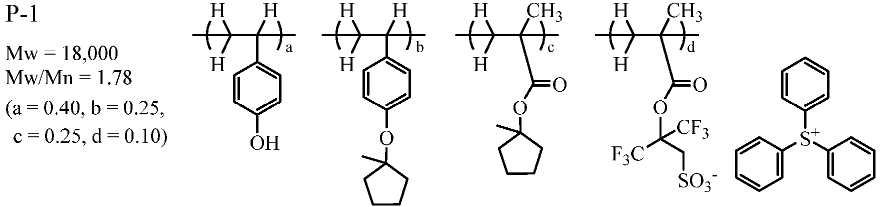

### Synthesis Examples 2-2 to 2-58 and Comparative Synthesis Examples 1-1 to 1-2

### Synthesis of Polymers P-2 to P-58 and Comparative Polymers cP-1 to cP-2

Polymers P-2 to P-58 and Comparative Polymers cP-1 to cP-2 were synthesized by the same procedure as Synthesis Example 2-1 except that the type and amount (mol%) of monomers were changed. Polymers P-24, P-25, P-26 or P-30 are not according to the invention. In Table 1, the incorporation ratio is a molar ratio.

**Table 1**

| | Unit 1 | Incorporation ratio (mol%) | Unit 2 | Incorporation ratio (mol%) | Unit 3 | Incorporation ratio (mol%) | Unit 4 | Incorporation ratio (mol%) | Unit 5 | Incorporation ratio (mol%) | Mw | Mw/Mn |
|---|---|---|---|---|---|---|---|---|---|---|---|---|
| P-1 | PM-1 | 10.0 | A-1 | 40.0 | C-1 | 25.0 | C-5 | 25.0 | - | - | 18,000 | 1.78 |
| P-2 | PM-1 | 10.0 | A-1 | 40.0 | B-1 | 10.0 | C-1 | 20.0 | C-5 | 20.0 | 17,400 | 1.79 |
| P-3 | PM-1 | 10.0 | A-1 | 40.0 | B-2 | 10.0 | C-1 | 20.0 | C-5 | 20.0 | 17,600 | 1.77 |
| P-4 | PM-2 | 10.0 | A-1 | 40.0 | B-2 | 10.0 | C-1 | 20.0 | C-5 | 20.0 | 17,900 | 1.78 |
| P-5 | PM-2 | 10.0 | A-1 | 40.0 | B-3 | 10.0 | C-1 | 20.0 | C-5 | 20.0 | 17,500 | 1.76 |
| P-6 | PM-2 | 10.0 | A-1 | 40.0 | B-4 | 10.0 | C-1 | 20.0 | C-5 | 20.0 | 17,400 | 1.78 |
| P-7 | PM-2 | 10.0 | A-1 | 40.0 | B-2 | 10.0 | C-2 | 20.0 | C-6 | 20.0 | 17,700 | 1.77 |
| P-8 | PM-2 | 10.0 | A-1 | 40.0 | B-2 | 10.0 | C-3 | 20.0 | C-5 | 20.0 | 17,700 | 1.75 |
| P-9 | PM-2 | 10.0 | A-1 | 40.0 | B-2 | 10.0 | C-4 | 20.0 | C-5 | 20.0 | 17,800 | 1.76 |
| P-10 | PM-2 | 10.0 | A-1 | 40.0 | B-2 | 10.0 | C-9 | 20.0 | C-5 | 20.0 | 17,500 | 1.77 |
| P-11 | PM-2 | 10.0 | A-1 | 40.0 | B-2 | 10.0 | C-1 | 20.0 | C-6 | 20.0 | 17,600 | 1.78 |
| P-12 | PM-2 | 10.0 | A-1 | 40.0 | B-2 | 10.0 | C-1 | 20.0 | C-7 | 20.0 | 17,400 | 1.75 |
| P-13 | PM-2 | 10.0 | A-1 | 40.0 | B-2 | 10.0 | C-1 | 20.0 | C-8 | 20.0 | 17,600 | 1.78 |
| P-14 | PM-2 | 10.0 | A-1 | 40.0 | B-2 | 10.0 | C-1 | 20.0 | C-12 | 20.0 | 17,500 | 1.76 |
| P-15 | PM-2 | 10.0 | A-1 | 40.0 | B-2 | 10.0 | C-13 | 20.0 | C-5 | 20.0 | 17,400 | 1.75 |
| P-16 | PM-2 | 10.0 | A-1 | 40.0 | B-2 | 10.0 | C-14 | 20.0 | C-5 | 20.0 | 17,500 | 1.77 |
| P-17 | PM-2 | 10.0 | A-1 | 40.0 | B-2 | 10.0 | C-15 | 20.0 | C-5 | 20.0 | 17,500 | 1.78 |
| P-18 | PM-2 | 10.0 | A-1 | 40.0 | B-2 | 10.0 | C-16 | 20.0 | C-5 | 20.0 | 17,400 | 1.77 |
| P-19 | PM-2 | 10.0 | A-1 | 40.0 | B-2 | 10.0 | C-17 | 20.0 | C-5 | 20.0 | 17,600 | 1.78 |
| P-20 | PM-2 | 10.0 | A-1 | 40.0 | B-2 | 10.0 | C-18 | 20.0 | C-5 | 20.0 | 17,700 | 1.76 |
| P-21 | PM-2 | 10.0 | A-1 | 40.0 | B-2 | 10.0 | C-10 | 20.0 | C13 | 20.0 | 17,800 | 1.75 |
| P-22 | PM-2 | 10.0 | A-1 | 40.0 | B-2 | 10.0 | C-11 | 20.0 | C13 | 20.0 | 17,600 | 1.76 |
| P-23 | PM-3 | 10.0 | A-1 | 40.0 | B-2 | 10.0 | C-1 | 20.0 | C-5 | 20.0 | 18,600 | 1.76 |
| P-24 | PM-4 | 10.0 | A-1 | 40.0 | B-2 | 10.0 | C-1 | 20.0 | C-5 | 20.0 | 17,600 | 1.75 |
| P-25 | PM-5 | 10.0 | A-1 | 40.0 | B-2 | 10.0 | C-1 | 20.0 | C-5 | 20.0 | 18,700 | 1.76 |
| P-26 | PM-6 | 10.0 | A-1 | 40.0 | B-2 | 10.0 | C-1 | 20.0 | C-5 | 20.0 | 18,800 | 1.76 |
| P-27 | PM-2 | 5.0 | A-1 | 35.0 | C-1 | 30.0 | C-5 | 30.0 | - | - | 18,400 | 1.79 |
| P-28 | PM-2 | 25.0 | A-1 | 35.0 | C-1 | 20.0 | C-5 | 20.0 | - | - | 17,900 | 1.77 |
| P-29 | PM-2 | 10.0 | A-2 | 50.0 | C-1 | 20.0 | C-5 | 20.0 | - | - | 18,000 | 1.78 |
| P-30 | PM-2 | 10.0 | A-3 | 40.0 | C-1 | 25.0 | C-5 | 25.0 | - | - | 18,200 | 1.79 |

**Table 2**

| | Unit 1 | Incorporation ratio (mol%) | Unit 2 | Incorporation ratio (mol%) | Unit 3 | Incorporation ratio (mol%) | Unit 4 | Incorporation ratio (mol%) | Unit 5 | Incorporation ratio (mol%) | Mw | Mw/Mn |
|---|---|---|---|---|---|---|---|---|---|---|---|---|
| P-31 | PM-2 | 10.0 | A-2 | 50.0 | B-3 | 10.0 | C-1 | 15.0 | C-5 | 15.0 | 18,300 | 1.77 |
| P-32 | PM-2 | 10.0 | A-2 | 50.0 | C-2 | 20.0 | C-6 | 20.0 | - | - | 18,100 | 1.78 |
| P-33 | PM-2 | 10.0 | A-2 | 50.0 | C-3 | 20.0 | C-7 | 20.0 | - | - | 18,200 | 1.79 |
| P-34 | PM-2 | 10.0 | A-2 | 50.0 | C-4 | 20.0 | C-8 | 20.0 | - | - | 18,400 | 1.78 |
| P-35 | PM-2 | 10.0 | A-2 | 50.0 | C-1 | 20.0 | C-6 | 20.0 | - | - | 18,100 | 1.77 |
| P-36 | PM-2 | 10.0 | A-2 | 50.0 | C-1 | 20.0 | C-7 | 20.0 | - | - | 18,200 | 1.78 |
| P-37 | PM-2 | 10.0 | A-2 | 50.0 | C-1 | 20.0 | C-8 | 20.0 | - | - | 18,500 | 1.78 |
| P-38 | PM-2 | 10.0 | A-2 | 50.0 | C-2 | 20.0 | C-5 | 20.0 | - | - | 18,100 | 1.78 |
| P-39 | PM-2 | 10.0 | A-2 | 50.0 | C-2 | 20.0 | C-7 | 20.0 | - | - | 18,200 | 1.79 |
| P-40 | PM-2 | 10.0 | A-2 | 50.0 | C-2 | 20.0 | C-8 | 20.0 | - | - | 18,300 | 1.78 |
| P-41 | PM-2 | 10.0 | A-2 | 50.0 | C-3 | 20.0 | C-5 | 20.0 | - | - | 18,300 | 1.78 |
| P-42 | PM-2 | 10.0 | A-2 | 50.0 | C-3 | 20.0 | C-6 | 20.0 | - | - | 18,300 | 1.79 |
| P-43 | PM-2 | 10.0 | A-2 | 50.0 | C-3 | 20.0 | C-8 | 20.0 | - | - | 18,400 | 1.78 |
| P-44 | PM-2 | 10.0 | A-2 | 50.0 | C-4 | 20.0 | C-5 | 20.0 | - | - | 18,400 | 1.79 |
| P-45 | PM-2 | 10.0 | A-2 | 50.0 | C-4 | 20.0 | C-6 | 20.0 | - | - | 18,400 | 1.79 |
| P-46 | PM-2 | 10.0 | A-2 | 50.0 | C-4 | 20.0 | C-7 | 20.0 | - | - | 18,500 | 1.78 |
| P-47 | PM-2 | 10.0 | A-2 | 50.0 | C-1 | 40.0 | - | - | - | - | 18,200 | 1.77 |
| P-48 | PM-2 | 10.0 | A-2 | 50.0 | C-5 | 40.0 | - | - | - | - | 17,800 | 1.78 |
| P-49 | PM-2 | 10.0 | A-2 | 50.0 | B-2 | 10.0 | C-5 | 15.0 | C-1 | 15.0 | 17,700 | 1.77 |
| P-50 | PM-2 | 5.0 | A-2 | 50.0 | B-2 | 10.0 | C-5 | 15.0 | C-1 | 20.0 | 17,800 | 1.76 |
| P-51 | PM-2 | 10.0 | A-2 | 50.0 | C-13 | 20.0 | C-1 | 20.0 | - | - | 17,700 | 1.77 |
| P-52 | PM-2 | 10.0 | A-2 | 40.0 | B-2 | 10.0 | C-13 | 20.0 | C-1 | 20.0 | 17,600 | 1.76 |
| P-53 | PM-2 | 10.0 | A-2 | 50.0 | C-19 | 20.0 | C-1 | 20.0 | - | - | 17,800 | 1.77 |
| P-54 | PM-2 | 10.0 | A-2 | 45.0 | B-2 | 10.0 | C-19 | 15.0 | C-1 | 20.0 | 17,600 | 1.76 |
| P-55 | PM-2 | 10.0 | A-2 | 45.0 | B-2 | 10.0 | C-20 | 15.0 | C-1 | 20.0 | 17,600 | 1.76 |
| P-56 | PM-2 | 10.0 | A-2 | 50.0 | C-1 | 35.0 | C-5 | 5.0 | - | - | 18,200 | 1.77 |
| P-57 | PM-2 | 5.0 | A-2 | 70.0 | C-2 | 10.0 | C-19 | 15.0 | - | - | 18,000 | 1.74 |
| P-58 | PM-2 | 10.0 | A-1 | 55.0 | B-2 | 10.0 | C-2 | 10.0 | C-19 | 15.0 | 18,100 | 1.73 |

**Table 3**

| | Unit 1 | Incorporation ratio (mol%) | Unit 2 | Incorporation ratio (mol%) | Unit 3 | Incorporation ratio (mol%) | Unit 4 | Incorporation ratio (mol%) | Unit 5 | Incorporation ratio (mol%) | Mw | Mw/Mn |
|---|---|---|---|---|---|---|---|---|---|---|---|---|
| cP-1 | PM-2 | 10.0 | A-1 | 57.0 | B-2 | 10.0 | C-1 | 23.0 | - | - | 17,600 | 1.79 |
| cP-2 | PM-2 | 10.0 | A-1 | 50.0 | B-2 | 10.0 | C-5 | 30.0 | - | - | 17,200 | 1.78 |

The structure of repeat units incorporated in the polymers is shown below.

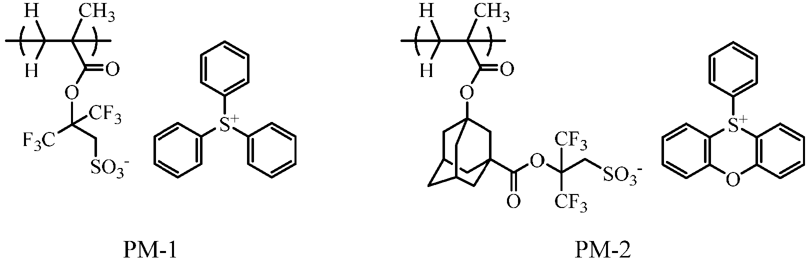

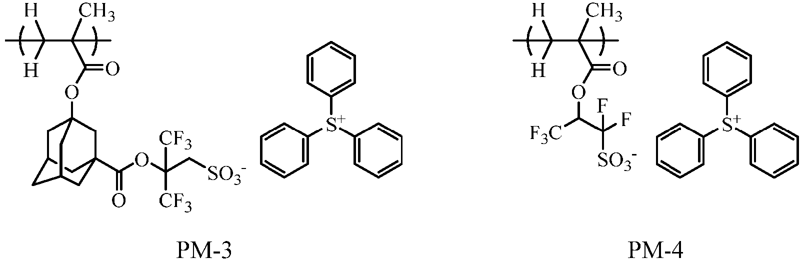

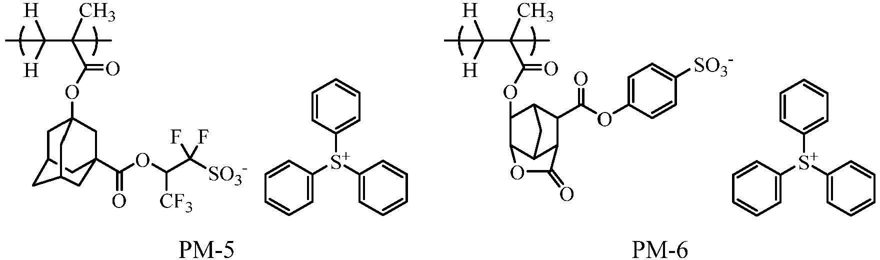

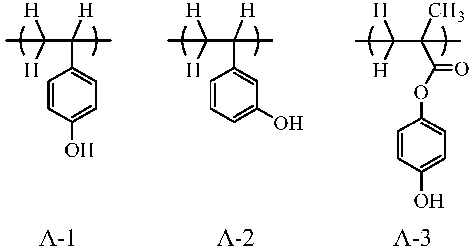

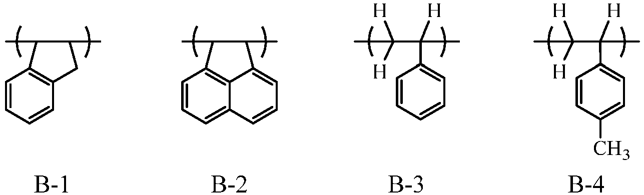

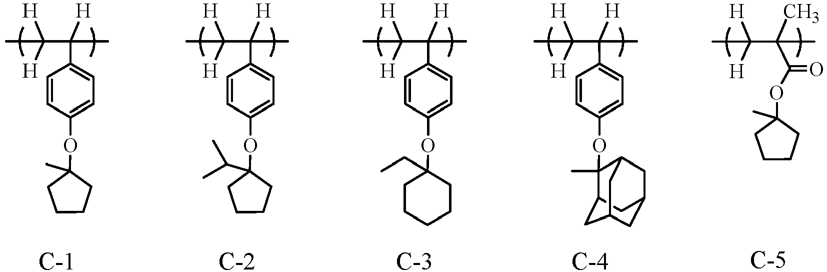

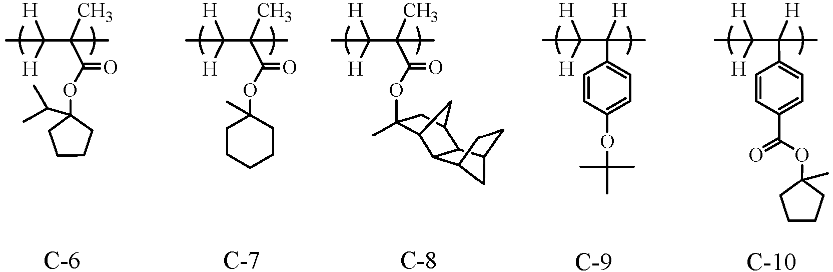

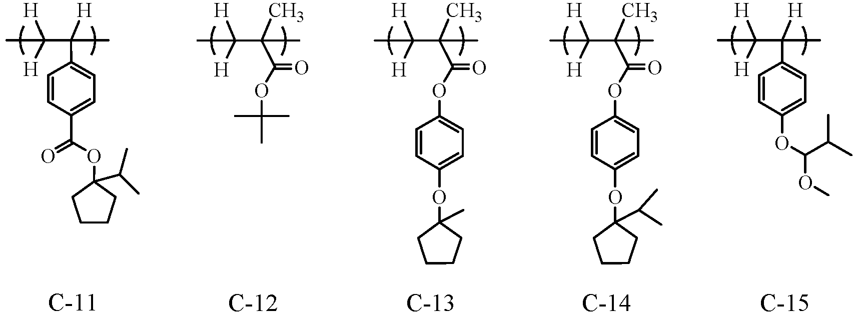

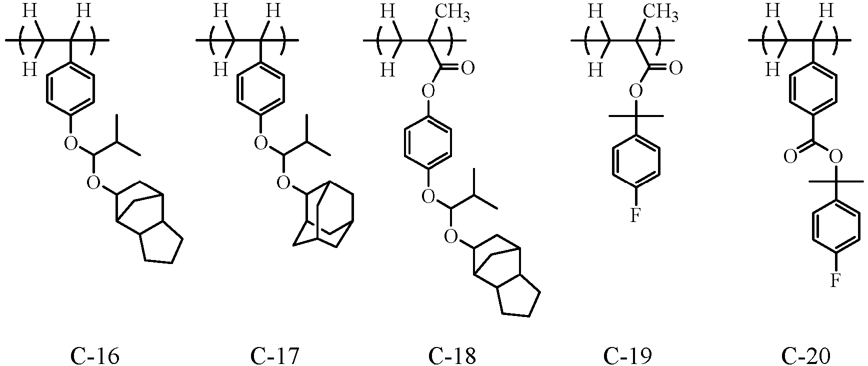

The dissolution rate of a polymer in alkaline developer was computed by spin coating a 16.7 wt% solution of the polymer in propylene glycol monomethyl ether (PGME) solvent onto a 8-inch silicon wafer, baking at 100°C for 90 seconds to form a film of 1,000 nm thick, developing the film in a 2.38 wt% aqueous solution of tetramethylammonium hydroxide (TMAH) at 23°C for 100 seconds, and measuring a loss of film thickness. Polymers P-1 to P-58 and Comparative Polymers cP-1 to cP-2 showed a dissolution rate of up to 5 nm/min.

### Synthesis Examples 3-1 to 3-11

### Synthesis of Polymers AP-1 to AP-11

Polymers AP-1 to AP-11 were synthesized by the same procedure as Synthesis Example 2-1 except that the monomers were changed.

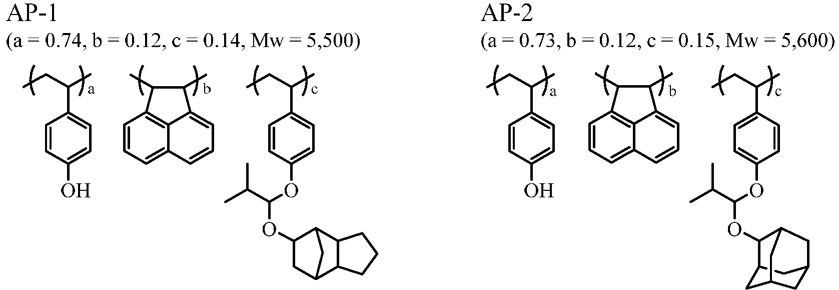

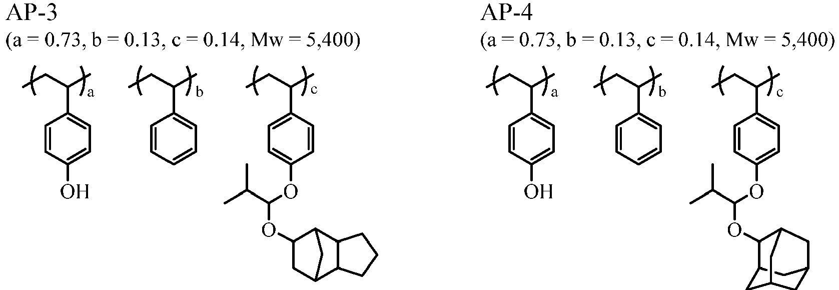

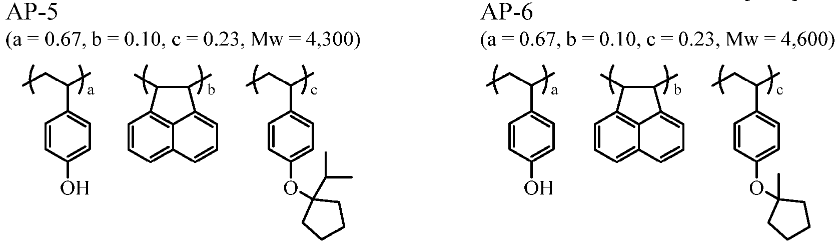

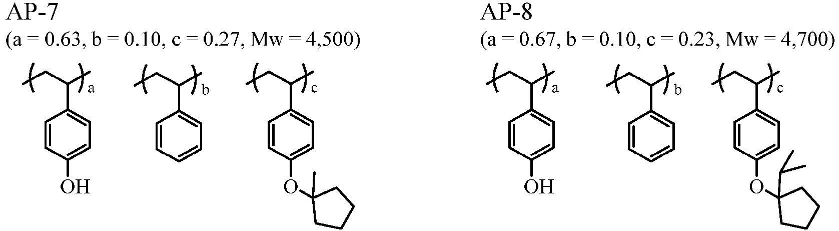

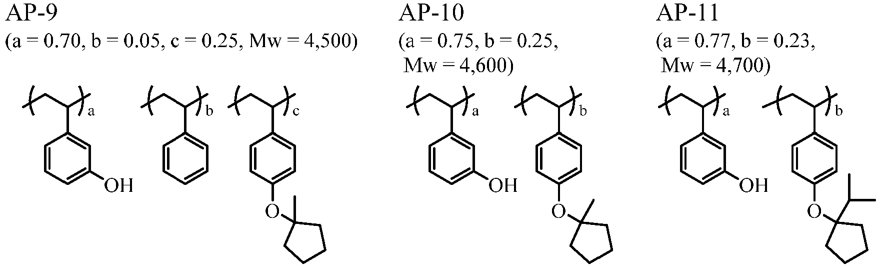

Polymers AP-1 to AP-11 showed a dissolution rate of up to 5 nm/min.

### Preparation of chemically amplified positive resist compositions

### Examples 1-1 to 1-90 and Comparative Examples 1-1 to 1-3

Positive resist compositions were prepared by dissolving selected components in an organic solvent in accordance with the formulation shown in Tables 4 to 8, and filtering the solution through a UPE filter with a pore size of 0.02 µm. The organic solvent was a mixture of 340 pbw of PGMEA, 1,700 pbw of EL, and 1,360 pbw of PGME, to which 0.075 pbw of surfactant FC-4430 (3M) was added.
Examples 1-33, 1-34, 1-35 and 1-55 are not according to the invention.

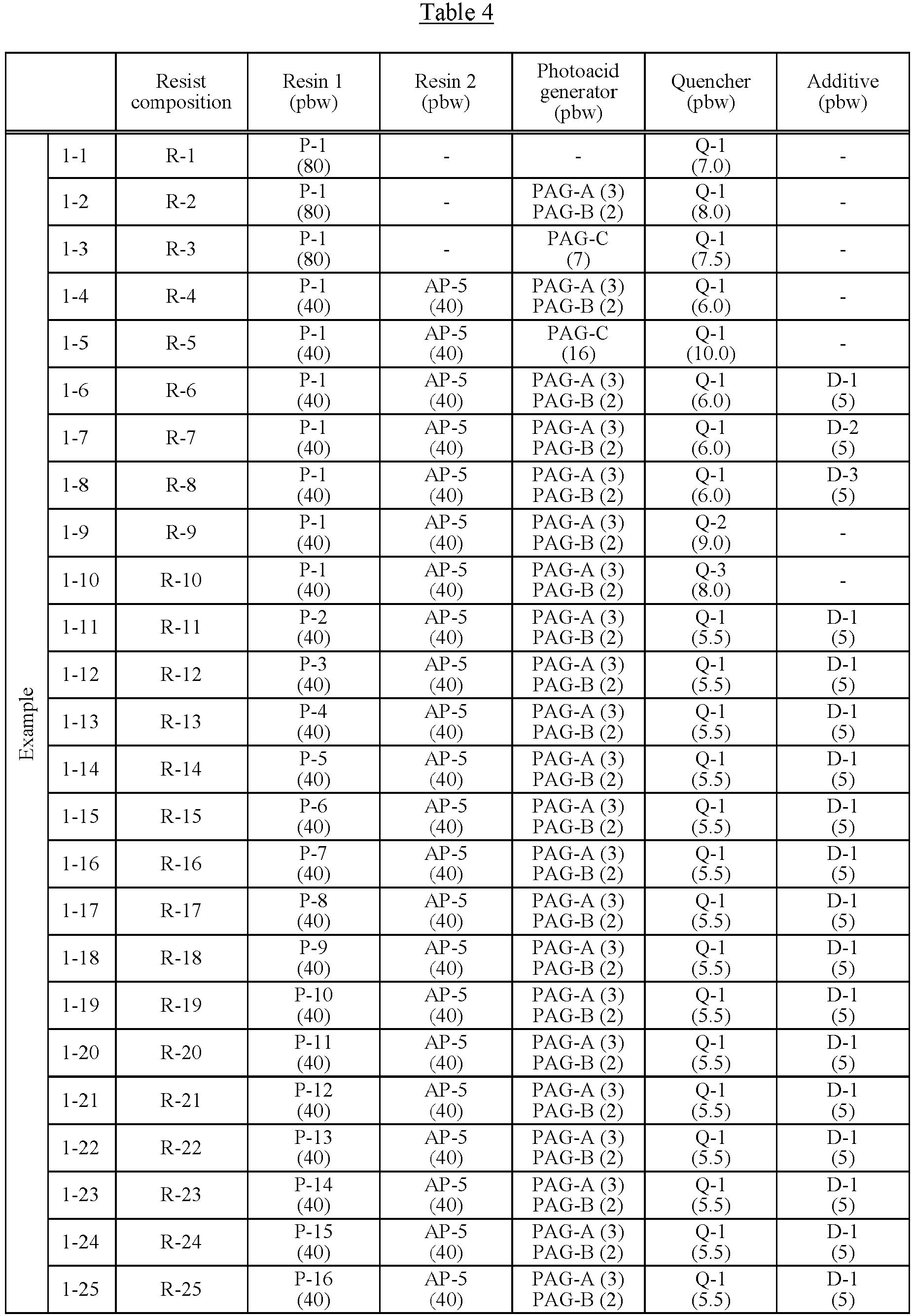

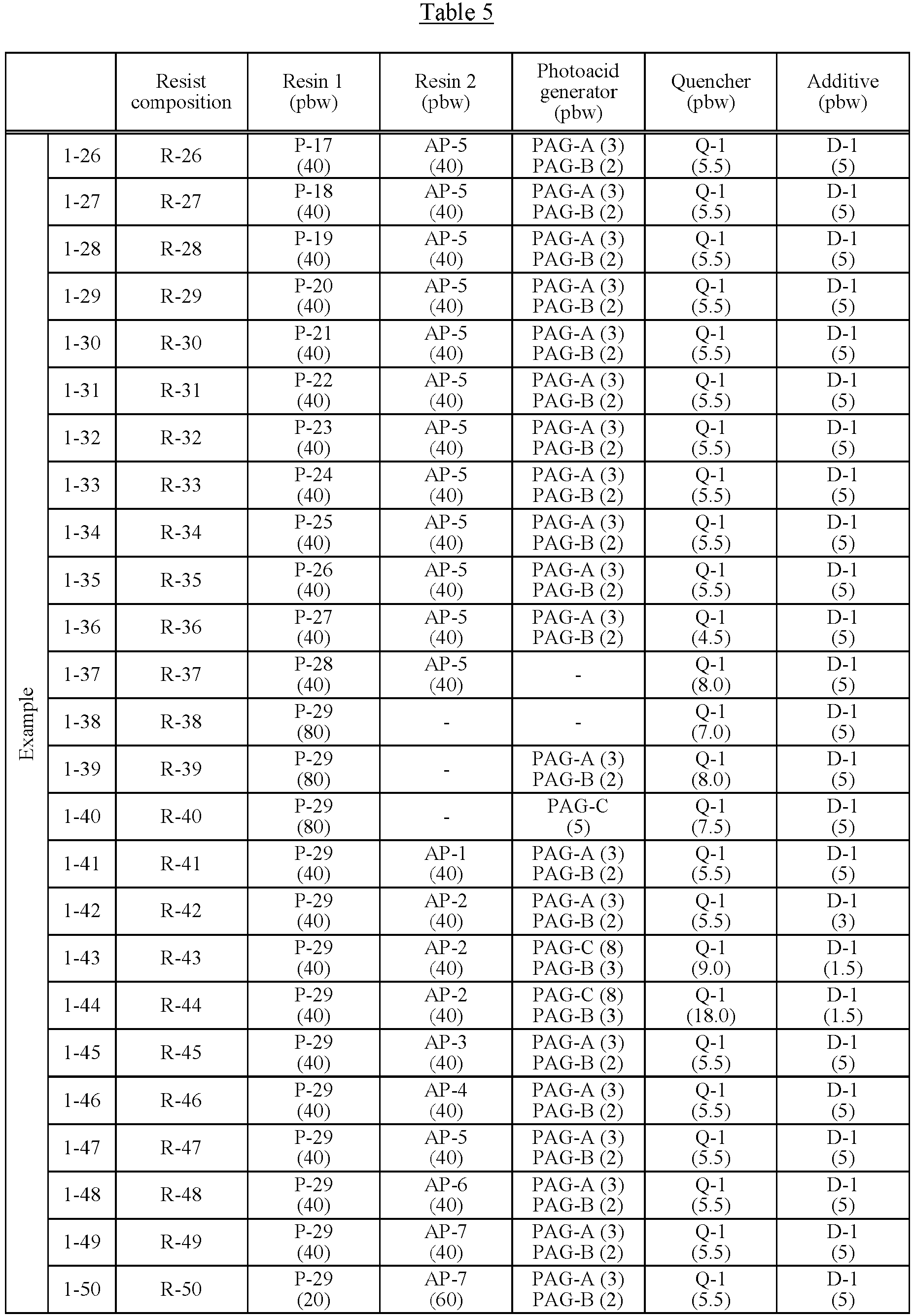

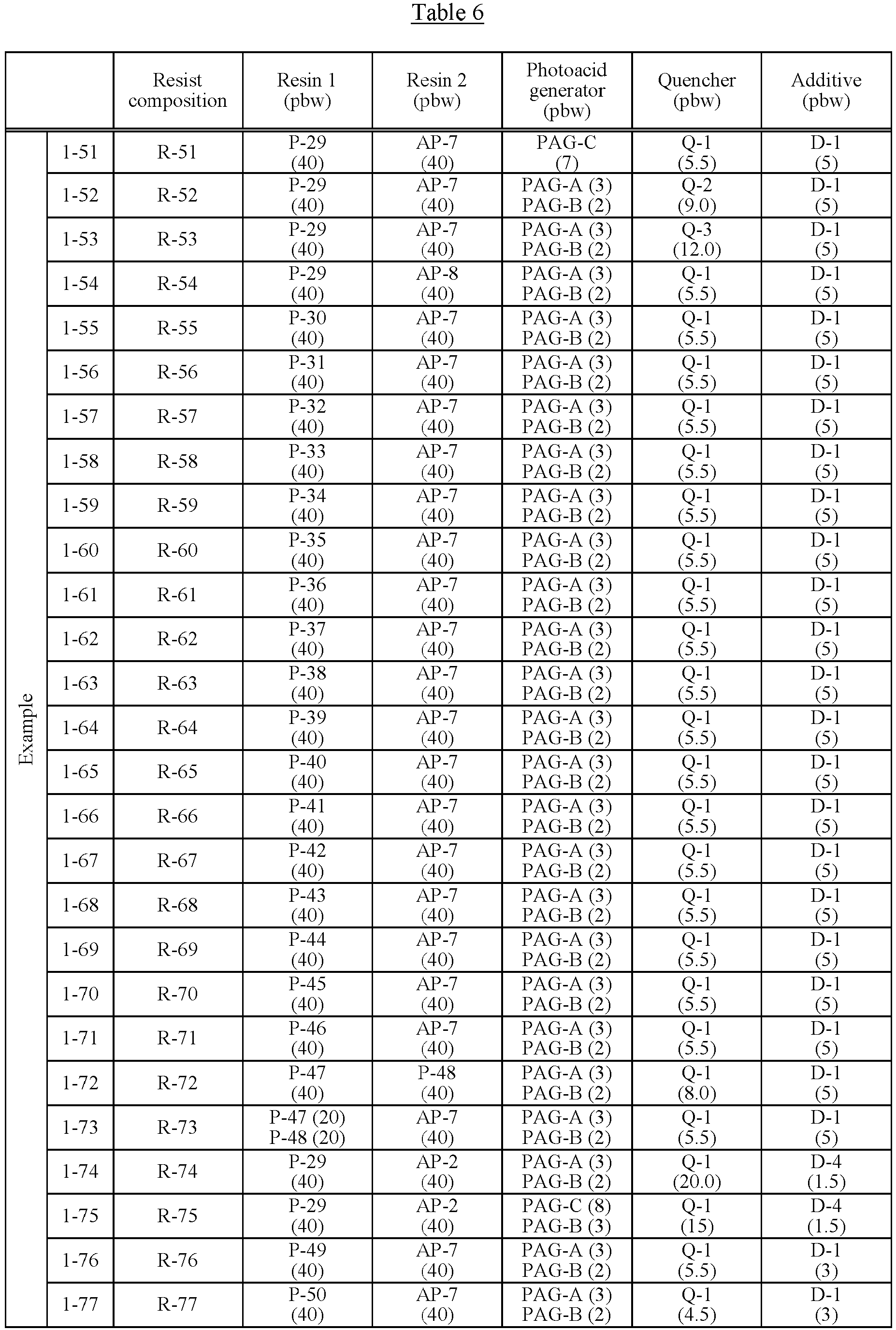

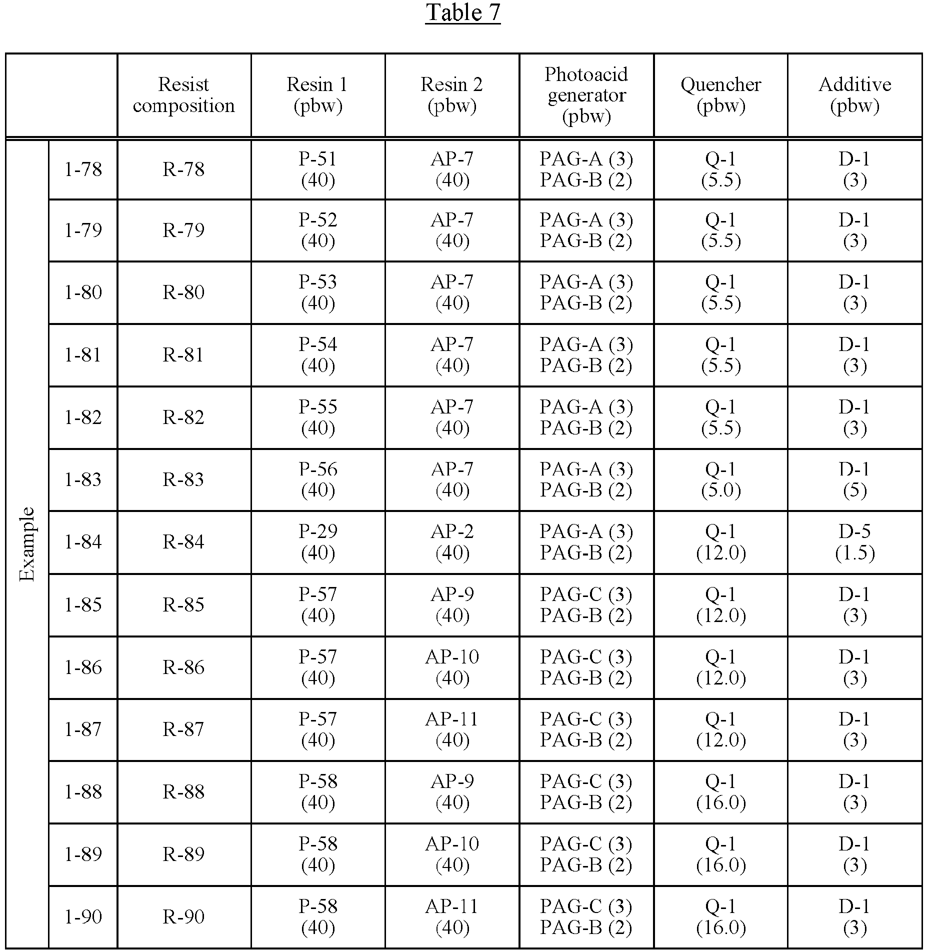

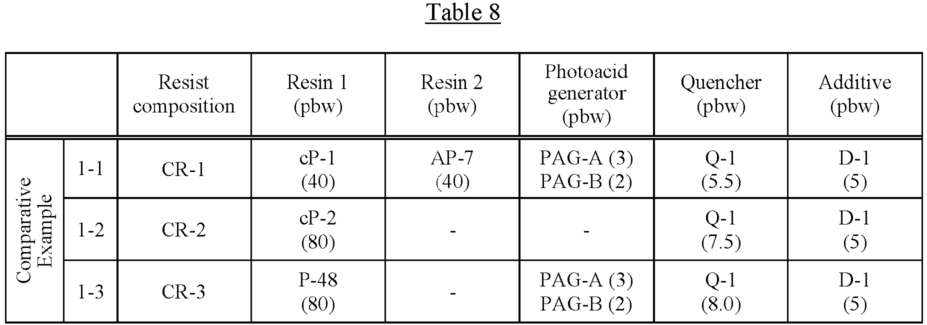

In Tables 4 to 8, quenchers Q-1 to Q-3, photoacid generators PAG-A to PAG-C, and polymers D-1 to D-5 have the structures shown below.

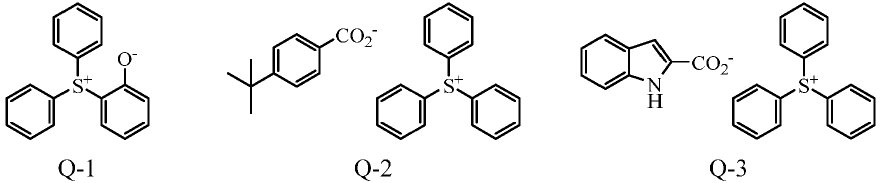

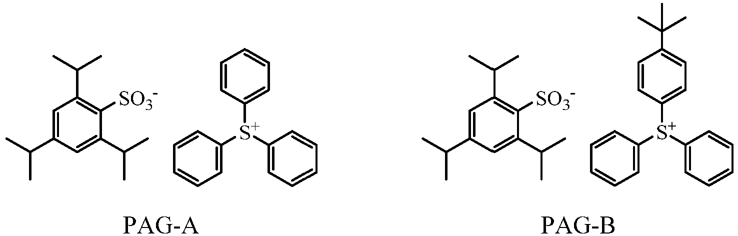

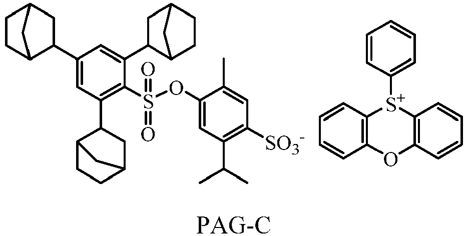

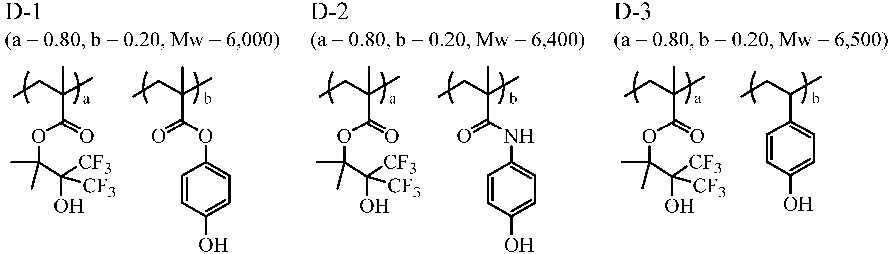

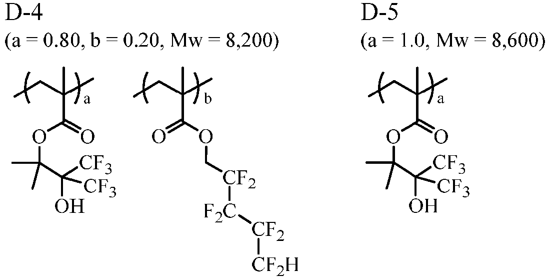

### EB lithography test

### Examples 2-1 to 2-90 and Comparative Examples 2-1 to 2-3

(Examples 2-33, 2-34, 2-35, and 2-55 are not according to the invention.)

Using a coater/developer system ACT-M (Tokyo Electron Ltd.), each of the positive resist compositions (R-1 to R-90, CR-1 to CR-3) was spin coated onto a photomask blank of 152 mm squares having the outermost surface of chromium and prebaked on a hotplate at 110°C for 600 seconds to form a resist film of 80 nm thick. The thickness of the resist film was measured by an optical film thickness measurement system Nanospec (Nanometrics Inc.). Measurement was made at 81 points in the plane of the blank substrate excluding a peripheral band extending 10 mm inward from the blank periphery, and an average film thickness and a film thickness range were computed therefrom.

The resist film was exposed to EB using an EB writer system EBM-5000Plus (NuFlare Technology Inc., accelerating voltage 50 kV), then baked (PEB) at 110°C for 600 seconds, and developed in a 2.38 wt% TMAH aqueous solution, thereby yielding a positive pattern.

The resist pattern was evaluated as follows. The patterned mask blank was observed under a top-down scanning electron microscope (TD-SEM). The optimum dose (Eop) was defined as the exposure dose (µC/cm²) which provided a 1:1 resolution at the top and bottom of a 200-nm 1:1 line-and-space (LS) pattern. The LS resolution (or maximum resolution) was defined as the minimum line width of a L/S pattern that could be resolved at the optimum dose. The edge roughness (LER) of a 200-nm LS pattern was measured under SEM. The develop loading was evaluated by forming a 200-nm LS pattern at the dose (µC/cm²) capable of resolving a 1:1 LS pattern of 200 nm design at a ratio 1:1 and a 200-nm LS pattern including dummy patterns having a density of 15%, 25%, 33%, 45%, 50%, 55%, 66%, 75%, 85%, and 95% arranged around the center pattern, measuring the size of spaces under SEM, and comparing the size difference among grouped and isolated patterns. Also, the pattern was visually observed to judge whether or not the profile was rectangular.

The dissolution rate of an over-exposed region is computed by spin coating the resist solution onto a 8-inch silicon wafer, baking at 110°C for 60 seconds to form a resist film of 90 nm thick, exposing the resist film to KrF excimer laser radiation in a dose (mJ/cm²) capable of resolving a 200-nm 1:1 LS pattern at a ratio 1:1, baking at 110°C for 60 seconds, developing the film in a 2.38 wt% TMAH aqueous solution at 23°C, and measuring a loss of film thickness by means of a resist development rate analyzer (RDA-800 by Litho Tech Japan Corp.). The results are shown in Tables 9 to 12.

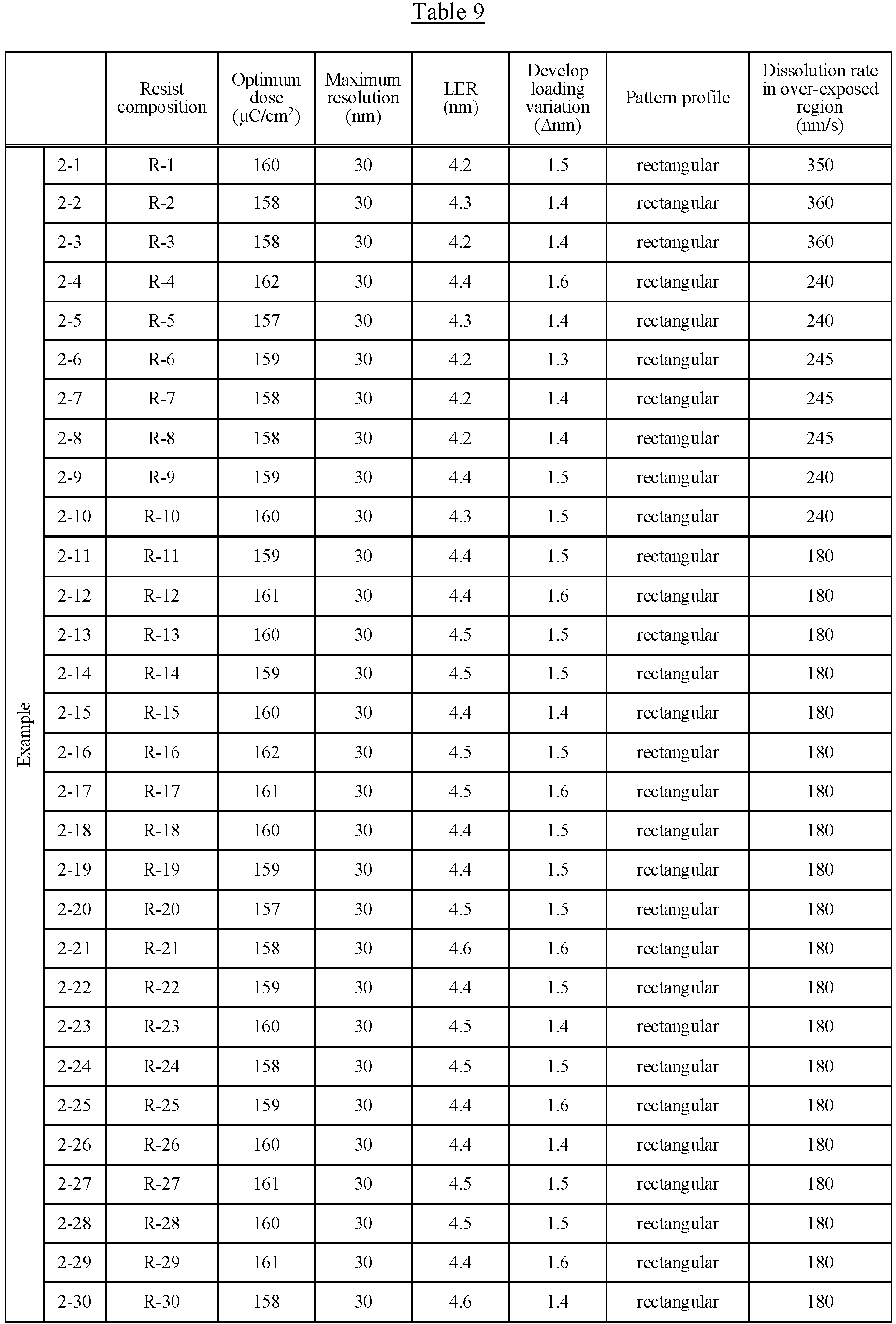

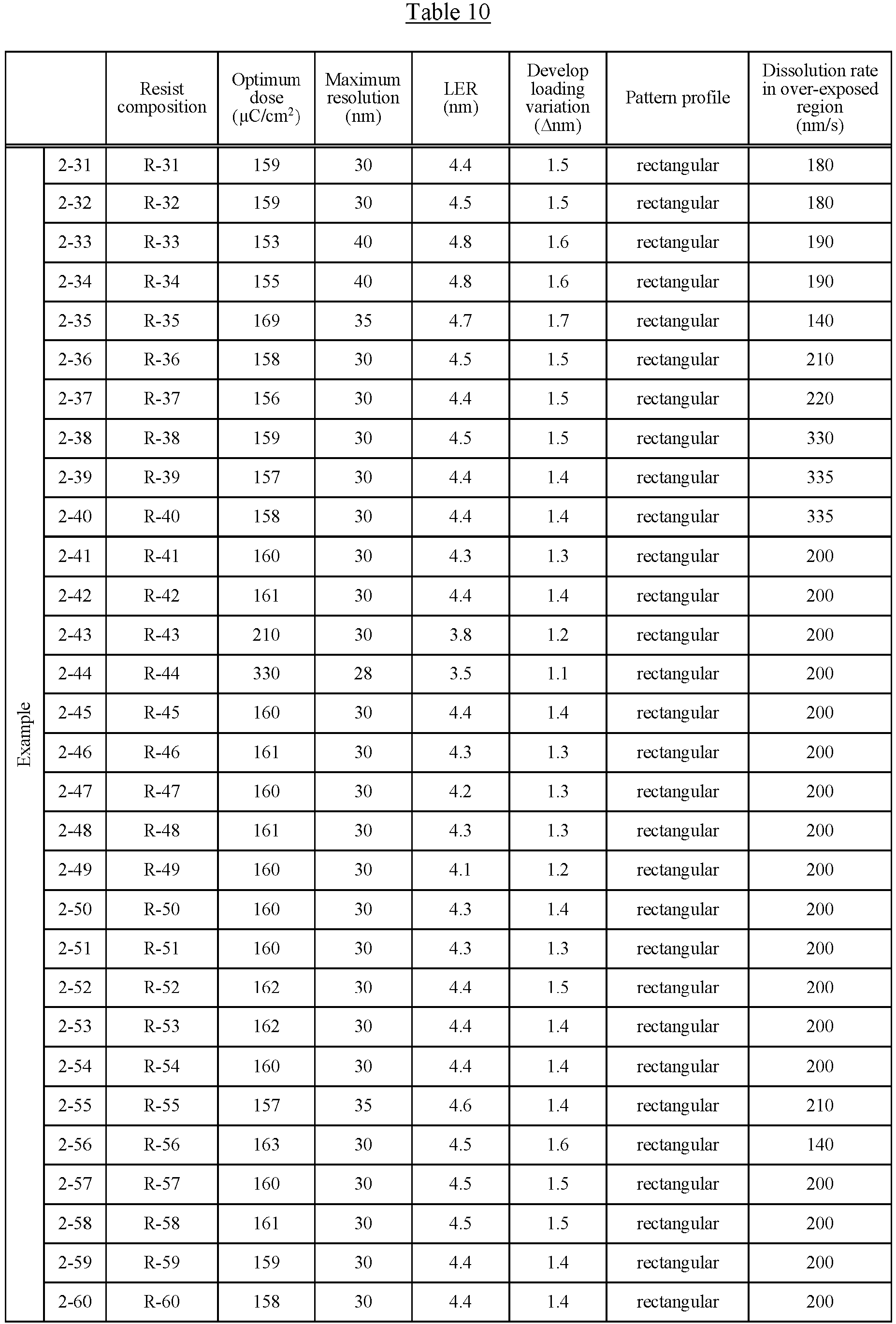

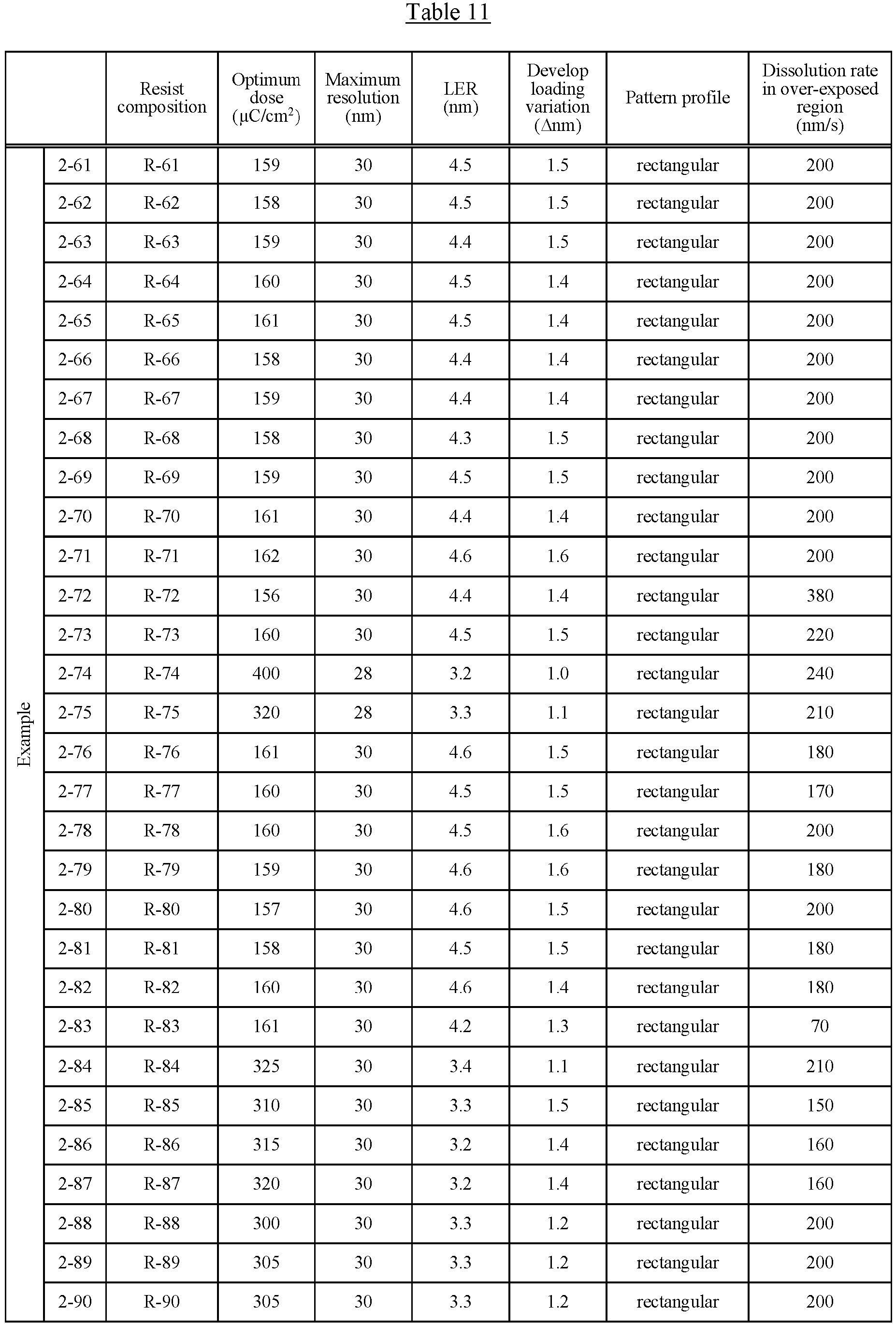

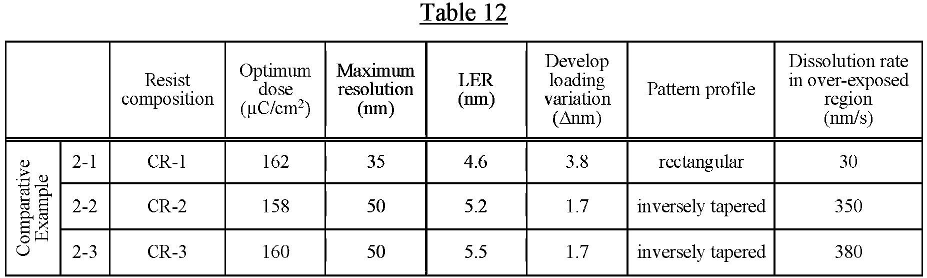

Examples 2-33, 2-34, 2-35, and 2-55 are not according to the invention.

All the chemically amplified positive resist compositions (R-1 to to R-32, R-36 to R-54 and R-56 to R-90) within the scope of the invention show satisfactory resolution, reduced LER, rectangular pattern profile, and controlled values of develop loading. Of the comparative resist compositions (CR-1 to CR-3), composition CR-1 has so low an over-exposed region dissolution rate that the control of develop loading is insufficient. In compositions CR-2 and CR-3, because the design of base polymers is insufficient, not all resolution, LER and pattern rectangularity are met although the develop loading is fully controlled.

This accounts for the design of base polymers. That is, an acid diffusion controlling effect is obtained by designing a PAG-bound polymer framework. By combining a phenolic acid-labile group with an acrylic acid-labile group, optimization of a pattern profile due to phenolic units and optimization of an exposed region dissolution rate due to acrylic units are attained. As a result, all resolution, LER, pattern rectangularity, and develop loading control are achieved. The resist pattern forming process using the positive resist composition is effective in photolithography for the fabrication of semiconductor devices and the processing of photomask blanks of transmission and reflection types.

## Claims

1. A chemically amplified positive resist composition comprising a base polymer protected with an acid labile group and adapted to turn alkali soluble under the action of acid, wherein
said base polymer contains a polymer comprising an acid generating unit, a phenolic hydroxy group-containing unit, a unit containing a phenolic hydroxy group protected with an acid labile group, and a unit containing a carboxy group protected with an acid labile group,
the aromatic ring-containing repeat units account for at least 60 mol% of the overall repeat units of the polymer in said base polymer,
wherein the acid generating unit is a repeat unit having the following formula (A4), the phenolic hydroxy group-containing unit is a repeat unit having the following formula (B1-1), the unit containing a phenolic hydroxy group protected with an acid labile group is a repeat unit having the following formula (B2-1), and the unit containing a carboxy group protected with an acid labile group is a repeat unit having the following formula (B3-1): 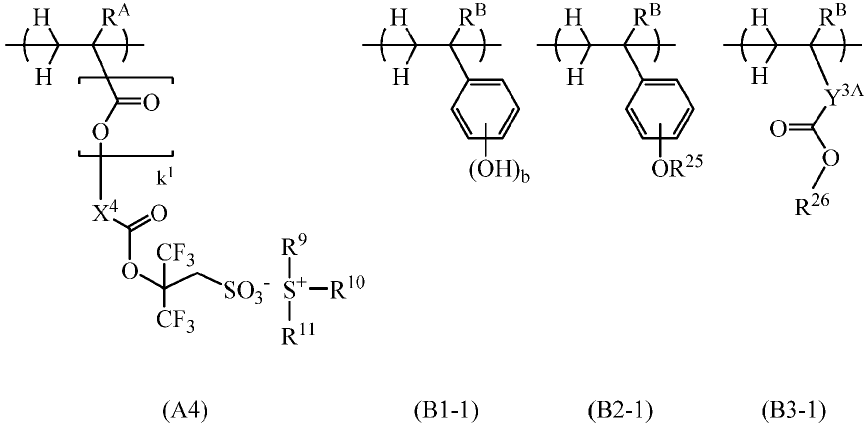
wherein R^{A} is each independently hydrogen or methyl,
wherein R^{B} is hydrogen, fluorine, methyl or trifluoromethyl,
X⁴ is a single bond or C₁-C₃₀ hydrocarbylene group which may contain a heteroatom, k¹ and k² are each independently 0 or 1, k¹ and k² are 0 when X⁴ is a single bond,
R⁹ to R¹¹ are each independently halogen or a C₁-C₂₀ hydrocarbyl group which may contain a heteroatom, R⁹ and R¹⁰ may bond together to form a ring with the sulfur atom to which they are attached,
b is an integer of 1 to 3,
k¹ is 0 or 1, k¹ is 0 when X⁴ is a single bond,
Y^{3A} is a single bond, phenylene group or naphthylene group,
R²⁵ and R²⁶ are each independently an acid labile group having a C₆-C₂₀ aromatic hydrocarbon moiety and/or C₅-C₂₀ alicyclic hydrocarbon moiety,
wherein said base polymer contains a polymer comprising repeat units having formula (A4), repeat units having formula (B 1-1), repeat units having formula (B2-1), and repeat units having formula (B3-1).

2. The positive resist composition of claim 1 wherein the polymer in said base polymer further comprises a repeat unit having any one of the following formulae (C1) to (C3): 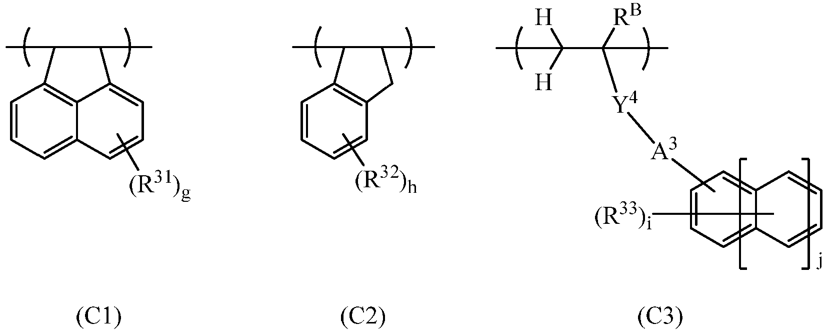 wherein R^{B} is as defined above,
g and h are each independently an integer of 0 to 4, i is an integer of 0 to 5, j is an integer of 0 to 2,
R³¹ and R³² are each independently a hydroxy group, halogen, an optionally halogenated C₂-C₈ saturated hydrocarbylcarbonyloxy group, optionally halogenated C₁-C₈ saturated hydrocarbyl group, or optionally halogenated C₁-C₈ saturated hydrocarbyloxy group,
R³³ is an acetyl group, C₁-C₂₀ saturated hydrocarbyl group, C₁-C₂₀ saturated hydrocarbyloxy group, C₂-C₂₀ saturated hydrocarbylcarbonyloxy group, C₂-C₂₀ saturated hydrocarbyloxyhydrocarbyl group, C₂-C₂₀ saturated hydrocarbylthiohydrocarbyl group, halogen, nitro group, or cyano group, R³³ may also be hydroxy when j is 1 or 2,
Y⁴ is a single bond, *-C(=O)-O- or *-C(=O)-NH-, * designates a point of attachment to the carbon atom in the backbone,
A³ is a single bond or a C₁-C₁₀ saturated hydrocarbylene group in which some constituent -CH₂- may be replaced by -O-.

3. The positive resist composition of claim 1 or 2 wherein said base polymer further contains a polymer comprising repeat units having formula (B1) and repeat units of at least one type selected from repeat units having formula (B2) and repeat units having formula (B3), but not repeat units having formula (A1) to (A8), 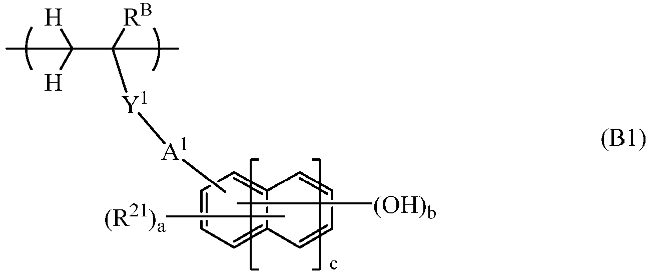 wherein R^{B} is hydrogen, fluorine, methyl or trifluoromethyl,
R²¹ is halogen, an optionally halogenated C₂-C₈ saturated hydrocarbylcarbonyloxy group, optionally halogenated C₁-C₆ saturated hydrocarbyl group, or optionally halogenated C₁-C₆ saturated hydrocarbyloxy group,
Y¹ is a single bond, *-C(=O)-O- or *-C(=O)-NH-, * designates a point of attachment to the carbon atom in the backbone,
A¹ is a single bond or a C₁-C₁₀ saturated hydrocarbylene group in which any constituent -CH₂- may be replaced by -O-,
a is an integer satisfying 0 ≤ a ≤ 5+2c-b, b is an integer of 1 to 3, and c is an integer of 0 to 2, 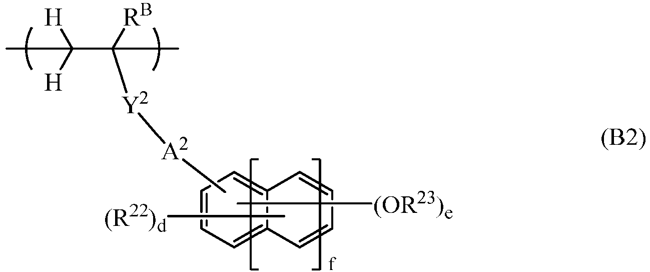 wherein R^{B} is as defined above,
R²² is halogen, an optionally halogenated C₂-C₈ saturated hydrocarbylcarbonyloxy group, optionally halogenated C₁-C₆ saturated hydrocarbyl group, or optionally halogenated C₁-C₆ saturated hydrocarbyloxy group,
Y² is a single bond, *-C(=O)-O- or *-C(=O)-NH-, * designates a point of attachment to the carbon atom in the backbone,
A² is a single bond or a C₁-C₁₀ saturated hydrocarbylene group in which any constituent -CH₂- may be replaced by -O-,
R²³ is an acid labile group when e is 1, and R²³ is hydrogen or an acid labile group, at least one being an acid labile group, when e is 2 or 3,
d is an integer satisfying 0 ≤ d ≤ 5+2f-e, e is an integer of 1 to 3, and f is an integer of 0 to 2, 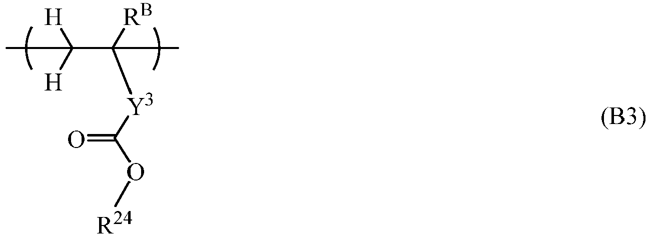 wherein R^{B} is as defined above,
Y³ is a single bond, phenylene group, naphthylene group or a C₁-C₁₂ linking group having an ester bond, ether bond or lactone ring, and
R²⁴ is an acid labile group, 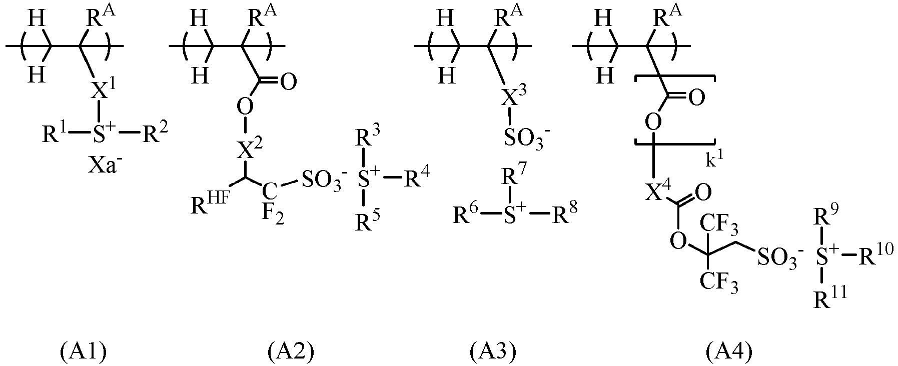 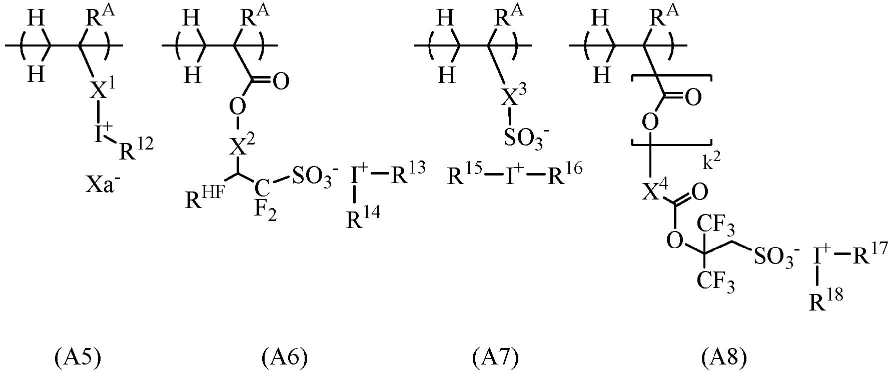 wherein R^{A} is each independently hydrogen or methyl,
X¹ is a single bond, a C₁-C₆ aliphatic hydrocarbylene group, phenylene group, naphthylene group or C₇-C₁₈ group obtained by combining the foregoing, *-O-X¹¹-, *-C(=O)-O-X¹¹-, or *-C(=O)-NH-X¹¹-, X¹¹ is a C₁-C₆ aliphatic hydrocarbylene group, phenylene group, naphthylene group or C₇-C₁₈ group obtained by combining the foregoing, which may contain a carbonyl moiety, ester bond, ether bond or hydroxy moiety,
X² is a single bond or **-X²¹-C(=O)-O-, X²¹ is a C₁-C₂₀ hydrocarbylene group which may contain a heteroatom,
X³ is a single bond, methylene, ethylene, phenylene, fluorinated phenylene, trifluoromethyl-substituted phenylene, *-O-X³¹-, *-C(=O)-O-X³¹-, or *-C(=O)-NH-X³¹-, X³¹ is a C₁-C₆ aliphatic hydrocarbylene group, phenylene group, fluorinated phenylene group, trifluoromethyl-substituted phenylene group, or C₇-C₂₀ group obtained by combining the foregoing, which may contain a carbonyl moiety, ester bond, ether bond or hydroxy moiety,
* designates a point of attachment to the carbon atom in the backbone, ** designates a point of attachment to the oxygen atom in the formula,
X⁴ is a single bond or C₁-C₃₀ hydrocarbylene group which may contain a heteroatom, k¹ and k² are each independently 0 or 1, k¹ and k² are 0 when X⁴ is a single bond,
R¹ to R¹⁸ are each independently halogen or a C₁-C₂₀ hydrocarbyl group which may contain a heteroatom, R¹ and R² may bond together to form a ring with the sulfur atom to which they are attached, R³ and R⁴, R⁶ and R⁷, or R⁹ and R¹⁰ may bond together to form a ring with the sulfur atom to which they are attached,
R^{HF} is hydrogen or trifluoromethyl, and
Xa⁻ is a non-nucleophilic counter ion.

4. The positive resist composition of any one of claims 1 to 3, further comprising a fluorinated polymer comprising repeat units of at least one type selected from repeat units having the following formula (D3), repeat units having the following formula (D4), repeat units having the following formula (D5), and repeat units having the following formula (D6) and optionally repeat units of at least one type selected from repeat units having the following formula (D1) and repeat units having the following formula (D2): 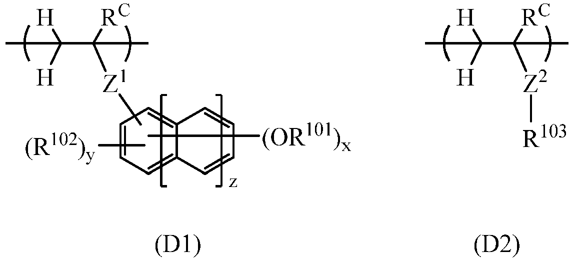 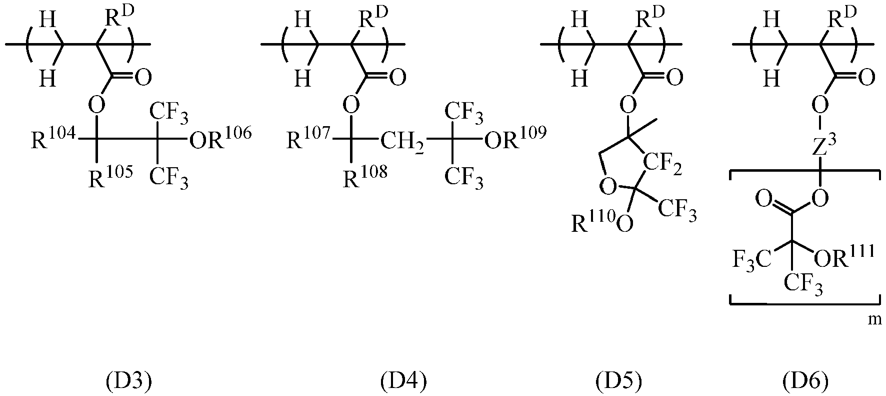 wherein R^{C} is each independently hydrogen or methyl,
R^{D} is each independently hydrogen, fluorine, methyl or trifluoromethyl,
R¹⁰¹ is hydrogen or a C₁-C₅ straight or branched hydrocarbyl group in which a heteroatom-containing moiety may intervene in a carbon-carbon bond,
R¹⁰² is a C₁-C₅ straight or branched hydrocarbyl group in which a heteroatom-containing moiety may intervene in a carbon-carbon bond,
R¹⁰³ is a C₁-C₂₀ saturated hydrocarbyl group in which at least one hydrogen atom is substituted by fluorine and in which some constituent -CH₂- may be replaced by an ester bond or ether bond,
R¹⁰⁴, R¹⁰⁵ , R¹⁰⁷ and R¹⁰⁸ are each independently hydrogen or a C₁-C₁₀ saturated hydrocarbyl group,
R¹⁰⁶, R¹⁰⁹, R¹¹⁰ and R¹¹¹ are each independently hydrogen, a C₁-C₁₅ hydrocarbyl group, C₁-C₁₅ fluorinated hydrocarbyl group, or acid labile group, when R¹⁰⁶, R¹⁰⁹, R¹¹⁰ and R¹¹¹ each are a hydrocarbyl or fluorinated hydrocarbyl group, an ether bond or carbonyl moiety may intervene in a carbon-carbon bond,
x is an integer of 1 to 3, y is an integer satisfying 0 ≤ y ≤ 5+2z-x, z is 0 or 1, m is an integer of 1 to 3,
Z¹ is a single bond, *-C(=O)-O- or *-C(=O)-NH-, * designates a point of attachment to the carbon atom in the backbone,
Z² is a single bond, -O-, *-C(=O)-O-Z²¹-Z²²- or *-C(=O)-NH-Z²¹-Z²²-, Z²¹ is a single bond or a C₁-C₁₀ saturated hydrocarbylene group, Z²² is a single bond, ester bond, ether bond or sulfonamide bond, * designates a point of attachment to the carbon atom in the backbone, and
Z³ is a C₁-C₂₀ (m+1)-valent hydrocarbon group or C₁-C₂₀ (m+1)-valent fluorinated hydrocarbon group.

5. The positive resist composition of any one of claims 1 to 4, further comprising an organic solvent.

6. The positive resist composition of any one of claims 1 to 5, further comprising a photoacid generator.

7. The positive resist composition of claim 6 wherein the photoacid generator contains an anion having an acid strength pKa of equal to or more than -2.0.

8. A resist pattern forming process comprising the steps of:
applying the chemically amplified positive resist composition of any one of claims 1 to 7 onto a substrate to form a resist film thereon,
exposing the resist film patternwise to high-energy radiation, and
developing the exposed resist film in an alkaline developer.

9. The process of claim 8 wherein the high-energy radiation is EUV or EB.

10. The process of claim 8 or 9 wherein the substrate has the outermost surface of a material containing at least one element selected from chromium, silicon, tantalum, molybdenum, cobalt, nickel, tungsten, and tin.

11. The process of any one of claims 8 to 10 wherein the substrate is a photomask blank.

12. A photomask blank which is coated with the chemically amplified positive resist composition of any one of claims 1 to 7.

## Patentansprüche

1. Chemisch verstärkte Positivresistzusammensetzung, umfassend ein Basispolymer, das mit einer säurelabilen Gruppe geschützt ist und unter Einwirkung von Säure alkalilöslich wird, wobei
das Basispolymer ein Polymer enthält, das eine säurebildende Einheit, eine phenolische Hydroxygruppe enthaltende Einheit, eine Einheit, die eine mit einer säurelabilen Gruppe geschützte phenolische Hydroxygruppe enthält, und eine Einheit, die eine mit einer säurelabilen Gruppe geschützte Carboxygruppe enthält, umfasst, die aromatischen Ring-haltigen Wiederholungseinheiten mindestens 60 Mol-% der gesamten Wiederholungseinheiten des Polymers in dem Basispolymer ausmachen, wobei die säurebildende Einheit eine Wiederholungseinheit mit der folgenden Formel (A4) ist, die phenolische Hydroxygruppe enthaltende Einheit eine Wiederholungseinheit mit der folgenden Formel (B1-1) ist, die Einheit, die eine mit einer säurelabilen Gruppe geschützte phenolische Hydroxygruppe enthält, eine Wiederholungseinheit mit der folgenden Formel (B2-1) ist, und die Einheit, die eine mit einer säurelabilen Gruppe geschützte Carboxygruppe enthält, eine Wiederholungseinheit mit der folgenden Formel (B3-1) ist: 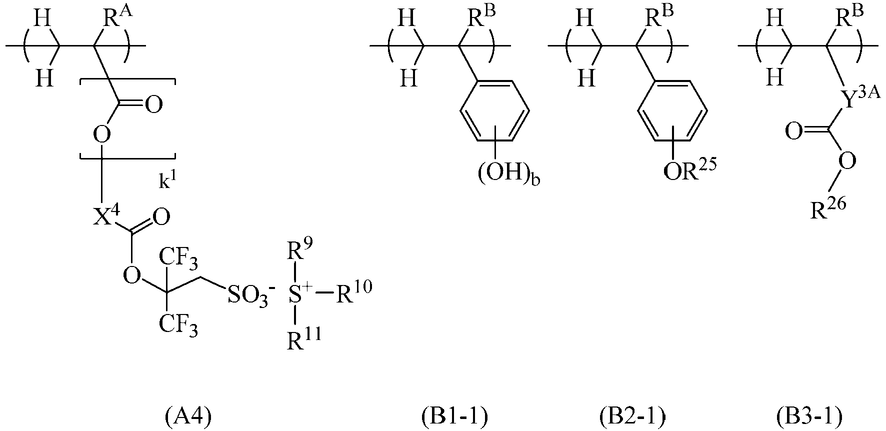
wobei R^{A} jeweils unabhängig voneinander Wasserstoff oder Methyl ist,
wobei R^{B} Wasserstoff, Fluor, Methyl oder Trifluormethyl ist,
X⁴ eine Einfachbindung oder eine C₁-C₃₀-Hydrocarbylengruppe ist, die ein Heteroatom enthalten kann, k¹ und k² jeweils unabhängig voneinander 0 oder 1 sind, k¹ und k² 0 sind, wenn X⁴ eine Einfachbindung ist,
R⁹ bis R¹¹ jeweils unabhängig voneinander Halogen oder eine C₁-C₂₀-Hydrocarbylgruppe sind, die ein Heteroatom enthalten kann, R⁹ und R¹⁰ miteinander verbunden sein können, um mit dem Schwefelatom, an das sie gebunden sind, einen Ring zu bilden,
b eine ganze Zahl von 1 bis 3 ist,
k¹ 0 oder 1 ist, k¹ 0 ist, wenn X⁴ eine Einfachbindung ist,
Y^{3A} eine Einfachbindung, eine Phenylengruppe oder eine Naphthylengruppe ist,
R²⁵ und R²⁶ jeweils unabhängig voneinander eine säurelabile Gruppe mit einem aromatischen C₆-C₂₀-Kohlenwasserstoffrest und/oder einem alicyclischen C₅-C₂₀-Kohlenwasserstoffrest sind,
wobei das Basispolymer ein Polymer enthält, das Wiederholungseinheiten der Formel (A4), Wiederholungseinheiten der Formel (B1-1), Wiederholungseinheiten der Formel (B2-1) und Wiederholungseinheiten der Formel (B3-1) umfasst.

2. Positivresistzusammensetzung nach Anspruch 1, wobei das Polymer in dem Basispolymer ferner eine Wiederholungseinheit mit einer der folgenden Formeln (C1) bis (C3) umfasst: 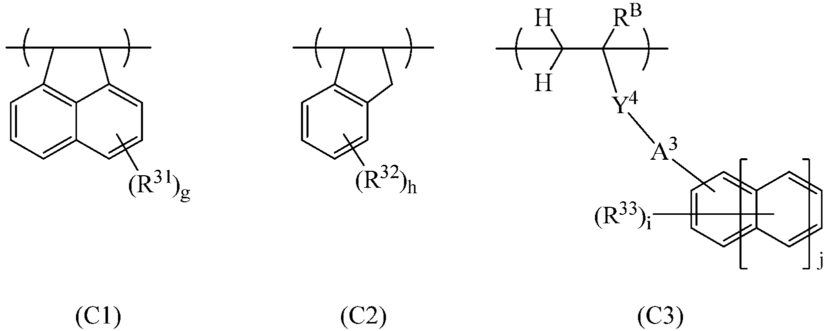
wobei R^{B} wie oben definiert ist,
g und h jeweils unabhängig voneinander eine ganze Zahl von 0 bis 4 sind, i eine ganze Zahl von 0 bis 5 ist, j eine ganze Zahl von 0 bis 2 ist,
R³¹ und R³² jeweils unabhängig voneinander eine Hydroxygruppe, Halogen, eine gegebenenfalls halogenierte gesättigte C₂-C₈-Hydrocarbylcarbonyloxygruppe, eine gegebenenfalls halogenierte gesättigte C₁-C₈-Hydrocarbylgruppe oder eine gegebenenfalls halogenierte gesättigte C₁-C₈-Hydrocarbyloxygruppe sind,
R³³ eine Acetylgruppe, eine gesättigte C₁-C₂₀-Hydrocarbylgruppe, eine gesättigte C₁-C₂₀-Hydrocarbyloxygruppe, eine gesättigte C₂-C₂₀-Hydrocarbylcarbonyloxygruppe, eine gesättigte C₂-C₂₀-Hydrocarbyloxyhydrocarbylgruppe, eine gesättigte C₂-C₂₀-Hydrocarbylthiohydrocarbylgruppe, Halogen, eine Nitrogruppe oder eine Cyanogruppe ist, wobei R³³ auch Hydroxy sein kann, wenn j 1 oder 2 ist,
Y⁴ eine Einfachbindung, *-C(=O)-O- oder *-C(=O)-NH- ist, * einen Bindungspunkt an das Kohlenstoffatom im Grundgerüst bezeichnet,
A³ eine Einfachbindung oder eine gesättigte C₁-C₁₀-Hydrocarbylengruppe ist, in der einige -CH₂- durch -O- ersetzt sein können.

3. Positivresistzusammensetzung nach Anspruch 1 oder 2, wobei das Basispolymer ferner ein Polymer enthält, das Wiederholungseinheiten mit der Formel (B1) und Wiederholungseinheiten mindestens eines Typs umfasst, die aus Wiederholungseinheiten mit der Formel (B2) und Wiederholungseinheiten mit der Formel (B3) ausgewählt sind, jedoch keine Wiederholungseinheiten mit den Formeln (A1) bis (A8) 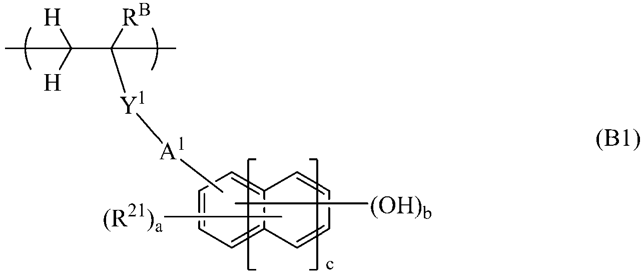
wobei R^{B} Wasserstoff, Fluor, Methyl oder Trifluormethyl ist,
R²¹ Halogen, eine gegebenenfalls halogenierte gesättigte C₂-C₈-Hydrocarbylcarbonyloxygruppe, eine gegebenenfalls halogenierte gesättigte C₁-C₆-Hydrocarbylgruppe oder eine gegebenenfalls halogenierte gesättigte C₁-C₆-Hydrocarbyloxygruppe ist,
Y¹ eine Einfachbindung, *-C(=O)-O- oder *-C(=O)-NH- ist, * einen Bindungspunkt an das Kohlenstoffatom im Grundgerüst bezeichnet,
A¹ eine Einfachbindung oder eine gesättigte C₁-C₁₀-Hydrocarbylengruppe ist, in der jedes -CH₂- durch -O- ersetzt sein kann,
a eine ganze Zahl ist, die 0 ≤ a ≤ 5+2c-b erfüllt, b eine ganze Zahl von 1 bis 3 ist und c eine ganze Zahl von 0 bis 2 ist, 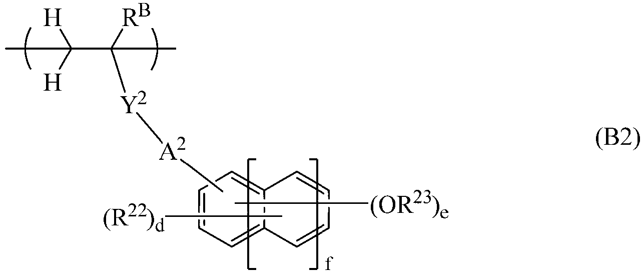
wobei R^{B} wie oben definiert ist,
R²² Halogen, eine gegebenenfalls halogenierte gesättigte C₂-C₈-Hydrocarbylcarbonyloxygruppe, eine gegebenenfalls halogenierte gesättigte C₁-C₆-Hydrocarbylgruppe oder eine gegebenenfalls halogenierte gesättigte C₁-C₆-Hydrocarbyloxygruppe ist,
Y² eine Einfachbindung, *-C(=O)-O- oder *-C(=O)-NH- ist, * einen Bindungspunkt an das Kohlenstoffatom im Grundgerüst bezeichnet,
A² eine Einfachbindung oder eine gesättigte C₁-C₁₀-Hydrocarbylengruppe ist, in der jedes -CH₂- durch -O- ersetzt sein kann,
R²³ eine säurelabile Gruppe ist, wenn e 1 ist, und R²³ Wasserstoff oder eine säurelabile Gruppe ist, wobei mindestens einer eine säurelabile Gruppe ist, wenn e 2 oder 3 ist,
d eine ganze Zahl ist, die 0 ≤ d ≤ 5+2f-e erfüllt, e eine ganze Zahl von 1 bis 3 ist und f eine ganze Zahl von 0 bis 2 ist, 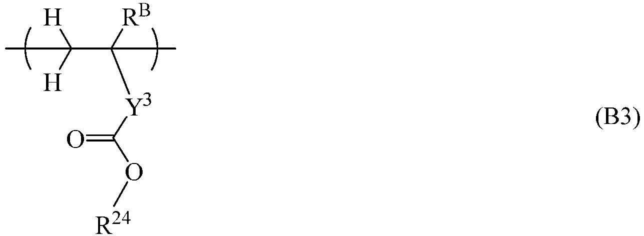
wobei R^{B} wie oben definiert ist,
Y³ eine Einfachbindung, eine Phenylengruppe, eine Naphthylengruppe oder eine C₁-C₁₂-Verbindungsgruppe mit einer Esterbindung, einer Etherbindung oder einem Lactonring ist und
R₂₄ eine säurelabile Gruppe ist, 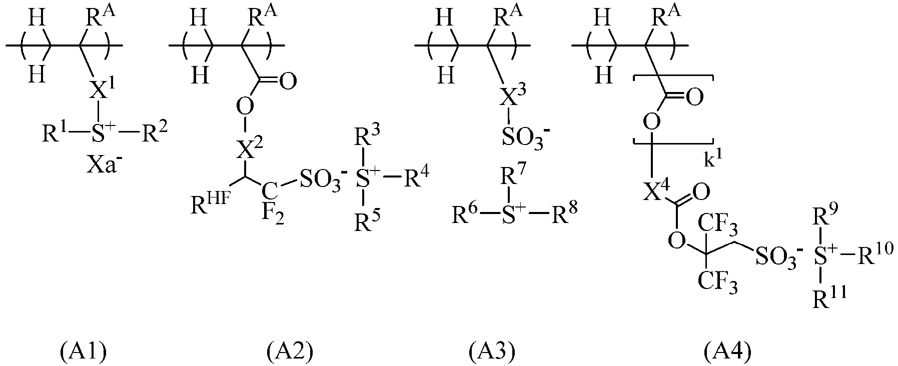 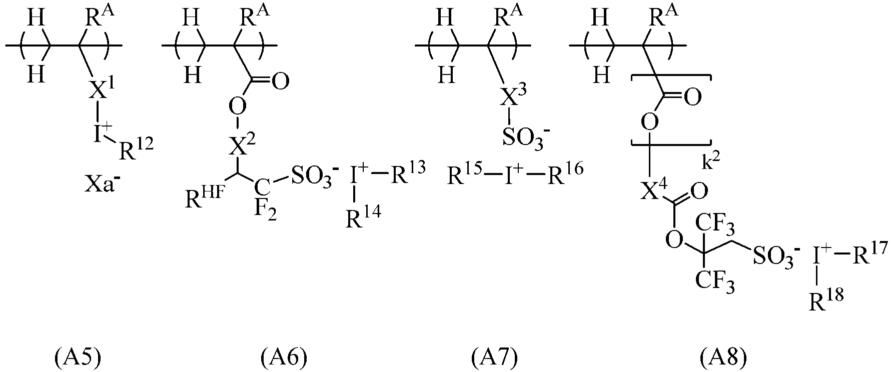
wobei R^{A} jeweils unabhängig voneinander Wasserstoff oder Methyl ist,
X¹ eine Einfachbindung, eine aliphatische C₁-C₆-Hydrocarbylengruppe, eine Phenylengruppe, eine Naphthylengruppe oder eine C₇-C₁₈-Gruppe ist, die durch Kombination der vorstehenden erhalten wird, *-O-X¹¹-, *C(=O)-O-X¹¹- oder *-C(=O)-NH-X¹¹- ist, X¹¹ eine aliphatische C₁-C₆-Hydrocarbylengruppe, eine Phenylengruppe, eine Naphthylengruppe oder eine C₇-C₁₈-Gruppe ist, die durch Kombination der vorstehenden erhalten wird und eine Carbonylgruppe, eine Esterbindung, eine Etherbindung oder eine Hydroxygruppe enthalten kann,
X² eine Einfachbindung oder **-X²¹-C(=O)-O- ist, X²¹ eine C₁-C₂₀-Hydrocarbylengruppe ist, die ein Heteroatom enthalten kann,
X³ eine Einfachbindung, Methylen, Ethylen, Phenylen, fluoriertes Phenylen, trifluormethylsubstituiertes Phenylen, *-O-X³¹-, *-C(=O)-O-X³¹- oder *-C(=O)-NH-X³¹- ist, X³¹ eine aliphatische C₁-C₆-Hydrocarbylengruppe, eine Phenylengruppe, eine fluorierte Phenylengruppe, eine trifluormethylsubstituierte Phenylengruppe oder eine C₇-C₂₀-Gruppe ist, die durch Kombination der vorgenannten erhalten wird und eine Carbonylgruppe, eine Esterbindung, eine Etherbindung oder eine Hydroxygruppe enthalten kann,
* einen Bindungspunkt an das Kohlenstoffatom im Grundgerüst bezeichnet, ** einen Bindungspunkt an das Sauerstoffatom in der Formel bezeichnet,
X⁴ eine Einfachbindung oder eine C₁-C₃₀-Hydrocarbylengruppe ist, die ein Heteroatom enthalten kann, k¹ und k² jeweils unabhängig voneinander 0 oder 1 sind, k¹ und k² 0 sind, wenn X⁴ eine Einfachbindung ist,
R¹ bis R¹⁸ jeweils unabhängig voneinander Halogen oder eine C₁-C₂₀-Hydrocarbylgruppe sind, die ein Heteroatom enthalten kann, R¹ und R² miteinander verbunden sein können, um einen Ring mit dem Schwefelatom zu bilden, an das sie gebunden sind, R³ und R⁴, R⁶ und R⁷ oder R⁹ und R¹⁰ miteinander verbunden sein können, um einen Ring mit dem Schwefelatom zu bilden, an das sie gebunden sind, R^{HF} Wasserstoff oder Trifluormethyl ist, und
Xa⁻ ein nicht-nukleophiles Gegenion ist.

4. Positivresistzusammensetzung nach einem der Ansprüche 1 bis 3, ferner umfassend ein fluoriertes Polymer, das Wiederholungseinheiten mindestens eines Typs umfasst, ausgewählt aus Wiederholungseinheiten mit der folgenden Formel (D3), Wiederholungseinheiten mit der folgenden Formel (D4), Wiederholungseinheiten mit der folgenden Formel (D5) und Wiederholungseinheiten mit der folgenden Formel (D6) und gegebenenfalls Wiederholungseinheiten mindestens eines Typs, ausgewählt aus Wiederholungseinheiten mit der folgenden Formel (D1) und Wiederholungseinheiten mit der folgenden Formel (D2): 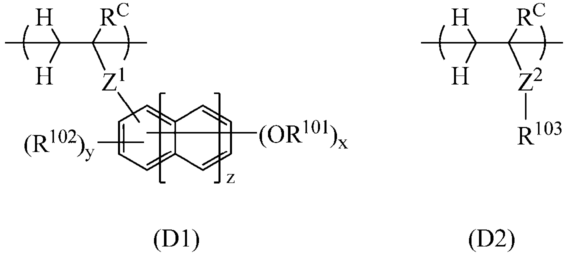 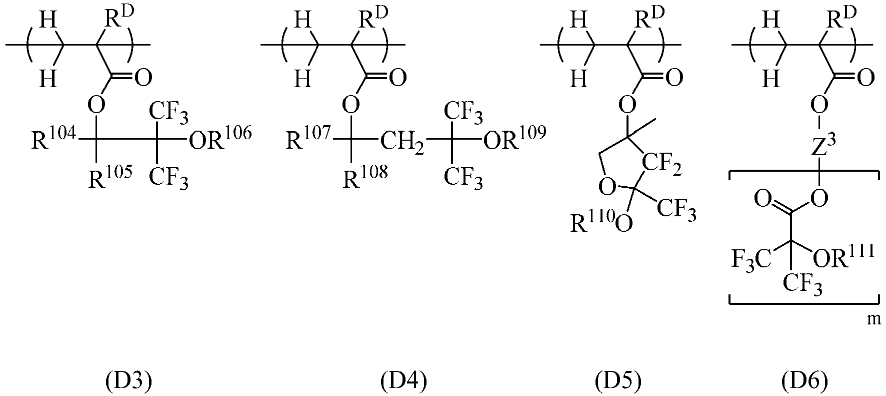
wobei R^{C} jeweils unabhängig voneinander Wasserstoff oder Methyl ist,
R^{D} jeweils unabhängig voneinander Wasserstoff, Fluor, Methyl oder Trifluormethyl ist,
R¹⁰¹ Wasserstoff oder eine geradkettige oder verzweigte C₁-C₅-Hydrocarbylgruppe ist, in der eine heteroatomhaltige Einheit in eine Kohlenstoff-Kohlenstoff-Bindung eingreifen kann,
R¹⁰² eine geradkettige oder verzweigte C₁-C₅-Hydrocarbylgruppe ist, in der eine heteroatomhaltige Einheit in eine Kohlenstoff-Kohlenstoff-Bindung eingreifen kann, R¹⁰³ eine gesättigte C₁-C₂₀-Hydrocarbylgruppe ist, in der mindestens ein Wasserstoffatom durch Fluor substituiert ist und in der einige -CH₂- durch eine Ester- oder Etherbindung ersetzt sein können,
R¹⁰⁴, R¹⁰⁵ , R¹⁰⁷ und R¹⁰⁸ jeweils unabhängig voneinander Wasserstoff oder eine gesättigte C₁-C₁₀-Hydrocarbylgruppe sind,
R¹⁰⁶, R¹⁰⁹, R¹¹⁰ und R¹¹¹ jeweils unabhängig voneinander Wasserstoff, eine C₁-C₁₅-Hydrocarbylgruppe, eine fluorierte C₁-C₁₅-Hydrocarbylgruppe oder eine säurelabile Gruppe sind, wenn R¹⁰⁶, R¹⁰⁹, R¹¹⁰ und R¹¹¹ jeweils eine Hydrocarbyl- oder fluorierte Hydrocarbylgruppe sind, eine Etherbindung oder eine Carbonylgruppe in eine Kohlenstoff-Kohlenstoff-Bindung eingreifen kann,
x eine ganze Zahl von 1 bis 3 ist, y eine ganze Zahl ist, die 0 ≤ y ≤ 5+2z-x erfüllt, z 0 oder 1 ist, m eine ganze Zahl von 1 bis 3 ist,
Z¹ eine Einfachbindung, *-C(=O)-O- oder *-C(=O)-NH- ist, * einen Bindungspunkt an das Kohlenstoffatom im Grundgerüst bezeichnet,
Z² eine Einfachbindung, -O-, *-C(=O)-O-Z²¹-Z²²- oder *-C(=O)-NH-Z²¹-Z²²- ist, Z²¹ eine Einfachbindung oder eine gesättigte C₁-C₁₀-Hydrocarbylengruppe ist, Z²² eine Einfachbindung, eine Esterbindung, eine Etherbindung oder eine Sulfonamidbindung ist, * eine Bindungsstelle an das Kohlenstoffatom im Grundgerüst bezeichnet, und
Z³ eine C₁-C₂₀ (m+1)-valente Kohlenwasserstoffgruppe oder eine C₁-C₂₀ (m+1)-valente fluorierte Kohlenwasserstoffgruppe ist.

5. Positivresistzusammensetzung nach einem der Ansprüche 1 bis 4, die ferner ein organisches Lösungsmittel umfasst.

6. Positivresistzusammensetzung nach einem der Ansprüche 1 bis 5, ferner umfassend einen Photosäuregenerator.

7. Positivresistzusammensetzung nach Anspruch 6, wobei der Photosäuregenerator ein Anion mit einer Säurestärke pKa von gleich oder größer als -2,0 enthält.

8. Verfahren zur Bildung eines Resistmusters, umfassend die Schritte:
Aufbringen der chemisch verstärkten Positivresistzusammensetzung nach einem der Ansprüche 1 bis 7 auf ein Substrat, um darauf einen Resistfilm zu bilden,
musterweises Belichten des Resistfilms mit hochenergetischer Strahlung und
Entwickeln des belichteten Resistfilms in einem alkalischen Entwickler.

9. Verfahren nach Anspruch 8, wobei die hochenergetische Strahlung EUV oder EB ist.

10. Verfahren nach Anspruch 8 oder 9, wobei das Substrat eine äußerste Oberfläche aus einem Material aufweist, das mindestens ein Element, ausgewählt aus Chrom, Silizium, Tantal, Molybdän, Kobalt, Nickel, Wolfram und Zinn, enthält.

11. Verfahren nach einem der Ansprüche 8 bis 10, wobei das Substrat ein Photomaskenrohling ist.

12. Photomaskenrohling, der mit der chemisch verstärkten Positivresistzusammensetzung nach einem der Ansprüche 1 bis 7 beschichtet ist.

## Revendications

1. Composition de réserve positive chimiquement amplifiée comportant un polymère de base protégé avec un groupe labile acide et adaptée pour devenir soluble en milieu alcalin sous l'action d'un acide, dans laquelle
ledit polymère de base contient un polymère comportant un motif générateur d'acide, un motif contenant un groupe hydroxy phénolique, un motif contenant un groupe hydroxy phénolique protégé avec un groupe labile acide et un motif contenant un groupe carboxy protégé par un groupe labile acide,
les motifs répétés contenant un cycle aromatique représentent au moins 60 % en mole des motifs répétés totaux du polymère dans ledit polymère de base,
dans laquelle le motif générateur d'acide est un motif répété ayant la formule (A4) suivante, le motif contenant un groupe hydroxy phénolique est un motif répété ayant la formule (B1-1) suivante, le motif contenant un groupe hydroxy phénolique protégé avec un groupe labile acide est un motif répété ayant la formule (B2-1) suivante, et le motif contenant un groupe carboxy protégé avec un groupe labile acide est un motif répété ayant la formule (B3-1) suivante : 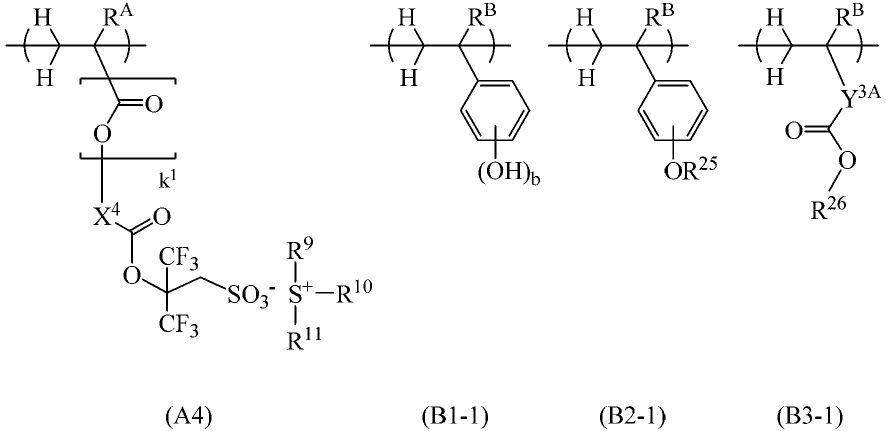
dans lesquelles les éléments R ^{A} représentent chacun, indépendamment les uns des autres, l'hydrogène ou un méthyle,
dans lesquelles R ^{B} est l'hydrogène, le fluor, un méthyle ou un trifluorométhyle,
X⁴ est une liaison simple ou un groupe hydrocarbylène en C₁ à C₃₀ qui peut contenir un hétéroatome, k¹ et k² valent chacun, indépendamment l'un de l'autre, 0 ou 1, k¹ et k² valent 0 lorsque X⁴ est une liaison simple,
R⁹ à R¹¹ sont chacun, indépendamment les uns des autres, un halogène ou un groupe hydrocarbyle en C₁ à C₂₀ qui peut contenir un hétéroatome, R⁹ et R¹⁰ peuvent se lier ensemble pour former un cycle avec l'atome de soufre auquel ils sont rattachés,
b est un entier de 1 à 3,
k¹ vaut 0 ou 1, k¹ vaut 0 lorsque X⁴ est une liaison simple,
Y^{3A} est une liaison simple, un groupe phénylène ou un groupe naphtylène,
R²⁵ et R²⁶ sont chacun, indépendamment l'un de l'autre, un groupe labile acide ayant un groupement hydrocarbure aromatique en C₆ à C₂₀ et/ou un groupement hydrocarbure alicyclique en C₅ à C₂₀,
dans laquelle ledit polymère de base contient un polymère comportant des motifs répétés de formule (A4), des motifs répétés ayant la formule (B1-1), des motifs répétés ayant la formule (B2-1) et des motifs répétés ayant la formule (B3-1).

2. Composition de réserve positive selon la revendication 1, dans laquelle le polymère dans ledit polymère de base comporte en outre un motif répété ayant l'une quelconque des formules (C1) à (C3) suivantes : 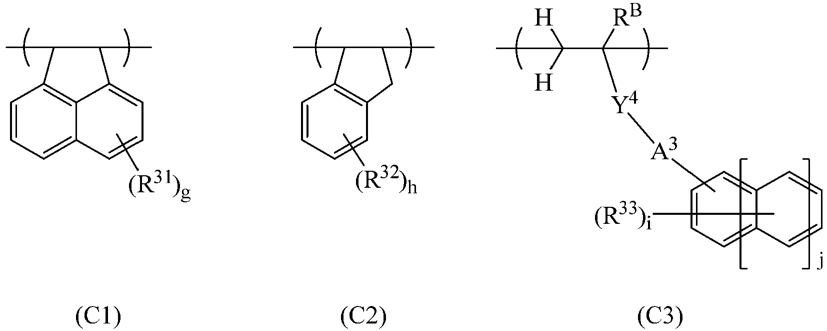
dans lesquelles R^{B} est tel que défini ci-dessus,
g et h sont chacun, indépendamment l'un de l'autre, un entier de 0 à 4, i est un entier de 0 à 5, j est un entier de 0 à 2,
R³¹ et R³² sont chacun, indépendamment l'un de l'autre, un groupe hydroxy, un halogène, un groupe hydrocarbylcarbonyloxy saturé en C₂ à C₈ facultativement halogéné, un groupe hydrocarbyle saturé en C₁ à C₈ facultativement halogéné ou un groupe hydrocarbyloxy saturé en C₁ à C₈ facultativement halogéné,
R³³ est un groupe acétyle, un groupe hydrocarbyle saturé en C₁ à C₂₀, un groupe hydrocarbyloxy saturé en C₁ à C₂₀, un groupe hydrocarbylcarbonyloxy saturé en C₂ à C₂₀, un groupe hydrocarbyloxyhydrocarbyle saturé en C₂ à C₂₀, un groupe hydrocarbylthiohydrocarbyle saturé en C₂ à C₂₀, un halogène, un groupe nitro ou un groupe cyano, R³³ peut également être hydroxy lorsque j vaut 1 ou 2,
Y⁴ est une liaison simple, *-C(=O)-O- ou *-C(=O)-NH-, * désigne un point d'attache à l'atome de carbone dans le squelette,
A³ est une liaison simple ou un groupe hydrocarbylène saturé en C₁ à C₁₀ dans lequel un constituant -CH₂- peut être remplacé par -O-,

3. Composition de réserve positive selon la revendication 1 ou 2, dans laquelle ledit polymère de base contient en outre un polymère comportant des motifs répétés ayant la formule (B1) et des motifs répétés d'au moins un type choisi parmi des motifs répétés ayant la formule (B2) et des motifs répétés ayant la formule (B3), mais pas des motifs répétés ayant les formules (A1) à (A8), 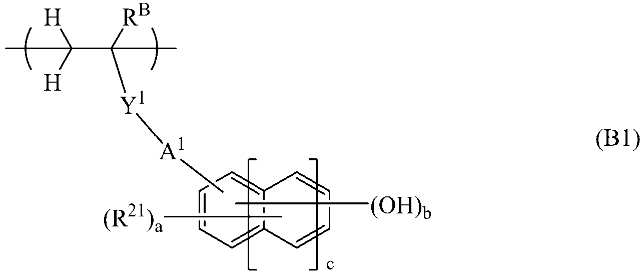
dans lesquelles R ^{B} est l'hydrogène, le fluor, un méthyle ou un trifluorométhyle,
R²¹ est un halogène, un groupe hydrocarbylcarbonyloxy saturé en C₂ à C₈ facultativement halogéné, un groupe hydrocarbyle saturé en C₁ à C₆ facultativement halogéné ou un groupe hydrocarbyloxy saturé en C₁ à C₆ facultativement halogéné,
Y¹ est une liaison simple, *-C(=O)-O- ou *-C(=O)-NH-, * désigne un point d'attache à l'atome de carbone dans le squelette,
A¹ est une liaison simple ou un groupe hydrocarbylène saturé en C₁ à C₁₀ dans lequel tout constituant -CH₂- peut être remplacé par -O-,
a est un entier satisfaisant à 0 ≤ a ≤ 5+2c-b, b est un entier de 1 à 3, et c est un entier de 0 à 2, 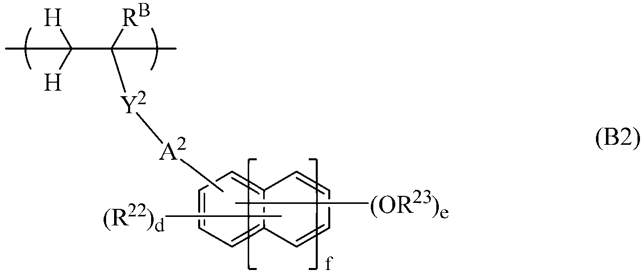
dans laquelle R^{B} est tel que défini ci-dessus,
R²² est un halogène, un groupe hydrocarbylcarbonyloxy saturé en C₂ à C₈ facultativement halogéné, un groupe hydrocarbyle saturé en C₁ à C₆ facultativement halogéné ou un groupe hydrocarbyloxy saturé en C₁ à C₆ facultativement halogéné,
Y² est une liaison simple, *-C(=O)-O- ou *-C(=O)-NH-, * désigne un point d'attache à l'atome de carbone dans le squelette,
A² est une liaison simple ou un groupe hydrocarbylène saturé en C₁ à C₁₀ dans lequel tout constituant -CH₂- peut être remplacé par -O-,
R²³ est un groupe labile acide lorsque e vaut 1, et R²³ est l'hydrogène ou un groupe labile acide, au moins un élément étant un groupe labile acide, lorsque e vaut 2 ou 3,
d est un entier satisfaisant à 0 ≤ d ≤ 5+2f-e, e est un entier de 1 à 3, et f est un entier de 0 à 2, 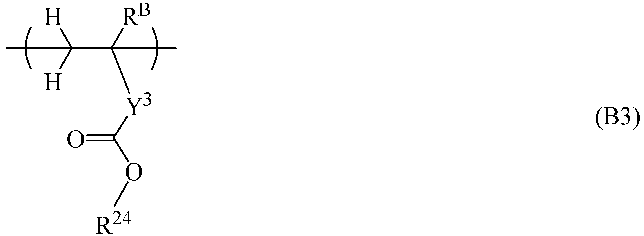
dans laquelle R^{B} est tel que défini ci-dessus,
Y³ est une liaison simple, un groupe phénylène, un groupe naphtylène ou un groupe de liaison en C₁ à C₁₂ ayant une liaison ester, une liaison éther ou un cycle lactone, et
R²⁴ est un groupe labile acide, 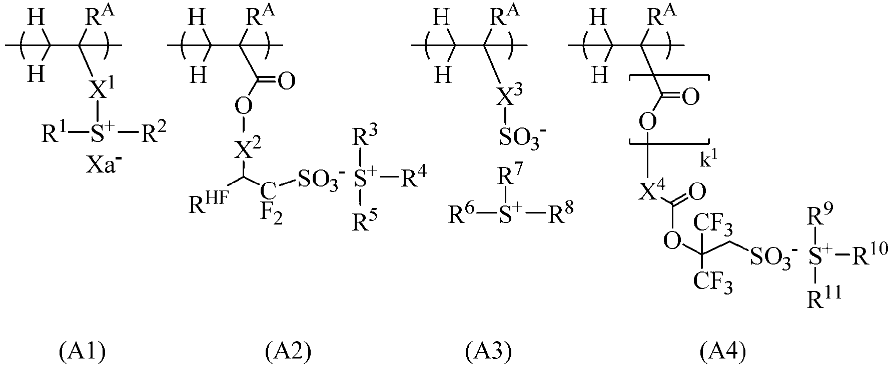 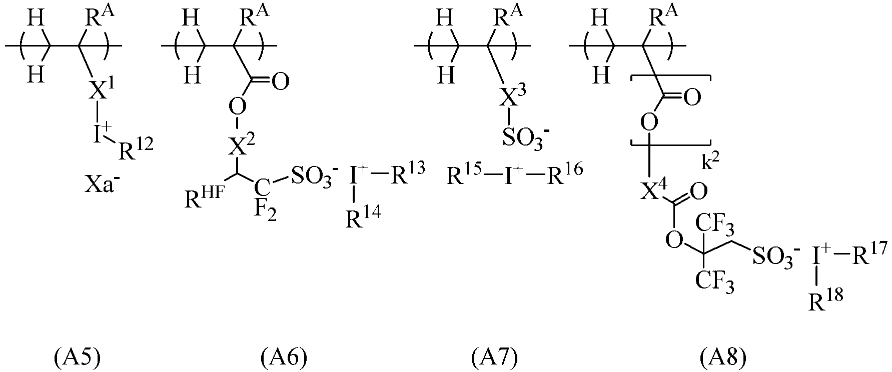
dans lesquelles les éléments R ^{A} représentent chacun, indépendamment les uns des autres, l'hydrogène ou un méthyle,
X¹ est une liaison simple, un groupe hydrocarbylène aliphatique en C₁ à C₆, un groupe phénylène, un groupe naphtylène ou un groupe en C₇ à C₁₈ obtenu en combinant ceux qui précèdent, *-O-X¹¹-, *-C(=O)-O-X¹¹- ou *-C(=O)-NH-X¹¹-, X¹¹ est un groupe hydrocarbylène aliphatique en C₁ à C₆, un groupe phénylène, un groupe naphtylène ou un groupe en C₇ à C₁₈ obtenu en combinant ceux qui précèdent, qui peut contenir un groupement carbonyle, une liaison ester, une liaison éther ou un groupement hydroxy,
X² est une liaison simple ou**-X²¹-C(=O)-O-, X²¹ est un groupe hydrocarbylène en C₁ à C₂₀ qui peut contenir un hétéroatome,
X³ est une liaison simple, un méthylène, un éthylène, un phénylène, un phénylène fluoré, un phénylène trifluorométhyl-substitué, *-O-X³¹-, *-C(=O)-O-X³¹- ou *-C(=O)-NH-X³¹⁻, X³¹ est un groupe hydrocarbylène aliphatique en C₁ à C₆, un groupe phénylène, un groupe phénylène fluoré, un groupe phénylène trifluorométhyl-substitué, ou un groupe en C₇ à C₂₀ obtenu en combinant ceux qui précèdent, qui peut contenir un groupement carbonyle, une liaison ester, une liaison éther ou un groupement hydroxy,
* désigne un point d'attache à l'atome de carbone dans le squelette, ** désigne un point d'attache à l'atome d'oxygène dans la formule,
X⁴ est une liaison simple ou un groupe hydrocarbylène en C₁ à C₃₀ qui peut contenir un hétéroatome, k¹ et k² valent chacun, indépendamment l'un de l'autre, 0 ou 1, k¹ et k² valent 0 lorsque X⁴ est une liaison simple,
R¹ à R¹⁸ sont chacun, indépendamment les uns des autres, un halogène ou un groupe hydrocarbyle en C₁ à C₂₀ qui peut contenir un hétéroatome, R¹ et R² peuvent se lier ensemble pour former un cycle avec l'atome de soufre auquel ils sont rattachés, R³ et R⁴, R⁶ et R ⁷, ou R⁹ et R ¹⁰ peuvent se lier ensemble pour former un cycle avec l'atome de soufre auquel ils sont rattachés,
R^{HF} est l'hydrogène ou un trifluorométhyle, et
Xa⁻ est un contre-ion non nucléophile.

4. Composition de réserve positive selon l'une quelconque des revendications 1 à 3, comportant en outre un polymère fluoré comportant des motifs répétés d'au moins un type choisi parmi des motifs répétés ayant la formule (D3) suivante, des motifs répétés ayant la formule (D4) suivante, des motifs répétés ayant la formule (D5) suivante, et des motifs répétés ayant la formule (D6) suivante, et facultativement des motifs répétés d'au moins un type choisi parmi des motifs répétés ayant la formule (D1) suivante et des motifs répétés ayant la formule (D2) suivante : 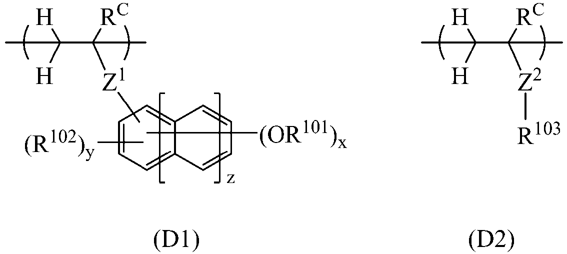 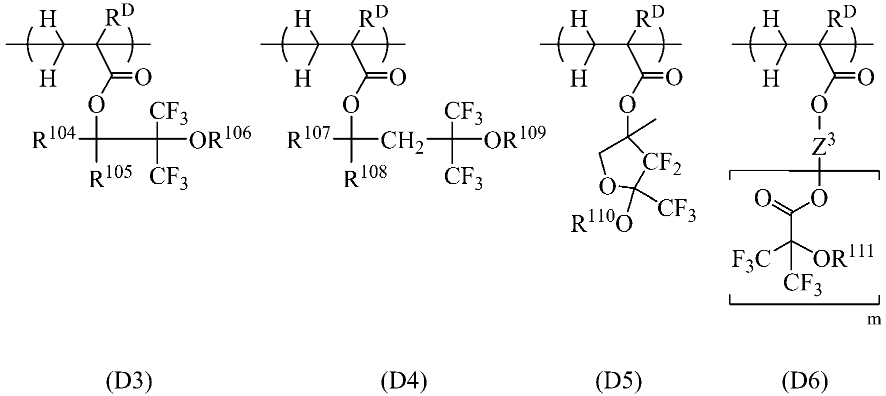
dans lesquelles les éléments R^{C} sont chacun, indépendamment les uns des autres, l'hydrogène ou un méthyle,
les éléments R^{D} sont chacun, indépendamment les uns des autres, l'hydrogène, le fluor, un méthyle ou un trifluorométhyle,
R¹⁰¹ est l'hydrogène ou un groupe hydrocarbyle à chaîne droite ou ramifiée en C₁ à C₅ dans lequel un groupement contenant un hétéroatome peut intervenir dans une liaison carbone-carbone,
R¹⁰² est un groupe hydrocarbyle à chaîne droite ou ramifiée en C₁ à C₅ dans lequel un groupement contenant un hétéroatome peut intervenir dans une liaison carbone-carbone,
R¹⁰³ est un groupe hydrocarbyle saturé en C₁ à C₂₀ dans lequel au moins un atome d'hydrogène est substitué par du fluor, et dans lequel un constituant -CH₂- peut être remplacé par une liaison ester ou une liaison éther,
R¹⁰⁴, R¹⁰⁵, R¹⁰⁷ et R¹⁰⁸ sont chacun, indépendamment les uns des autres, l'hydrogène ou un groupe hydrocarbyle saturé en C₁ à C₁₀,
R¹⁰⁶, R¹⁰⁹, R¹¹⁰ et R¹¹¹ sont chacun, indépendamment les uns des autres, un hydrogène, un groupe hydrocarbyle en C₁ à C₁₅, un groupe hydrocarbyle fluoré en C₁ à C₁₅ ou un groupe labile acide, lorsque R¹⁰⁶, R¹⁰⁹, R¹¹⁰ et R¹¹¹ sont chacun un groupe hydrocarbyle ou un groupe hydrocarbyle fluoré, une liaison éther ou un groupement carbonyle peut intervenir dans une liaison carbone-carbone,
x est un entier de 1 à 3, y est un entier satisfaisant à 0 ≤ y ≤ 5+2z-x, z vaut 0 ou 1, m est un entier de 1 à 3,
Z¹ est une liaison simple, *-C(=O)-O- ou *-C(=O)-NH-, * désigne un point d'attache à l'atome de carbone dans le squelette,
Z² est une liaison simple, -O-, *-C(=O)=O-Z²¹-Z²²- ou *-C(=O)-NH-Z²¹-Z²²-, Z²¹ est une liaison simple ou un groupe hydrocarbylène saturé en C₁ à C₁₀ , Z²² est une liaison simple, une liaison ester, une liaison éther ou une liaison sulfonamide, * désigne un point d'attache à l'atome de carbone dans le squelette.
Z³ est un groupe hydrocarbure de valence (m+1) en C₁ à C₂₀ ou un groupe hydrocarbure fluoré de valence (m+1) en C₁ à C₂₀.

5. Composition de réserve positive selon l'une quelconque des revendications 1 à 4, comportant en outre un solvant organique.

6. Composition de réserve positive selon l'une quelconque des revendications 1 à 5, comportant en outre un générateur de photoacides.

7. Composition de réserve positive selon la revendication 6, dans laquelle le générateur de photoacides contient un anion ayant une force d'acide pKa égale ou supérieure à -2,0.

8. Procédé de formation d'un motif de réserve comportant les étapes consistant à :
appliquer la composition de réserve positive chimiquement amplifiée selon l'une quelconque des revendications 1 à 7 sur un substrat pour former un film de réserve sur celui-ci,
exposer le film de réserve formé en motifs à un rayonnement de haute énergie, et
développer le film de réserve exposé dans un révélateur alcalin.

9. Procédé selon la revendication 8, dans lequel le rayonnement de haute énergie est EUV ou EB.

10. Procédé selon la revendication 8 ou 9, dans lequel le substrat a la surface la plus à l'extérieur d'un matériau contenant au moins un élément choisi parmi le chrome, le silicium, le tantale, le molybdène, le cobalt, le nickel, le tungstène et l'étain.

11. Procédé selon l'une quelconque des revendications 8 à 10, dans lequel le substrat est une ébauche de photomasque.

12. Ébauche de photomasque revêtue de la composition de réserve positive chimiquement amplifiée de l'une quelconque des revendications 1 à 7.
